(19) Europäisches Patentamt
European Patent Office
Office européen des brevets

(11) EP 4 282 887 A1

(12) **EUROPEAN PATENT APPLICATION**
published in accordance with Art. 153(4) EPC

(43) Date of publication:
**29.11.2023 Bulletin 2023/48**

(21) Application number: **22742446.2**

(22) Date of filing: **07.01.2022**

(51) International Patent Classification (IPC):
***C08F 20/20*** *(2006.01)* ***G03F 7/004*** *(2006.01)*
***G03F 7/038*** *(2006.01)* ***G03F 7/039*** *(2006.01)*
***G03F 7/20*** *(2006.01)* ***G03F 7/32*** *(2006.01)*

(52) Cooperative Patent Classification (CPC):
**C08F 20/20; G03F 7/004; G03F 7/038; G03F 7/039; G03F 7/20; G03F 7/32**

(86) International application number:
**PCT/JP2022/000432**

(87) International publication number:
**WO 2022/158323 (28.07.2022 Gazette 2022/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.01.2021 JP 2021009169**
**21.07.2021 JP 2021120391**

(71) Applicant: **FUJIFILM Corporation**
**Tokyo 106-8620 (JP)**

(72) Inventors:
- **KATO Keita**
**Haibara-gun, Shizuoka 421-0396 (JP)**
- **SHIRAKAWA Michihiro**
**Haibara-gun, Shizuoka 421-0396 (JP)**
- **TAKAHASHI Satomi**
**Haibara-gun, Shizuoka 421-0396 (JP)**
- **SHIMIZU Tetsuya**
**Haibara-gun, Shizuoka 421-0396 (JP)**

(74) Representative: **HGF**
**HGF Limited**
**1 City Walk**
**Leeds LS11 9DX (GB)**

(54) **PATTERN FORMATION METHOD AND METHOD FOR PRODUCING ELECTRONIC DEVICE**

(57) Provided are a pattern forming method including (1) a step of forming a film using an actinic ray-sensitive or radiation-sensitive resin composition that contains a resin (A) which is decomposed by action of acid to increase polarity and a compound (B) which generates an acid by irradiation with an actinic ray or a radiation, (2) a step of exposing the film, and (3) a step of subjecting the exposed film to at least one of development or rinsing with an organic treatment liquid containing butyl acetate and a hydrocarbon having 11 or more carbon atoms, in which a content of the hydrocarbon having 11 or more carbon atoms in the organic treatment liquid is 1% by mass or more and 35% by mass or less; a pattern forming method capable of obtaining a pattern having excellent in-plane uniformity of a line width by a method for manufacturing an electronic device including the pattern forming method; and a method for manufacturing an electronic device including the pattern forming method.

EP 4 282 887 A1

**Description**

## BACKGROUND OF THE INVENTION

1. Field of the Invention

The present invention relates to a pattern forming method and a method for manufacturing an electronic device. More specifically, the present invention relates to a pattern forming method and a method for manufacturing an electronic device, which are suitably used for ultra-micro lithography process which can be applied to ultra large scale integration (LSI) and high-capacity microchip manufacturing process, nanoimprint mold manufacturing process, high-density information recording medium manufacturing process, and the like, and suitably used for other photofabrication processes.

2. Description of the Related Art

In the related art, in processes for manufacturing semiconductor devices such as an integrated circuit (IC) and LSI, nanofabrication by lithography using a photoresist composition has been performed. In recent years, along with high integration of integrated circuits, a formation of ultrafine patterns in a submicron region or quarter micron region has been required. Along with this, there is a tendency for an exposure wavelength to be shortened, such as from g-rays to i-rays and to KrF excimer laser light, and at present, an exposure machine using, as a light source, an ArF excimer laser having a wavelength of 193 nm has been developed. In addition, as a technique for further enhancing resolving power, development of a so-called immersion method in which a liquid having a high refractive index (hereinafter, also referred to as "immersion liquid") is filled between a projection lens and a sample has been progressed in the related art.

In addition, at present, in addition to the excimer laser light, development of lithography using electron beam (EB), X-rays, extreme ultraviolet rays (EUV), or the like has also been progressed. Along with this, a chemically amplified resist composition which is effectively sensitive to various types of radiation and has excellent sensitivity and resolution has been developed.

For example, WO2016/104565A discloses a pattern forming method of developing or washing (rinsing) a resist film with an organic treatment liquid in which a content of an oxidizing agent is in a specific range.

In addition, JP2011-065105A discloses a pattern forming method in which a resist film is formed of a negative tone chemically amplified resist composition which undergoes negative conversion by a crosslinking reaction, exposed to light, and then developed with a developer containing an organic solvent satisfying a specific condition.

Further, WO2016/158711A discloses a pattern forming method in which a resist film containing a resin that has an acid-decomposable repeating unit which is decomposed by action of acid to generate an acid with a pKa in a specific range is exposed to light, and then developed with a developer containing an organic solvent.

## SUMMARY OF THE INVENTION

As described in WO2016/104565A, JP2011-065105A, and WO2016/158711A above, it has been known in the related art to perform development or rinsing using an organic solvent in the pattern forming method. However, according to studies by the present inventors, in particular, in a case where a developer or rinsing liquid in the related art, containing an organic solvent, is used for a resist film formed of a polarity conversion resist composition containing an acid-decomposable resin and a photoacid generator, it has been found that there is room for improvement regarding in-plane uniformity of a line width of a pattern to be obtained.

Therefore, an object of the present invention is to provide a pattern forming method capable of obtaining a pattern having excellent in-plane uniformity of a line width, and a method for manufacturing an electronic device, including the pattern forming method.

The present inventors have found that the above-described objects can be achieved by the following configurations.

[1] A pattern forming method comprising:

(1) a step of forming a film using an actinic ray-sensitive or radiation-sensitive resin composition that contains a resin (A) which is decomposed by action of acid to increase polarity and a compound (B) which generates an acid by irradiation with an actinic ray or a radiation;
(2) a step of exposing the film; and
(3) a step of subjecting the exposed film to at least one of development or rinsing with an organic treatment liquid containing butyl acetate and a hydrocarbon having 11 or more carbon atoms,

in which a content of the hydrocarbon having 11 or more carbon atoms in the organic treatment liquid is 1% by mass or more and 35% by mass or less.

[2] The pattern forming method according to [1], in which the hydrocarbon having 11 or more carbon atoms is undecane.

[3] The pattern forming method according to [1] or [2],

in which the resin (A) which is decomposed by action of acid to increase polarity includes at least one selected from the group consisting of a group in which a hydrogen atom of a carboxy group is substituted with a leaving group which is eliminated by action of acid, a group in which a hydrogen atom of an alcoholic hydroxyl group is substituted with a leaving group which is eliminated by action of acid, and a group in which a hydrogen atom of a phenolic hydroxyl group is substituted with a leaving group which is eliminated by action of acid.

[4] The pattern forming method according to any one of [1] to [3],

in which the resin (A) which is decomposed by action of acid to increase polarity has a repeating unit represented by General Formula (AX),

In General Formula (AX),

$Xa_1$ represents a hydrogen atom or an alkyl group,

$Rx_1$ to $Rx_3$ each independently represent an alkyl group, a cycloalkyl group, an alkenyl group, or an aryl group, and two of $Rx_1$ to $Rx_3$ may be bonded to each other to form a ring.

[5] The pattern forming method according to any one of [1] to [4],

in which the resin (A) which is decomposed by action of acid to increase polarity has at least one selected from the group consisting of a lactone group, a carbonate group, a sultone group, and a cyclic group having a hydroxyl group.

[6] The pattern forming method according to any one of [1] to [5],

in which the resin (A) which is decomposed by action of acid to increase polarity has a repeating unit represented by General Formula (Y),

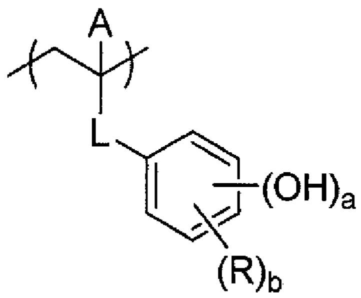

(Y)

In General Formula (Y),

A represents a hydrogen atom, an alkyl group, a cycloalkyl group, a halogen atom, or a cyano group,

L represents a single bond or a divalent linking group having an oxygen atom,

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, where in a case of a plurality of R's, the plurality of R's may be the same or different from each other, in a case where a plurality of R's are present, the plurality of R's may be bonded to each other to form a ring,

a represents an integer of 1 to 3, and

b represents an integer of 0 to (5 - a).

[7] The pattern forming method according to any one of [1] to [6],

in which the compound (B) which generates an acid by irradiation with an actinic ray or a radiation has a cation represented by General Formula (ZaI) or a cation represented by General Formula (ZaII),

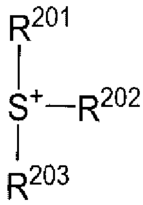

(ZaI)

$R^{204}$-$I^+$-$R^{205}$ (ZaII)

In General Formula (ZaI), $R^{201}$, $R^{202}$, and $R^{203}$ each independently represent an organic group, in General Formula (ZaII), $R^{204}$ and $R^{205}$ each independently represent an organic group.

[8] The pattern forming method according to [7],

in which at least one of $R^{201}$, $R^{202}$, or $R^{203}$ in General Formula (ZaI) is an aryl group, or at least one of $R^{204}$ or $R^{205}$ in General Formula (ZaII) is an aryl group.

[9] The pattern forming method according to [7] or [8],

in which at least one of $R^{201}$, $R^{202}$, or $R^{203}$ in General Formula (ZaI) has an acid-decomposable group, or at least one of $R^{204}$ or $R^{205}$ in General Formula (ZaII) has an acid-decomposable group.

[10] The pattern forming method according to any one of [1] to [9], in which a molecular weight of the acid generated from the compound (B) which generates an acid by irradiation with an actinic ray or a radiation is 250 or more.

[11] The pattern forming method according to any one of [1] to [10], in which a content of the compound (B) which generates an acid by irradiation with an actinic ray or a radiation is 10% by mass or more with respect to a total solid content of the actinic ray-sensitive or radiation-sensitive resin composition.

[12] The pattern forming method according to any one of [1] to [11],

in which the actinic ray-sensitive or radiation-sensitive resin composition contains two or more types of the compound (B) which generates an acid by irradiation with an actinic ray or a radiation, or the compound (B) which generates an acid by irradiation with an actinic ray or a radiation is at least one selected from the group consisting of the following compound (I) and the following compound (II),

Compound (I):

a compound having one or more of the following structural moieties X and one or more of the following structural moieties Y, in which the compound generates an acid including the following first acidic moiety derived from the following structural moiety X and the following second acidic moiety derived from the following structural moiety Y by irradiation with an actinic ray or a radiation,
Structural moiety X: a structural moiety which consists of an anionic moiety $A_1^-$ and a cationic moiety $M_1^+$, and forms a first acidic moiety represented by $HA_1$ by irradiation with an actinic ray or a radiation,
Structural moiety Y: a structural moiety which consists of an anionic moiety $A_2^-$ and a cationic moiety $M_2^+$, and forms a second acidic moiety represented by $HA_2$ by irradiation with an actinic ray or a radiation,
where, the compound (I) satisfies the following condition I,
Condition I: a compound PI, which is formed by, in the compound (I), replacing the cationic moiety $M_1^+$ in the structural moiety X and the cationic moiety $M_2^+$ in the structural moiety Y with $H^+$, has an acid dissociation constant a1 derived from the acidic moiety represented by $HA_1$, formed by replacing the cationic moiety $M_1^+$ in the structural moiety X with $H^+$, and has an acid dissociation constant a2 derived from the acidic moiety represented by $HA_2$, formed by replacing the cationic moiety $M_2^+$ in the structural moiety Y with $H^+$, in which the acid dissociation constant a2 is larger than the acid dissociation constant a1,

Compound (II):

a compound having two or more of the structural moieties X and one or more of the following structural moieties Z, in which the compound generates an acid including two or more of the first acidic moieties derived from the structural moiety X and the structural moiety Z by irradiation with an actinic ray or a radiation,

Structural moiety Z: a non-ionic moiety capable of neutralizing an acid.

[13] A method for manufacturing an electronic device, comprising: the pattern forming method according to any one of [1] to [12].

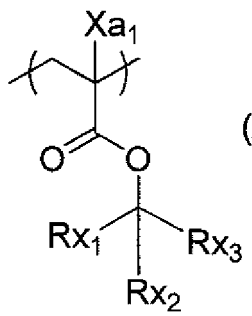

(AX)

According to the present invention, it is possible to provide a pattern forming method capable of obtaining a pattern having excellent in-plane uniformity of a line width, and a method for manufacturing an electronic device, including the pattern forming method.

## DESCRIPTION OF THE PREFERRED EMBODIMENTS

Hereinafter, the present invention will be described in detail.

Description of configuration requirements described below may be made on the basis of representative embodiments of the present invention in some cases, but the present invention is not limited to such embodiments.

In notations for a group (atomic group) in the present specification, in a case where the group is cited without specifying that it is substituted or unsubstituted, the group includes both a group having no substituent and a group having a substituent as long as it does not impair the spirit of the present invention. For example, an "alkyl group" includes not only an alkyl group having no substituent (unsubstituted alkyl group), but also an alkyl group having a substituent (substituted alkyl group). In addition, an "organic group" in the present specification refers to a group including at least one carbon atom.

A substituent is preferably a monovalent substituent unless otherwise specified.

"Actinic ray" or "radiation" in the present specification means, for example, a bright line spectrum of a mercury lamp, far ultraviolet rays typified by an excimer laser, extreme ultraviolet rays (EUV), X-rays, or electron beams (EB).

"Light" in the present specification means actinic ray or radiation.

Unless otherwise specified, "exposure" in the present specification encompasses not only exposure by a bright line spectrum of a mercury lamp, far ultraviolet rays typified by an excimer laser, extreme ultraviolet rays, X-rays, EUV light, or the like, but also drawing by particle beams such as electron beams and ion beams.

In the present specification, a numerical range expressed using "to" is used in a meaning of a range that includes the preceding and succeeding numerical values of "to" as the lower limit value and the upper limit value, respectively.

A bonding direction of divalent groups cited in the present specification is not limited unless otherwise specified. For example, in a case where Y in a compound represented by Formula "X-Y-Z" is -COO-, Y may be -CO-O- or -O-CO-. In addition, the above-described compound may be "X-CO-O-Z" or "X-O-CO-Z".

In the present specification, (meth)acrylate represents acrylate and methacrylate, and (meth)acryl represents acryl and methacryl.

In the present specification, a weight-average molecular weight (Mw), a number-average molecular weight (Mn), and a dispersity (hereinafter, also referred to as "molecular weight distribution") (Mw/Mn) are defined as values expressed in terms of polystyrene by means of gel permeation chromatography (GPC) measurement (solvent: tetrahydrofuran, flow amount (amount of a sample injected): 10 μL, columns: TSK gel Multipore HXL-M manufactured by Tosoh Corporation, column temperature: 40°C, flow rate: 1.0 mL/min, and detector: differential refractive index detector) using a GPC apparatus (HLC-8120GPC manufactured by Tosoh Corporation).

In the present specification, an acid dissociation constant (pKa) represents a pKa in an aqueous solution, and is specifically a value determined by computation from a value based on a Hammett's substituent constant and database of publicly known literature values, using the following software package 1. Any of the pKa values described in the

present specification indicates values determined by computation using the software package.

Software Package 1: Advanced Chemistry Development (ACD/Labs) Software V 8.14 for Solaris (1994 - 2007 ACD/Labs).

In addition, the pKa can also be determined by a molecular orbital computation method. Examples of a specific method therefor include a method for performing calculation by computing $H^+$ dissociation free energy in an aqueous solution based on a thermodynamic cycle. With regard to a computation method for $H^+$ dissociation free energy, the $H^+$ dissociation free energy can be computed by, for example, density functional theory (DFT), but various other methods have been reported in literature and the like, and are not limited thereto. There are a plurality of software applications capable of performing DFT, and examples thereof include Gaussian 16.

As described above, the pKa in the present specification refers to a value determined by computation from a value based on a Hammett's substituent constant and database of publicly known literature values, using the software package 1, but in a case where the pKa cannot be calculated by the method, a value obtained by Gaussian 16 based on density functional theory (DFT) shall be adopted.

In addition, the pKa in the present specification refers to a "pKa in an aqueous solution" as described above, but in a case where the pKa in an aqueous solution cannot be calculated, a "pKa in a dimethyl sulfoxide (DMSO) solution" shall be adopted.

[Pattern Forming Method]

The pattern forming method according to the embodiment of the present invention includes:

(1) a step of forming a film using an actinic ray-sensitive or radiation-sensitive resin composition that contains a resin (A) which is decomposed by action of acid to increase polarity and a compound (B) which generates an acid by irradiation with an actinic ray or a radiation;
(2) a step of exposing the film; and
(3) a step of subjecting the exposed film to at least one of development or rinsing with an organic treatment liquid containing butyl acetate and a hydrocarbon having 11 or more carbon atoms,

in which a content of the hydrocarbon having 11 or more carbon atoms in the organic treatment liquid is 1% by mass or more and 35% by mass or less.

Details of the mechanism capable of obtaining the pattern having excellent in-plane uniformity of the line width by the pattern forming method according to the embodiment of the present invention are not clear, but the present inventors have presumed as follows.

The organic treatment liquid, which contains butyl acetate and a hydrocarbon having 11 or more carbon atoms and having a specific composition in which the content of the hydrocarbon having 11 or more carbon atoms is 1% by mass or more and 35% by mass or less, has excellent affinity with a film formed of the actinic ray-sensitive or radiation-sensitive resin composition containing the resin (A) which is decomposed by action of acid to increase polarity and the compound (B) which generates an acid by irradiation with actinic ray or radiation. Therefore, it is considered that, by performing at least one of the development or the rinsing using the above-described organic treatment liquid, the above-described organic treatment liquid uniformly wets and spreads over the entire wafer, and the in-plane uniformity of the line width is improved.

Hereinafter, the procedure of each of the above-described steps will be described in detail.

<Step (1)>

The step (1) is a step of forming a film using an actinic ray-sensitive or radiation-sensitive resin composition that contains a resin (A) which is decomposed by action of acid to increase polarity and a compound (B) which generates an acid by irradiation with an actinic ray or a radiation.

The actinic ray-sensitive or radiation-sensitive resin composition used in the step (1) is typically a resist composition, and hereinafter, the actinic ray-sensitive or radiation-sensitive resin composition is also referred to as "resist composition". In addition, the film formed of the actinic ray-sensitive or radiation-sensitive resin composition is typically a resist film, and hereinafter, the film formed of the actinic ray-sensitive or radiation-sensitive resin composition is also referred to as "resist film".

Details of the actinic ray-sensitive or radiation-sensitive resin composition will be described later.

The step (1) is typically a step of forming a resist film on a substrate using the resist composition.

Examples of a method for forming a resist film on a substrate using the resist composition include a method in which a resist composition is applied to a substrate.

In addition, it is preferable that the resist composition before the application is filtered through a filter, as desired.

A pore size of the filter is preferably 0.1 μm or less, more preferably 0.05 μm or less, and still more preferably 0.03 μm or less. In addition, the filter is preferably a polytetrafluoroethylene-made filter, a polyethylene-made filter, or a nylon-made filter.

The resist composition can be applied to a substrate (for example, silicon and silicon dioxide coating) as used in the manufacture of integrated circuit elements by a suitable application method such as an application using a spinner or a coater. The coating method is preferably a spin coating using a spinner. A rotation speed upon the spin coating using a spinner is preferably 1000 to 3000 rotations per minute (rpm).

After the application of the resist composition, the substrate may be dried to form a resist film. In addition, various underlying films (an inorganic film, an organic film, or an antireflection film) may be formed on an underlayer of the resist film.

Examples of the drying method include a method of heating and drying. The heating can be carried out using a unit included in an ordinary exposure machine and/or development machine, and may also be carried out using a hot plate or the like. A heating temperature is preferably 80°C to 150°C, more preferably 80°C to 140°C, and still more preferably 80°C to 130°C. A heating time is preferably 30 to 1000 seconds, more preferably 60 to 800 seconds, and still more preferably 60 to 600 seconds.

A film thickness of the resist film is not particularly limited, but from the viewpoint that a fine pattern having higher accuracy can be formed, is preferably 10 to 120 nm. Among these, in a case of performing EUV exposure, the film thickness of the resist film is more preferably 10 to 65 nm and still more preferably 15 to 50 nm. In addition, in a case of performing ArF liquid immersion exposure, the film thickness of the resist film is more preferably 10 to 120 nm and still more preferably 15 to 90 nm.

A topcoat may be formed on an upper layer of the resist film using a topcoat composition.

It is preferable that the topcoat composition is not mixed with the resist film and can be uniformly applied to the upper layer of the resist film. The topcoat is not particularly limited, a topcoat known in the related art can be formed by the methods known in the related art, and for example, the topcoat can be formed based on the description in paragraphs [0072] to [0082] of JP2014-059543A.

For example, it is preferable that a topcoat including a basic compound as described in JP2013-61648A is formed on the resist film. Specific examples of the basic compound which can be included in the topcoat include a basic compound which may be included in the resist composition.

In addition, it is also preferable that the topcoat includes a compound which includes at least one group or bond selected from the group consisting of an ether bond, a thioether bond, a hydroxyl group, a thiol group, a carbonyl bond, and an ester bond.

<Step (2)>

The step (2) is a step of exposing the resist film.

Examples of an exposing method include a method in which the formed resist film is irradiated with actinic ray or radiation through a predetermined mask.

Examples of the actinic ray or radiation include infrared light, visible light, ultraviolet light, far ultraviolet light, extreme ultraviolet light, X-rays, and electron beams, preferably a far ultraviolet light having a wavelength of 250 nm or less, more preferably a far ultraviolet light having a wavelength of 220 nm or less, and particularly preferably a far ultraviolet light having a wavelength of 1 to 200 nm, specifically, KrF excimer laser (248 nm), ArF excimer laser (193 nm), $F_2$ excimer laser (157 nm), EUV (13 nm), X-rays, and electron beams.

It is preferable to perform baking (heating) before performing development and after the exposure. The baking accelerates a reaction in the exposed portion, and the sensitivity and the pattern shape are improved.

A heating temperature is preferably 80°C to 150°C, more preferably 80°C to 140°C, and still more preferably 80°C to 130°C.

A heating time is preferably 10 to 1000 seconds, more preferably 10 to 180 seconds, and still more preferably 30 to 120 seconds.

The heating can be carried out using a unit included in an ordinary exposure machine and/or development machine, and may also be performed using a hot plate or the like.

This step is also referred to as a post-exposure baking.

<Step (3)>

The step (3) is a step of subjecting the resist film exposed in the step (2) to at least one of development or rinsing with an organic treatment liquid containing butyl acetate and a hydrocarbon having 11 or more carbon atoms. The content of the above-described hydrocarbon having 11 or more carbon atoms in the above-described organic treatment liquid is 1% by mass or more and 35% by mass or less.

The organic treatment liquid used in the step (3) contains butyl acetate and a hydrocarbon having 11 or more carbon atoms. The hydrocarbon having 11 or more carbon atoms is preferably an alkane, more preferably an alkane having 11 to 15 carbon atoms, still more preferably an alkane having 11 to 13 carbon atoms, particularly preferably undecane or dodecane, and most preferably undecane. In a case where the alkane such as undecane and dodecane has structural isomers, the hydrocarbon having 11 or more carbon atoms may include the structural isomers.

The organic treatment liquid may contain one kind of the hydrocarbon having 11 or more carbon atoms, or may contain two or more kinds thereof.

A content of the hydrocarbon having 11 or more carbon atoms (in a case where a plurality types of the hydrocarbons having 11 or more carbon atoms are contained, the total amount thereof) in the organic treatment liquid is 1% by mass or more and 35% by mass or less with respect to 100% by mass of the entire organic treatment liquid, preferably 5% by mass or more and 30% by mass or less and more preferably 10% by mass or more and 25% by mass or less.

The organic treatment liquid used in the step (3) contains butyl acetate (n-butyl acetate).

A content of the butyl acetate in the organic treatment liquid is preferably 65% by mass or more and 99% by mass or less, more preferably 70% by mass or more and 95% by mass or less, and still more preferably 75% by mass or more and 90% by mass or less with respect to 100% by mass of the entire organic treatment liquid.

The organic treatment liquid may contain other components in addition to the butyl acetate and the hydrocarbon having 11 or more carbon atoms. Examples of the other components include a surfactant, an antioxidant, and a basic compound. A content of the other components in the organic treatment liquid is preferably 0% by mass or more and 5% by mass or less, more preferably 0% by mass or more and 1% by mass or less, still more preferably 0% by mass or more and 0.5% by mass or less, and particularly preferably 0% by mass (that is, the organic treatment liquid does not contain the other components) with respect to 100% by mass of the entire organic treatment liquid.

The step (3) is a step of subjecting the resist film exposed in the step (2) to at least one of development or rinsing (washed) with the above-described organic treatment liquid. In the step (3), only the development may be performed, only the rinsing may be performed, or the development and the rinsing may be performed.

Hereinafter, a case where the development is performed in the step (3) (hereinafter, the step of performing the development with the above-described organic treatment liquid is also referred to as a step (3A)) and a case where the rinsing is performed in the step (3) (hereinafter, the step of performing the rinsing with the above-described organic treatment liquid is also referred to as a step (3B)) will be described.

The step (3) may be a step including only the step (3A), a step including only the step (3B), or a step including the step (3A) and the step (3B). In a case where the step (3) includes the step (3A) and the step (3B), the organic treatment liquid used in the step (3A) as a developer and the organic treatment liquid used in the step (3B) as a rinsing liquid may be the same or different from each other.

A particularly preferred aspect of the present invention is an aspect in which an organic treatment liquid which contains butyl acetate and undecane, in which "butyl acetate/undecane" is "90/10" in a mass ratio, is used as the rinsing liquid.

[Step (3A)]

A case (step (3A)) where the development is performed with the above-described organic treatment liquid in the step (3) will be described. In the step (3A), the above-described organic treatment liquid is used as a developer.

Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).

In addition, after the step of performing the development, a step of stopping the development may be carried out while replacing the solvent with another solvent.

A developing time is not particularly limited as long as it is a period of time in which the resin of a portion to be removed is sufficiently dissolved, and is preferably 10 to 300 seconds and more preferably 20 to 120 seconds.

A temperature of the developer is preferably 0°C to 50°C and more preferably 15°C to 35°C.

By performing the step (3A), a resist pattern (also simply referred to as "pattern") is formed.

After performing the step (3A), it is preferable to perform rinsing. The rinsing can be performed according to a step (3B) described later, or can be performed using a rinsing liquid other than the above-described organic treatment liquid.

The rinsing liquid other than the above-described organic treatment liquid is not particularly limited as long as the it does not dissolve the pattern, and a solution containing a general organic solvent can be used. As the rinsing liquid other than the above-described organic treatment liquid, a rinsing liquid containing at least one organic solvent selected

from the group consisting of a hydrocarbon-based solvent, a ketone-based solvent, an ester-based solvent, an alcohol-based solvent, an amide-based solvent, and an ether-based solvent is preferable. Even in a case where the rinsing is performed using the rinsing liquid other than the above-described organic treatment liquid, the rinsing method can be carried out in the same manner as the rinsing method in the step (3B) described later.

[Step (3B)]

A case (step (3B)) where the development is performed with the above-described organic treatment liquid in the step (3) will be described. In the step (3B), the above-described organic treatment liquid is used as a rinsing liquid.

A method for the rinsing is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

Before performing the step (3B), it is preferable to perform development. The development can be performed according to the step (3A) described above, or can be performed using a developer other than the above-described organic treatment liquid.

It is preferable to use an organic developer as the developer other than the above-described organic treatment liquid.

Even in a case where the development is performed using the developer other than the above-described organic treatment liquid, the development method can be carried out in the same manner as the development method in the step (3A) described above.

The organic developer is preferably a developer containing at least one organic solvent selected from the group consisting of a ketone-based solvent, an ester-based solvent, an alcohol-based solvent, an amide-based solvent, an ether-based solvent, and a hydrocarbon-based solvent.

A plurality of the above-described organic solvents may be mixed, or the organic solvent may be used in admixture with a solvent other than those described above or water. A moisture content in the entire developer is preferably less than 50% by mass, more preferably less than 20% by mass, and still more preferably less than 10% by mass, and it is particularly preferable that the entire developer contains substantially no water.

A content of the organic solvent with respect to the organic developer is preferably 50% by mass to 100% by mass, more preferably 80% by mass to 100% by mass, still more preferably 90% by mass to 100% by mass, and particularly preferably 95% by mass to 100% by mass with respect to the total amount of the developer.

In addition, the pattern forming method according to the embodiment of the present invention may include a heating step (postbaking) after the rinsing step. By this step, the developer and the rinsing liquid remaining between and inside the patterns are removed. In addition, this step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 seconds to 120 seconds).

In addition, an etching treatment on the substrate may be carried out using the formed pattern as a mask. That is, the substrate (or the underlayer film and the substrate) may be processed using the pattern formed in the step (3) as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step (3) as a mask is preferable. Oxygen plasma etching is preferable as the dry etching.

It is preferable that the organic treatment liquid, resist composition, and various materials (for example, the solvent, the developer, the rinsing liquid, a composition for forming the antireflection film, a composition for forming the topcoat, and the like) used in the pattern forming method according to the embodiment of the present invention do not include impurities such as metals. A content of the impurities included in these materials is preferably 1 part per million (ppm) by mass or less, more preferably 10 parts per billion (ppb) by mass or less, still more preferably 100 parts per trillion (ppt) by mass or less, particularly preferably 10 ppt by mass or less, and most preferably 1 ppt by mass or less. The lower limit thereof is not particularly limited, but is preferably 0 ppt by mass or more. Here, examples of the metal impurities include Na, K, Ca, Fe, Cu, Mg, Al, Li, Cr, Ni, Sn, Ag, As, Au, Ba, Cd, Co, Pb, Ti, V, W, and Zn.

Examples of a method for removing the impurities such as metals from the various materials include filtration using a filter. Details of the filtration using a filter are described in paragraph [0321] of WO2020/004306A.

In addition, examples of a method for reducing the impurities such as metals included in the various materials include a method of selecting raw materials having a low content of metals as raw materials constituting the various materials, a method of subjecting raw materials constituting the various materials to filter filtration, and a method of performing distillation under the condition for suppressing the contamination as much as possible by, for example, lining the inside of a device with TEFLON (registered trademark).

In addition to the filter filtration, removal of the impurities by an adsorbing material may be performed, or a combination of filter filtration and an adsorbing material may be used. As the adsorbing material, known adsorbing materials can be used, and for example, inorganic adsorbing materials such as silica gel and zeolite and organic adsorbing materials such as activated carbon can be used. It is necessary to prevent the incorporation of impurities such as metals in the production process in order to reduce the metal impurities included in the above-described various materials. Sufficient removal of the metal impurities from a production device can be confirmed by measuring the content of metal components included in a washing solution used to wash the production device. A content of the metal components included in the washing solution after the use is preferably 100 ppt by mass or less, more preferably 10 ppt by mass or less, and still more preferably 1 ppt by mass or less. The lower limit thereof is not particularly limited, but is preferably 0 ppt by mass or more.

A conductive compound may be added to an organic treatment liquid such as the rinsing liquid in order to prevent breakdown of chemical liquid pipes and various parts (a filter, an O-ring, a tube, and the like) due to electrostatic charging, and subsequently generated electrostatic discharging. The conductive compound is not particularly limited, and examples thereof include methanol. An addition amount is not particularly limited, but from the viewpoint that preferred development characteristics or rinsing characteristics are maintained, the addition amount is preferably 10% by mass or less and more preferably 5% by mass or less. The lower limit thereof is not particularly limited, but is preferably 0.01% by mass or more.

For members of the chemical liquid pipe, for example, various pipes coated with stainless steel (SUS), or a polyethylene, polypropylene, or a fluororesin (a polytetrafluoroethylene resin, a perfluoroalkoxy resin, or the like) that has been subjected to an antistatic treatment can be used. In the same manner, for the filter or the O-ring, polyethylene, polypropylene, or a fluororesin (polytetrafluoroethylene, a perfluoroalkoxy resin, or the like) that has been subjected to an antistatic treatment can be used.

[Actinic Ray-Sensitive or Radiation-Sensitive Resin Composition]

The actinic ray-sensitive or radiation-sensitive resin composition used in the present invention will be described.

The actinic ray-sensitive or radiation-sensitive resin composition (also referred to as "resist composition") used in the present invention contains a resin (A) which is decomposed by action of acid to increase polarity (referred to as "acid-decomposable resin" or "resin (A)") and a compound (B) which generates an acid by irradiation with actinic ray or radiation (referred to as "photoacid generator" or "compound (B)").

The resist composition is preferably a negative tone resist composition. In addition, the resist composition is preferably a resist composition for organic solvent development.

The resist composition is typically a chemically amplified resist composition.

[Acid-decomposable Resin (Resin (A))]

The resist composition contains a resin (A).

In the pattern forming method according to the embodiment of the present invention, typically, in a case where the organic developer is adopted as the developer, a negative tone pattern is suitably formed.

The resin (A) usually includes a repeating unit having a group having a polarity that increases through decomposition by action of acid (also referred to as "acid-decomposable group"), and preferably includes a repeating unit having an acid-decomposable group.

As the repeating unit having an acid-decomposable group, in addition to (repeating Unit having an acid-decomposable group) described below, (repeating unit having an acid-decomposable group including an unsaturated bond) is preferable.

<Repeating Unit having Acid-decomposable Group>

(Repeating Unit having Acid-decomposable Group)

The acid-decomposable group is preferably a group which is decomposed by action of acid to form a polar group.

The acid-decomposable group preferably has a structure in which a polar group is protected by a leaving group which is eliminated by action of acid. That is, the resin (A) preferably has a repeating unit having a group which is decomposed by action of acid to generate a polar group. The resin having this repeating unit has an increased polarity by action of acid, an increased solubility in an alkali developer, and a decreased solubility in an organic solvent.

As the above-described polar group, an alkali-soluble group is preferable, and examples thereof include an acidic group, such as a carboxy group, a phenolic hydroxyl group, a fluorinated alcohol group, a sulfonic acid group, a phosphoric acid group, a sulfonamide group, a sulfonylimide group, an (alkylsulfonyl)(alkylcarbonyl)methylene group,

an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group; and an alcoholic hydroxyl group.

As the above-described polar group, a carboxy group, a phenolic hydroxyl group, a fluorinated alcohol group (preferably, a hexafluoroisopropanol group), or a sulfonic acid group is preferable.

Examples of the leaving group which is eliminated by action of acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): $-C(Rn)(H)(Ar)$

In Formula (Y1) and Formula (Y2), $Rx_1$ to $Rx_3$ each independently represent a (linear or branched) alkyl group, a (monocyclic or polycyclic) cycloalkyl group, an (linear or branched) alkenyl group, or a (monocyclic or polycyclic) aryl group. In a case where all of $Rx_1$ to $Rx_3$ are (linear or branched) alkyl groups, it is preferable that at least two of $Rx_1$ to $Rx_3$ are methyl groups.

Among these, it is preferable that $Rx_1$ to $Rx_3$ each independently represent a linear or branched alkyl group, and it is more preferable that $Rx_1$ to $Rx_3$ each independently represent a linear alkyl group.

Two of $Rx_1$ to $Rx_3$ may be bonded to each other to form a monocycle or a polycycle.

As the alkyl group of $Rx_1$ to $Rx_3$, an alkyl group having 1 to 5 carbon atoms, such as a methyl group, an ethyl group, an n-propyl group, an isopropyl group, an n-butyl group, an isobutyl group, and a t-butyl group, is preferable.

As the cycloalkyl group of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of $Rx_1$ to $Rx_3$, an aryl group having 6 to 10 carbon atoms is preferable, and examples thereof include a phenyl group, a naphthyl group, and an anthryl group.

As the alkenyl group of $Rx_1$ to $Rx_3$, a vinyl group is preferable.

A cycloalkyl group is preferable as the ring formed by the bonding of two of $Rx_1$ to $Rx_3$. As a cycloalkyl group formed by the bonding of two of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of $Rx_1$ to $Rx_3$, for example, one of methylene groups constituting the ring may be replaced with a heteroatom such as an oxygen atom, with a group including a heteroatom, such as a carbonyl group, or with a vinylidene group. In addition, in the cycloalkyl group, one or more of the ethylene groups constituting the cycloalkane ring may be replaced with a vinylene group.

With regard to the group represented by Formula (Y1) or Formula (Y2), for example, an aspect in which $Rx_1$ is a methyl group or an ethyl group and $Rx_2$ and $Rx_3$ are bonded to each other to form the above-described cycloalkyl group is preferable.

For example, in a case where the resist composition is a resist composition for EUV exposure, it is also preferable that the alkyl group, cycloalkyl group, alkenyl group, and aryl group represented by $Rx_1$ to $Rx_3$ and the ring formed by bonding two of $Rx_1$ to $Rx_3$ further have a fluorine atom or an iodine atom as a substituent.

In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ is a hydrogen atom.

The alkyl group, the cycloalkyl group, the aryl group, and the aralkyl group may include a heteroatom such as an oxygen atom, and/or a group including a heteroatom, such as a carbonyl group. For example, in the above-described alkyl group, cycloalkyl group, aryl group, and aralkyl group, one or more of methylene groups may be replaced with a heteroatom such as an oxygen atom and/or with a group including a heteroatom, such as a carbonyl group.

In addition, $R_{38}$ and another substituent included in the main chain of the repeating unit may be bonded to each other to form a ring. A group formed by the mutual bonding of $R_{38}$ and another substituent on the main chain of the repeating unit is preferably an alkylene group such as a methylene group.

For example, in a case where the resist composition is a resist composition for EUV exposure, it is also preferable

that the monovalent organic group represented by $R_{36}$ to $R_{38}$ and the ring formed by bonding $R_{37}$ and $R_{38}$ with each other further have a fluorine atom or an iodine atom as a substituent.

As Formula (Y3), a group represented by Formula (Y3-1) is preferable.

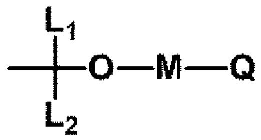

(Y3-1)

Here, $L_1$ and $L_2$ each independently represent a hydrogen atom, an alkyl group, a cycloalkyl group, an aryl group, or a group formed by a combination thereof (for example, a group formed by a combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by a combination thereof (for example, a group formed by a combination of an alkyl group and a cycloalkyl group).

In the alkyl group and the cycloalkyl group, for example, one of methylene groups may be replaced with a heteroatom such as an oxygen atom or with a group including a heteroatom, such as a carbonyl group.

It is preferable that one of $L_1$ or $L_2$ is a hydrogen atom, and the other is an alkyl group, a cycloalkyl group, an aryl group, or a group formed by a combination of an alkylene group and an aryl group.

At least two of Q, M, or $L_1$ may be bonded to each other to form a ring (preferably a 5- or 6-membered ring).

From the viewpoint of pattern miniaturization, $L_2$ is preferably a secondary or tertiary alkyl group, and more preferably a tertiary alkyl group. Examples of the secondary alkyl group include an isopropyl group, a cyclohexyl group, and a norbornyl group, and examples of the tertiary alkyl group include a tert-butyl group and an adamantane group. In these aspects, since a glass transition temperature (Tg) and an activation energy are increased, it is possible to suppress fogging in addition to ensuring a film hardness.

For example, in a case where the resist composition is a resist composition for EUV exposure, it is also preferable that the alkyl group, cycloalkyl group, aryl group, and combination of these groups represented by $L_1$ and $L_2$ further have a fluorine atom or an iodine atom as a substituent. In addition, it is also preferable that the above-described alkyl group, cycloalkyl group, aryl group, and aralkyl group include a heteroatom such as an oxygen atom in addition to the fluorine atom and the iodine atom (that is, in the above-described alkyl group, cycloalkyl group, aryl group, and aralkyl group, for example, one of methylene groups may be replaced with a heteroatom such as an oxygen atom or with a group including a heteroatom, such as a carbonyl group).

In addition, for example, in a case where the resist composition is a resist composition for EUV exposure, in the alkyl group which may include a heteroatom, the cycloalkyl group which may include a heteroatom, the aryl group which may include a heteroatom, the amino group, the ammonium group, the mercapto group, the cyano group, the aldehyde group, and the group formed by a combination thereof, which are represented by Q, the heteroatom is also preferably a heteroatom selected from the group consisting of a fluorine atom, an iodine atom, and an oxygen atom.

In Formula (Y4), Ar represents an aromatic ring group. Rn represents an alkyl group, a cycloalkyl group, or an aryl group. Rn and Ar may be bonded to each other to form a non-aromatic ring. Ar is preferably an aryl group.

For example, in a case where the resist composition is a resist composition for EUV exposure, it is also preferable that the aromatic ring group represented by Ar and the alkyl group, cycloalkyl group, and aryl group represented by Rn further have a fluorine atom or an iodine atom as a substituent.

From the viewpoint that the acid decomposability of the repeating unit is excellent, in a case where a non-aromatic ring is directly bonded to a polar group (or a residue thereof) in a leaving group which protects the polar group, it is also preferable that a ring member atom adjacent to the ring member atom directly bonded to the polar group (or a residue thereof) in the non-aromatic ring has no halogen atom such as a fluorine atom as a substituent.

In addition, the leaving group which is eliminated by action of acid may be a 2-cyclopentenyl group having a substituent (an alkyl group and the like), such as a 3-methyl-2-cyclopentenyl group, and a cyclohexyl group having a substituent (an alkyl group and the like), such as a 1,1,4,4-tetramethylcyclohexyl group.

It is preferable that the resin (A) which is decomposed by action of acid to increase polarity includes at least one selected from the group consisting of a group in which a hydrogen atom of a carboxy group is substituted with a leaving group which is eliminated by action of acid, a group in which a hydrogen atom of an alcoholic hydroxyl group is substituted with a leaving group which is eliminated by action of acid, and a group in which a hydrogen atom of a phenolic hydroxyl group is substituted with a leaving group which is eliminated by action of acid.

As the repeating unit having an acid-decomposable group, a repeating unit represented by Formula (A) is also

preferable.

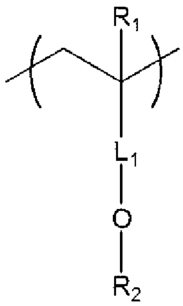

(A)

$L_1$ represents a divalent linking group which may have a fluorine atom or an iodine atom, $R_1$ represents a hydrogen atom, a fluorine atom, an iodine atom, a fluorine atom, an alkyl group which may have an iodine atom, or an aryl group which may have a fluorine atom or an iodine atom, and $R_2$ represents a leaving group which is eliminated by action of acid and may have a fluorine atom or an iodine atom. However, at least one of $L_1$, $R_1$, or $R_2$ has a fluorine atom or an iodine atom.

$L_1$ represents a divalent linking group which may have a fluorine atom or an iodine atom. Examples of the divalent linking group which may have a fluorine atom or an iodine atom include -CO-, -O-, -S-, -SO-, $-SO_2-$, a hydrocarbon group which may have a fluorine atom or an iodine atom (for example, an alkylene group, a cycloalkylene group, an alkenylene group, and an arylene group), and a linking group formed by the linking of a plurality of these groups. Among these, $L_1$ is preferably -CO-, an arylene group, or -arylene group-alkylene group having a fluorine atom or an iodine atom-, and more preferably -CO- or -arylene group-alkylene group having a fluorine atom or an iodine atom-.

As the arylene group, a phenylene group is preferable.

The alkylene group may be linear or branched. The number of carbon atoms in the alkylene group is not particularly limited, but is preferably 1 to 10 and more preferably 1 to 3.

The total number of fluorine atoms and iodine atoms included in the alkylene group having a fluorine atom or an iodine atom is not particularly limited, but is preferably 2 or more, more preferably 2 to 10, and still more preferably 3 to 6.

$R_1$ represents a hydrogen atom, a fluorine atom, an iodine atom, an alkyl group which may have a fluorine atom or an iodine atom, or an aryl group which may have a fluorine atom or an iodine atom.

The alkyl group may be linear or branched. The number of carbon atoms in the alkyl group is not particularly limited, but is preferably 1 to 10 and more preferably 1 to 3.

The total number of fluorine atoms and iodine atoms included in the alkyl group having a fluorine atom or an iodine atom is not particularly limited, but is preferably 1 or more, more preferably 1 to 5, and still more preferably 1 to 3.

The above-described alkyl group may include a heteroatom such as an oxygen atom other than a halogen atom.

$R_2$ represents a leaving group which is eliminated by action of acid and may have a fluorine atom or an iodine atom. Examples of the leaving group which may have a fluorine atom or an iodine atom include leaving groups which are represented by Formulae (Y1) to (Y4) described above and have a fluorine atom or an iodine atom.

As the repeating unit having an acid-decomposable group, a repeating unit represented by General Formula (AI) is also preferable.

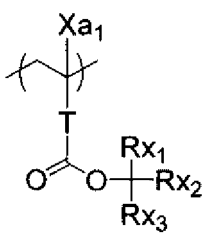

(A I)

In General Formula (AI),

$Xa_1$ represents a hydrogen atom or an alkyl group,
T represents a single bond or a divalent linking group,
$Rx_1$ to $Rx_3$ each independently represent an alkyl group, a cycloalkyl group, an alkenyl group, or an aryl group, and

two of $Rx_1$ to $Rx_3$ may be bonded to each other to form a ring.

The alkyl group represented by $Xa_1$ may be linear or branched. In addition, the above-described alkyl group may have a substituent. Examples of the above-described alkyl group include a methyl group and a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom. Among these, an alkyl group having 3 or less carbon atoms is preferable, and a methyl group is more preferable. $Xa_1$ is preferably a hydrogen atom, a methyl group, a trifluoromethyl group, or a hydroxymethyl group.

Examples of the divalent linking group of T include an alkylene group, an aromatic ring group, a -COO-Rt- group, and an -O-Rt- group. In the formulae, Rt represents an alkylene group or a cycloalkylene group.

T is preferably a single bond or a -COO-Rt- group and more preferably a single bond. In a case where T represents a -COO-Rt-group, Rt is preferably an alkylene group having 1 to 5 carbon atoms, and more preferably a $-CH_2-$ group, a $-(CH_2)_2-$ group, or a $-(CH_2)_3-$ group.

The alkyl group of $Rx_1$ to $Rx_3$ may be linear or branched. In addition, the above-described alkyl group may have a substituent. As the above-described alkyl group, an alkyl group having 1 to 4 carbon atoms, such as a methyl group, an ethyl group, an n-propyl group, an isopropyl group, an n-butyl group, an isobutyl group, and a t-butyl group, is preferable.

The cycloalkyl group of $Rx_1$ to $Rx_3$ may be a monocyclic cycloalkyl group or a polycyclic cycloalkyl group. In addition, the above-described cycloalkyl group may have a substituent. As the above-described cycloalkyl group, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable. In the above-described cycloalkyl group, for example, one of methylene groups constituting the ring may be replaced with a heteroatom such as an oxygen atom and a sulfur atom, with a group including a heteroatom, such as a carbonyl group, or with a vinylidene group. In addition, in the cycloalkyl group, one or more of the ethylene groups constituting the cycloalkane ring may be replaced with a vinylene group.

The aryl group of $Rx_1$ to $Rx_3$ may be a monocyclic aryl group or a polycyclic aryl group. In addition, the above-described aryl group may have a substituent. As the above-described aryl group, an aryl group having 6 to 10 carbon atoms is preferable, and examples thereof include a phenyl group, a naphthyl group, and an anthryl group.

The alkenyl group of $Rx_1$ to $Rx_3$ may be linear or branched. In addition, the above-described alkenyl group may have a substituent. The above-described alkenyl group is preferably a vinyl group.

In a case where two of $Rx_1$ to $Rx_3$ are bonded to each other to form a ring, the formed ring may be a monocyclic ring or a polycyclic ring. The formed ring is preferably a cycloalkyl group. As the above-described cycloalkyl group, a monocyclic cycloalkyl group such as a cyclopentyl group and a cyclohexyl group is preferable. In addition, a polycyclic cycloalkyl group such as a norbornyl group, a tetracyclodecanyl group, a tetracyclododecanyl group, and an adamantyl group is preferable. Among these, a monocyclic cycloalkyl group having 5 or 6 carbon atoms is preferable.

In the cycloalkyl group formed by the bonding of two of $Rx_1$ to $Rx_3$, for example, one of methylene groups constituting the ring may be replaced with a heteroatom such as an oxygen atom and a sulfur atom, with a group including a heteroatom, such as a carbonyl group, or with a vinylidene group. In addition, in the cycloalkyl group, one or more of the ethylene groups constituting the cycloalkane ring may be replaced with a vinylene group.

In a case where each of the above-described groups has a substituent, the substituent is not particularly limited, and examples of the substituent include an alkyl group (having 1 to 4 carbon atoms), a halogen atom, a hydroxyl group, an alkoxy group (having 1 to 4 carbon atoms), an alkylthio group (having 1 to 4 carbon atoms), a carboxy group, and an alkoxycarbonyl group (having 2 to 6 carbon atoms). The substituent preferably has 8 or less carbon atoms.

The repeating unit represented by General Formula (AI) is preferably a repeating unit represented by General Formula (AX).

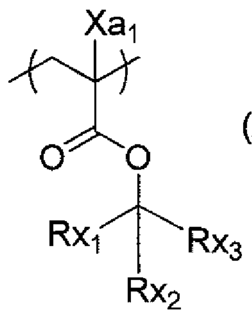

(AX)

In General Formula (AX),

$Xa_1$ represents a hydrogen atom or an alkyl group,
$Rx_1$ to $Rx_3$ each independently represent an alkyl group, a cycloalkyl group, an alkenyl group, or an aryl group, and two of $Rx_1$ to $Rx_3$ may be bonded to each other to form a ring.

$Xa_1$ in General Formula (AX) has the same meaning as $Xa_1$ in General Formula (AI) described above, and specific examples and preferred range thereof are also the same.

$Rx_1$ to $Rx_3$ in General Formula (AX) has the same meaning as $Rx_1$ to $Rx_3$ in General Formula (AI) described above, and specific examples and preferred range thereof are also the same.

As the repeating unit having an acid-decomposable group, a repeating unit represented by General Formula (AX2) is also preferable.

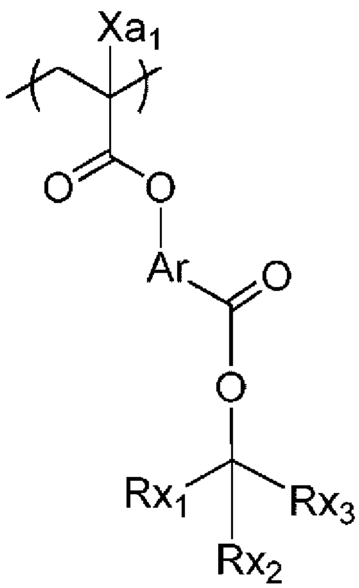

(AX2)

In General Formula (AX2),

$Xa_1$ represents a hydrogen atom or an alkyl group,
$Rx_1$ to $Rx_3$ each independently represent an alkyl group, a cycloalkyl group, an alkenyl group, or an aryl group, two of $Rx_1$ to $Rx_3$ may be bonded to each other to form a ring, and
Ar represents a divalent aromatic hydrocarbon group.

$Xa_1$ in General Formula (AX2) has the same meaning as $Xa_1$ in General Formula (AI) described above, and specific examples and preferred range thereof are also the same.

$Rx_1$ to $Rx_3$ in General Formula (AX2) has the same meaning as $Rx_1$ to $Rx_3$ in General Formula (AI) described above, and specific examples and preferred range thereof are also the same.

Ar in General Formula (AX2) is preferably an arylene group, more preferably an arylene group having 6 to 20 carbon atoms, still more preferably an arylene group having 6 to 10 carbon atoms, and particularly preferably a phenylene group. Ar may have a substituent, and examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms), and these groups preferably have 8 or less carbon atoms.

In a case where the resin (A) includes a group in which a hydrogen atom of a phenolic hydroxyl group is substituted with a leaving group which is eliminated by action of acid, the resin (A) preferably has a repeating unit having a structure in which the hydrogen atom in the phenolic hydroxyl group is protected by the group represented by Formulae (Y1) to (Y4).

As the group in which a hydrogen atom of a phenolic hydroxyl group is substituted with a leaving group which is eliminated by action of acid, a repeating unit represented by General Formula (AII) is preferable.

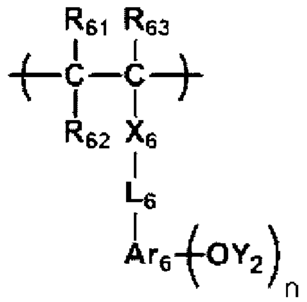

(AII)

In General Formula (AII),

$R_{61}$, $R_{62}$, and $R_{63}$ each independently represent a hydrogen atom, an alkyl group, a cycloalkyl group, a halogen atom, a cyano group, or an alkoxycarbonyl group. However, $R_{62}$ may be bonded to $Ar_6$ to form a ring, and in this case, $R_{62}$ represents a single bond or an alkylene group.

$X_6$ represents a single bond, -COO-, or -CONR$_{64}$-. $R_{64}$ represents a hydrogen atom or an alkyl group.

$L_6$ represents a single bond or an alkylene group.

$Ar_6$ represents an (n+1)-valent aromatic hydrocarbon group, and in a case of being bonded to $R_{62}$ to form a ring, $Ar_6$ represents an (n+2)-valent aromatic hydrocarbon group.

In a case where $n \geq 2$, $Y_2$'s each independently represent a hydrogen atom or a group eliminated due to action of acid. However, at least one of $Y_2$'s represents the group eliminated due to action of acid.

The group which is eliminated by action of acid, as $Y_2$, is preferably a group represented by Formulae (Y1) to (Y4) described above.

n represents an integer of 1 to 4.

Each of the above-described groups may have a substituent, and examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms), and these groups preferably have 8 or less carbon atoms.

A content of the repeating unit having an acid-decomposable group is preferably 15% by mole or more, more preferably 20% by mole or more, and still more preferably 30% by mole or more with respect to all repeating units in the resin (A). In addition, the upper limit value thereof is preferably 90% by mole or less, more preferably 80% by mole or less, still more preferably 70% by mole or less, and particularly preferably 60% by mole or less with respect to all repeating units in the resin (A).

Specific examples of the repeating unit having an acid-decomposable group are shown below, but the present invention is not limited thereto. In the formulae, $Xa_1$ represents H, $CH_3$, $CF_3$, or $CH_2OH$, and Rxa and Rxb each represent a linear or branched alkyl group having 1 to 5 carbon atoms.

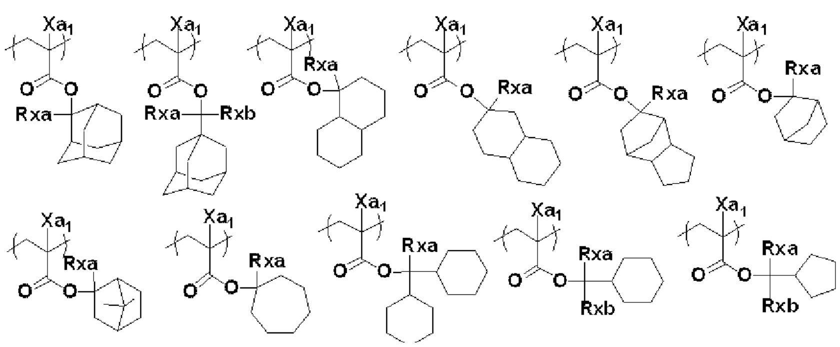

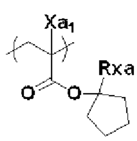
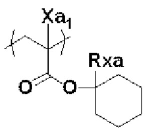
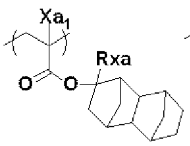
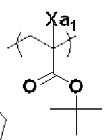
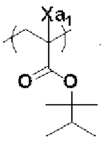
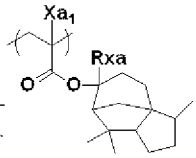

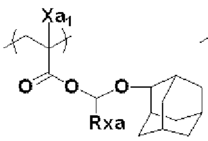
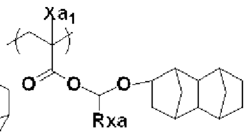
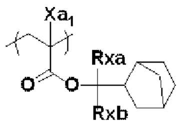
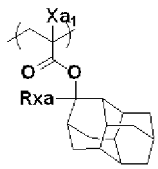

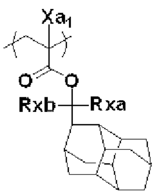
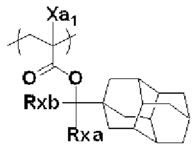
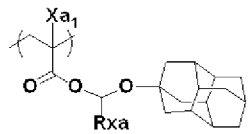
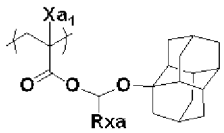

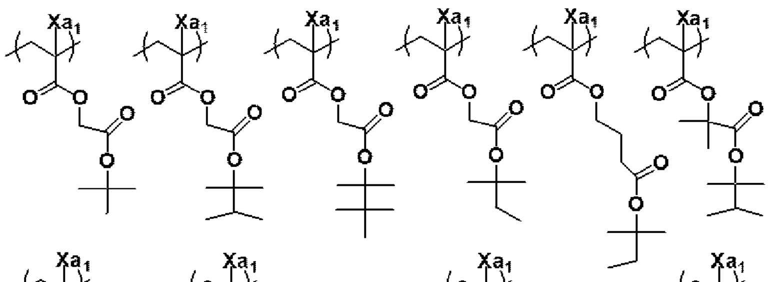

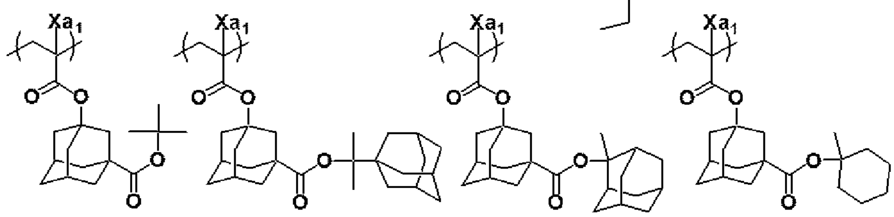

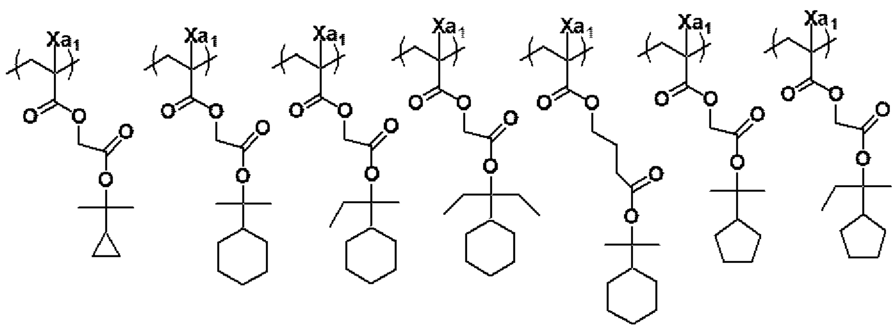

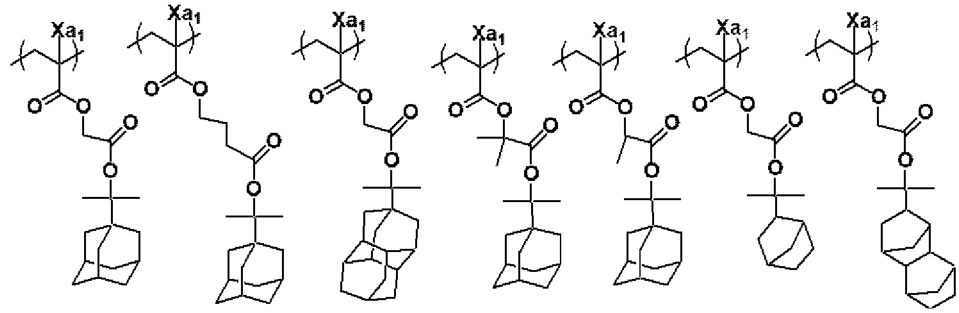

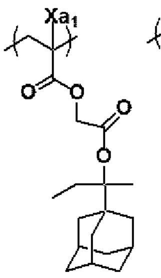
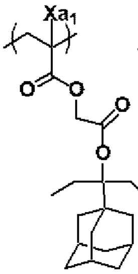
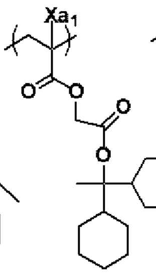
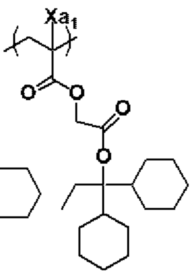
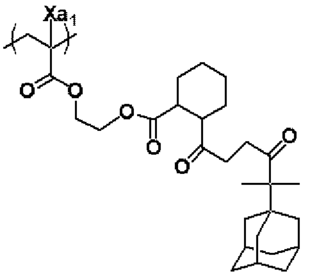

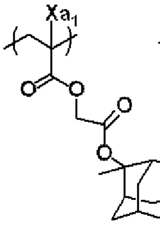
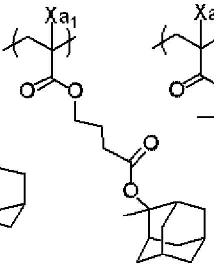
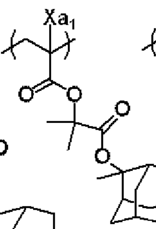
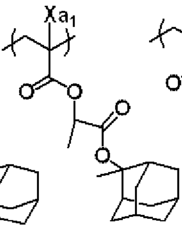
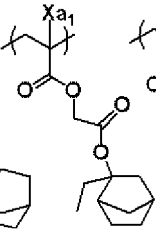
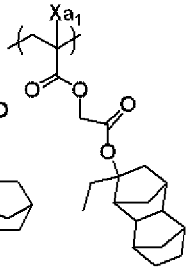

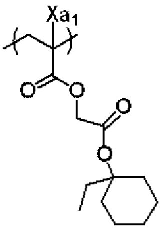
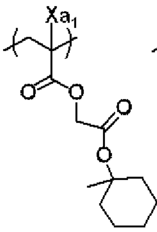
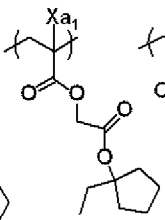
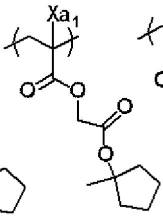
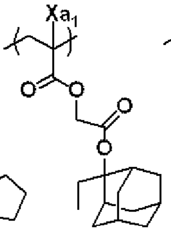
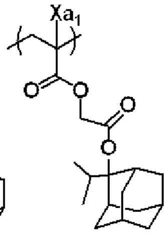

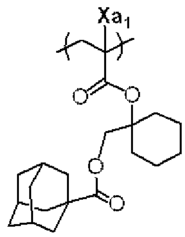
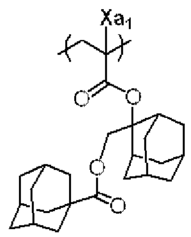

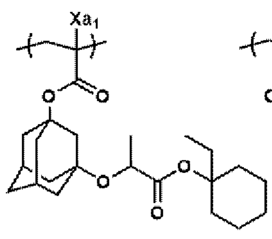
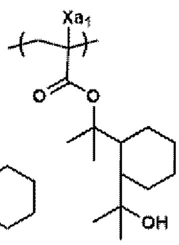
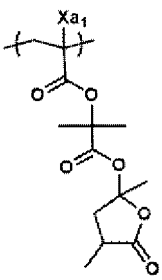
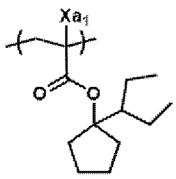
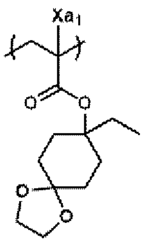

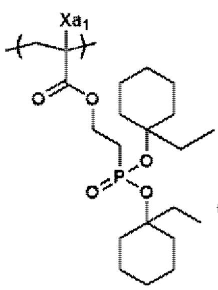
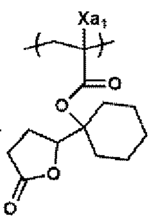
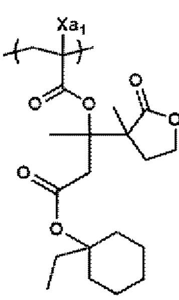
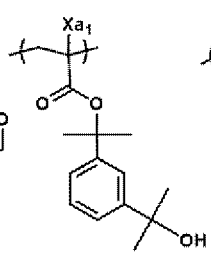
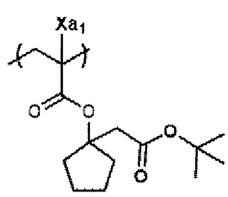

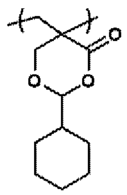
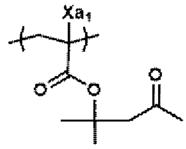
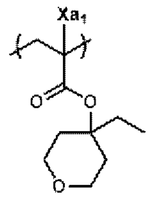
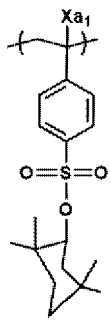
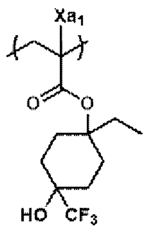
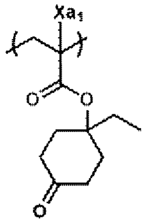
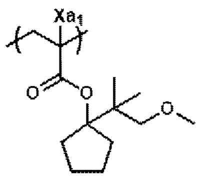
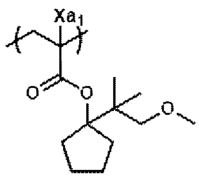
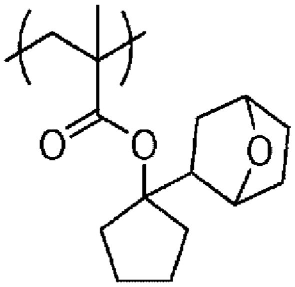
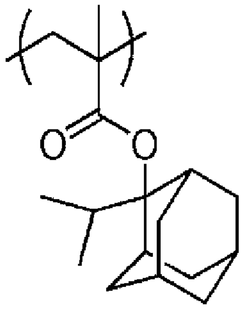
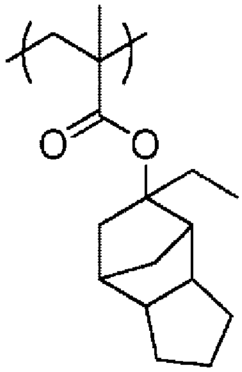
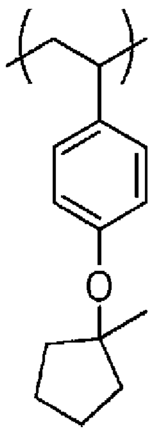
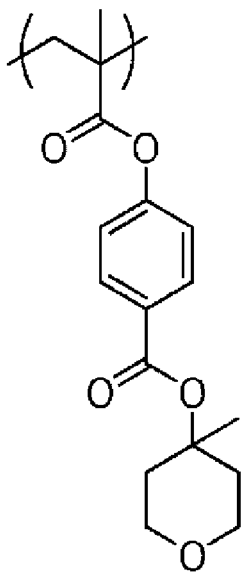

(Repeating Unit having Acid-decomposable Group including Unsaturated Bond)

The resin (A) may have a repeating unit which has an acid-decomposable group including an unsaturated bond.

As the repeating unit having an acid-decomposable group including an unsaturated bond, a repeating unit represented by Formula (B) is preferable.

Formula (B):

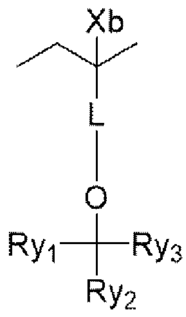

In Formula (B),

Xb represents a hydrogen atom, a halogen atom, or an alkyl group which may have a substituent,
L represents a single bond or a divalent linking group which may have a substituent,
$Ry_1$ to $Ry_3$ each independently represent a linear or branched alkyl group, a monocyclic or polycyclic cycloalkyl group, an alkenyl group, an alkynyl group, or a monocyclic or polycyclic aryl group, where, at least one of $Ry_1$, $Ry_2$, or $Ry_3$ represents an alkenyl group, an alkynyl group, a monocyclic or polycyclic cycloalkenyl group, or a monocyclic or polycyclic aryl group, and
two of $Ry_1$ to $Ry_3$ may be bonded to each other to form a monocycle or a polycycle (monocyclic or polycyclic cycloalkyl group, cycloalkenyl group, or the like).

Examples of the alkyl group which may have a substituent, represented by Xb, include a methyl group and a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom. Among these, an alkyl group having 3 or less carbon atoms is preferable, and a methyl group is more preferable. Xb is preferably a hydrogen atom, a fluorine atom, a methyl group, a trifluoromethyl group, or a hydroxymethyl group.

Examples of the divalent linking group of L include a -Rt- group, a -CO- group, a -COO-Rt- group, a -COO-Rt-CO- group, a -Rt-CO- group, and an -O-Rt- group. In the formulae, Rt represents an alkylene group, a cycloalkylene group, or an aromatic ring group, and an aromatic ring group is preferable.

L is preferably a -Rt- group, a -CO- group, a -COO-Rt-CO- group, or a -Rt-CO-group. Rt may have a substituent such as a halogen atom, a hydroxyl group, and an alkoxy group. An aromatic group is preferable.

As the alkyl group of $Ry_1$ to Rys, an alkyl group having 1 to 4 carbon atoms, such as a methyl group, an ethyl group, an n-propyl group, an isopropyl group, an n-butyl group, an isobutyl group, and a t-butyl group, is preferable.

As the cycloalkyl group of $Ry_1$ to $Ry_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of $Ry_1$ to $Ry_3$, an aryl group having 6 to 10 carbon atoms is preferable, and examples thereof include a phenyl group, a naphthyl group, and an anthryl group.

As the alkenyl group of $Ry_1$ to $Ry_3$, a vinyl group is preferable.

As the alkynyl group of $Ry_1$ to $Ry_3$, an ethynyl group is preferable.

As the cycloalkenyl group of $Ry_1$ to $Ry_3$, a structure in which a part of a monocyclic cycloalkyl group such as a cyclopentyl group and a cyclohexyl group includes a double bond is preferable.

As the cycloalkyl group formed by bonding two of $Ry_1$ to $Ry_3$, a monocyclic cycloalkyl group such as a cyclopentyl group and a cyclohexyl group is preferable. In addition, a polycyclic cycloalkyl group such as a norbornyl group, a tetracyclodecanyl group, a tetracyclododecanyl group, and an adamantyl group is preferable. Among these, a monocyclic cycloalkyl group having 5 or 6 carbon atoms is more preferable.

In the cycloalkyl group or cycloalkenyl group formed by the bonding of two of $Ry_1$ to Rys, for example, one of methylene groups constituting the ring may be replaced with a heteroatom such as an oxygen atom, with a group including a heteroatom, such as a carbonyl group, a $-SO_2-$ group, and a $-SO_3-$ group, with a vinylidene group, or with a combination of these groups. In addition, in the cycloalkyl group or cycloalkenyl group, one or more of the ethylene groups constituting the cycloalkane ring or cycloalkene ring may be replaced with a vinylene group.

With regard to the repeating unit represented by Formula (B), for example, an aspect in which $Ry_1$ is a methyl group, an ethyl group, a vinyl group, an allyl group, or an aryl group and $Ry_2$ and $Ry_3$ are bonded to each other to form the above-described cycloalkyl group or cycloalkenyl group is preferable.

In a case where each of the above-described groups has a substituent, examples of the substituent include an alkyl group (having 1 to 4 carbon atoms), a halogen atom, a hydroxyl group, an alkoxy group (having 1 to 4 carbon atoms), a carboxy group, and an alkoxycarbonyl group (having 2 to 6 carbon atoms). The substituent preferably has 8 or less carbon atoms.

The repeating unit represented by Formula (B) is preferably an acid-decomposable (meth)acrylic acid tertiary ester-based repeating unit (repeating unit in which Xb represents a hydrogen atom or a methyl group and L represents a -CO- group), an acid-decomposable hydroxystyrene tertiary alkyl ether-based repeating unit (repeating unit in which Xb represents a hydrogen atom or a methyl group and L represents a phenyl group), or an acid-decomposable styrene carboxylic acid tertiary ester-based repeating unit (repeating unit in which Xb represents a hydrogen atom or a methyl group and L represents a -Rt-CO- group (Rt is an aromatic group)).

A content of the repeating unit having an acid-decomposable group including an unsaturated bond is preferably 15% by mole or more, more preferably 20% by mole or more, and still more preferably 30% by mole or more with respect to all repeating units in the resin (A). In addition, the upper limit value thereof is preferably 80% by mole or less, more preferably 70% by mole or less, and particularly preferably 60% by mole or less with respect to all repeating units in the resin (A).

Specific examples of the repeating unit having an acid-decomposable group including an unsaturated bond are shown below, but the present invention is not limited thereto. In the formulae, Xb and $L_1$ represent any of the above-described substituents or linking groups; Ar represents an aromatic group; R represents a substituent such as a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR''' or -COOR'''; R''' is an alkyl group or fluorinated alkyl group having 1 to 20 carbon atoms), and a carboxy group; R' represents a linear or branched alkyl group, a monocyclic or polycyclic cycloalkyl group, an alkenyl group, an alkynyl group, or a monocyclic or polycyclic aryl group; Q represents a heteroatom such as an oxygen atom, a group containing a heteroatom, such as a carbonyl group, $-SO_2-$ group, and $-SO_3-$ group, a vinylidene group, or a combination thereof; and l, n, and m represent an integer of 0 or more.

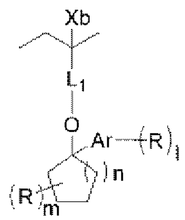
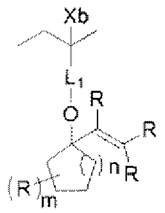
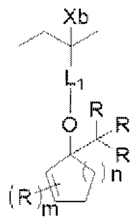
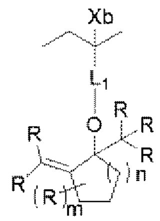
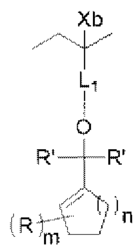
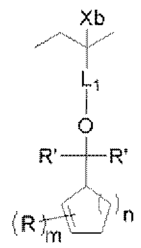

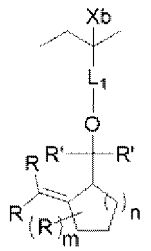
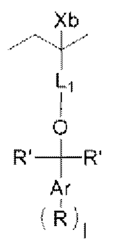
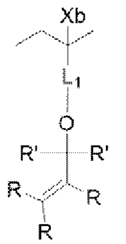
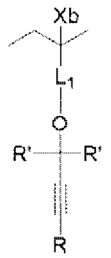
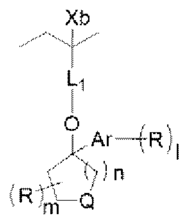
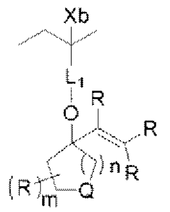

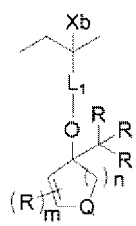
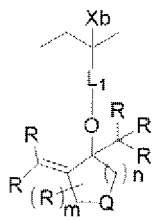

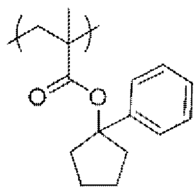
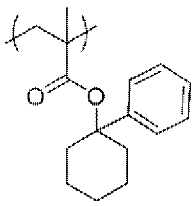
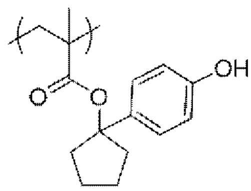
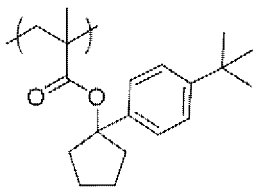

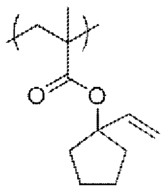
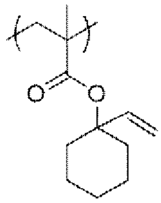
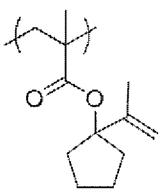
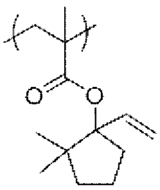

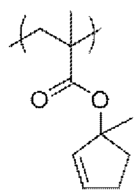
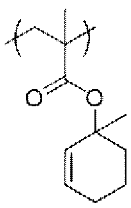
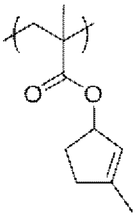
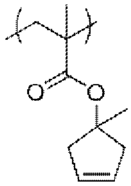

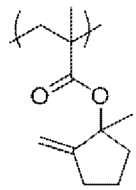
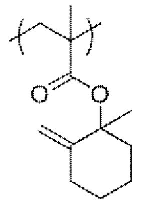
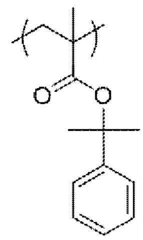
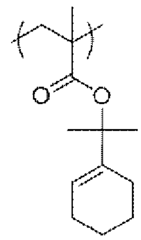

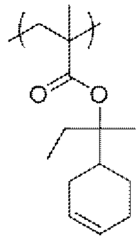
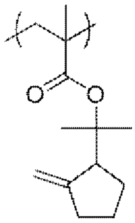
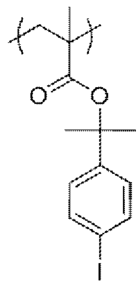
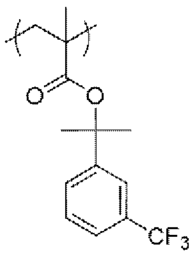

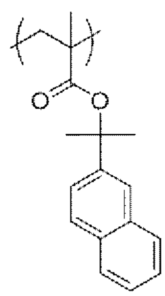
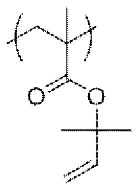
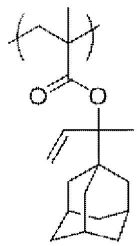
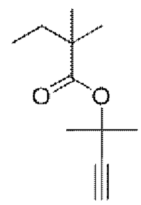

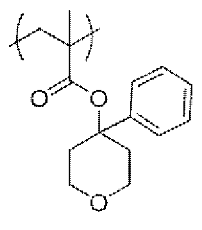
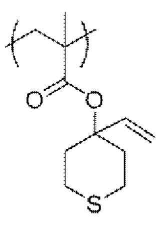
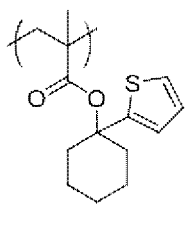
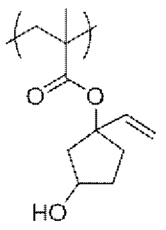
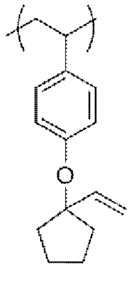
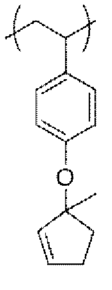
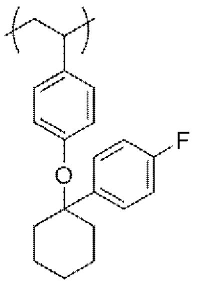
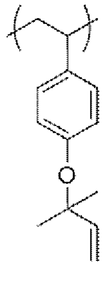
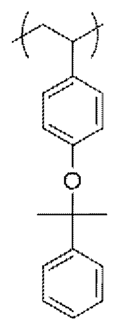
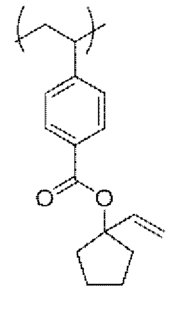
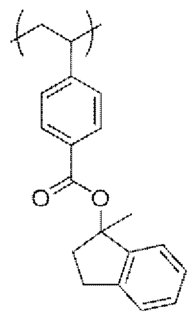
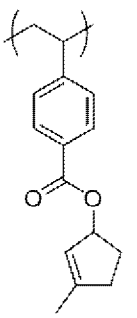
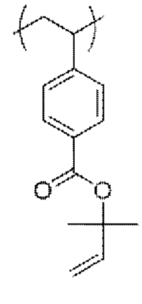
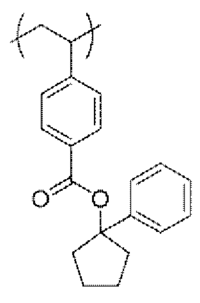
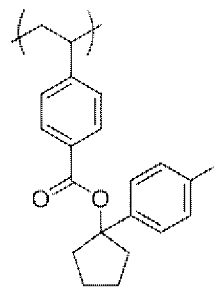
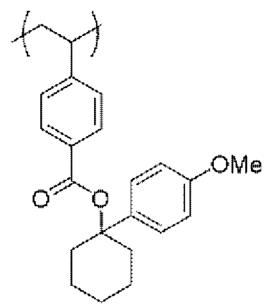
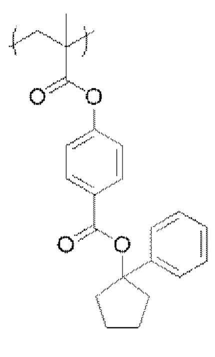
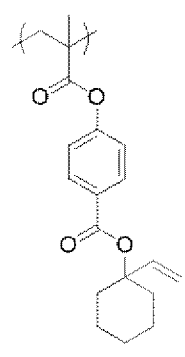
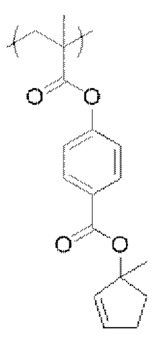
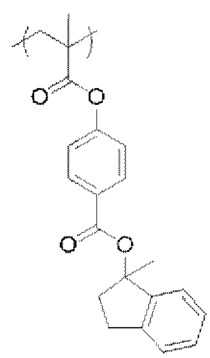

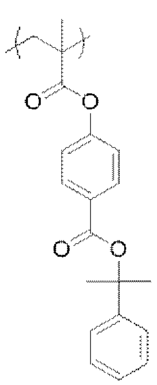
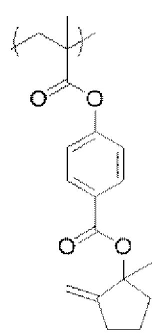
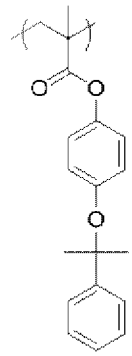
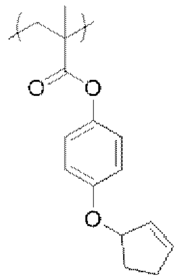

(Repeating Unit having Polar Group)

The resin (A) may have a repeating unit having a polar group.

Examples of the polar group include a hydroxyl group, a cyano group, and a carboxy group.

The repeating unit having a polar group is preferably a repeating unit having an alicyclic hydrocarbon structure substituted with a polar group. In addition, it is preferable that the repeating unit having a polar group does not have the acid-decomposable group. As an alicyclic hydrocarbon structure in the alicyclic hydrocarbon structure substituted with a polar group, an adamantyl group or a norbornyl group is preferable.

Specific examples of a monomer corresponding to the repeating unit having a polar group are shown below, but the present invention is not limited to these specific examples. The following specific examples are described as a methacrylic acid ester compound, but an acrylic acid ester compound may also be used.

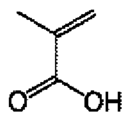
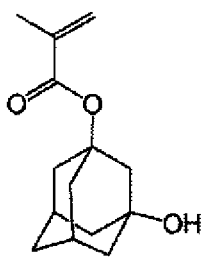
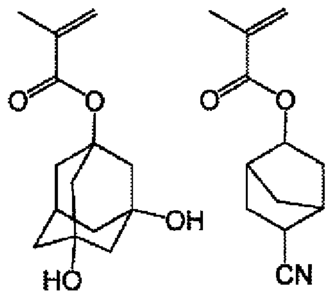

In addition, specific examples of the repeating unit having a polar group include constitutional units described in paragraphs 0415 to 0433 of US2016/0070167A.

The resin (A) may include only one kind of the repeating unit having a polar group or a combination of two or more kinds thereof.

In a case where the resin (A) includes the repeating unit having a polar group, a content thereof is preferably 0.1% to 40% by mole and more preferably 1% to 30% by mole with respect to all repeating units of the resin (A).

The resin (A) may include a repeating unit other than the above-described repeating units.

For example, the resin (A) may include at least one repeating unit selected from the group consisting of the following group A and/or at least one repeating unit selected from the group consisting of the following group B.

Group A: group consisting of the following repeating units (20) to (29)

(20) repeating unit having an acid group, which will be described later
(21) repeating unit having a fluorine atom or an iodine atom, which will be described later
(22) repeating unit having a lactone group, a sultone group, or a carbonate group, which will be described later
(23) repeating unit having a photoacid generating group, which will be described later
(24) repeating unit represented by Formula (V-1) or Formula (V-2), which will be described later
(25) repeating unit represented by Formula (A), which will be described later
(26) repeating unit represented by Formula (B), which will be described later
(27) repeating unit represented by Formula (C), which will be described later
(28) repeating unit represented by Formula (D), which will be described later

(29) repeating unit represented by Formula (E), which will be described later

Group B: group consisting of the following repeating units (30) to (32)

(30) repeating unit having at least one group selected from a lactone group, a sultone group, a carbonate group, a hydroxyl group, a cyano group, or an alkali-soluble group, which will be described later
(31) repeating unit having an alicyclic hydrocarbon structure and not exhibiting acid decomposability, which will be described later
(32) repeating unit represented by Formula (III) having neither a hydroxyl group nor a

cyano group, which will be described later

The resin (A) preferably has an acid group, and preferably includes a repeating unit having an acid group. The definition of the acid group will be described later together with a suitable aspect of the repeating unit having an acid group. In a case where the resin (A) has an acid group, interaction the resin (A) and the acid generated from the compound (B) is more excellent. As a result, diffusion of the acid is further suppressed, and a cross-sectional shape of the formed pattern can be more rectangular.
In a case where the resist composition is used as an actinic ray-sensitive or radiation-sensitive resin composition with EUV, it is preferable that the resin (A) has at least one repeating unit selected from the group consisting of the above-described group A.
In addition, in a case where the resist composition is used as an actinic ray-sensitive or radiation-sensitive resin composition with EUV, it is preferable that the resin (A) includes at least one of a fluorine atom or an iodine atom. In a case where the resin (A) includes both a fluorine atom and an iodine atom, the resin (A) may have one repeating unit including both a fluorine atom and an iodine atom, and the resin (A) may include two kinds of repeating units, that is, a repeating unit having a fluorine atom and a repeating unit having an iodine atom.
In addition, in a case where the resist composition is used as an actinic ray-sensitive or radiation-sensitive resin composition with EUV, it is also preferable that the resin (A) has a repeating unit having an aromatic group.
In a case where the resist composition is used as an actinic ray-sensitive or radiation-sensitive resin composition with ArF, it is preferable that the resin (A) has at least one repeating unit selected from the group consisting of the above-described group B.
In a case where the resist composition is used as an actinic ray-sensitive or radiation-sensitive resin composition with ArF, it is preferable that the resin (A) does not include a fluorine atom and a silicon atom.
In addition, in a case where the resist composition is used as an actinic ray-sensitive or radiation-sensitive resin composition with ArF, it is preferable that the resin (A) does not have an aromatic group.
It is preferable that the resin (A) has at least one selected from the group consisting of a lactone group, a carbonate group, a sultone group, and a cyclic group having a hydroxyl group. The lactone group, carbonate group, or sultone group will be described later. The cyclic group having a hydroxyl group is preferably an alicyclic group having a hydroxyl group, and specific examples thereof include groups exemplified below in the repeating unit having an acid group, which will be described below.

<Repeating Unit having Acid Group>

The resin (A) preferably has a repeating unit having an acid group.
As the acid group, an acid group having a pKa of 13 or less is preferable. As described above, the acid dissociation constant of the above-described acid group is preferably 13 or less, more preferably 3 to 13, and still more preferably 5 to 10.
In a case where the resin (A) has an acid group having a pKa of 13 or less, a content of the acid group in the resin (A) is not particularly limited, but is usually 0.2 to 6.0 mmol/g. Among these, 0.8 to 6.0 mmol/g is preferable, 1.2 to 5.0 mmol/g is more preferable, and 1.6 to 4.0 mmol/g is still more preferable. In a case where the content of the acid group is within the above-described range, the development proceeds satisfactorily, the formed pattern shape is excellent, and the resolution is also excellent.
As the acid group, for example, a carboxy group, a phenolic hydroxyl group, a fluoroalcohol group (preferably, a hexafluoroisopropanol group), a sulfonic acid group, a sulfonamide group, or an isopropanol group is preferable.
In addition, in the above-described hexafluoroisopropanol group, one or more (preferably one or two) fluorine atoms may be substituted with a group (an alkoxycarbonyl group and the like) other than a fluorine atom. $-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.
The repeating unit having an acid group is preferably a repeating unit different from the repeating unit having

the structure in which a polar group is protected by the leaving group which is eliminated by action of acid as described above, and the repeating unit having a lactone group, a sultone group, or a carbonate group, which will be described later.

The repeating unit having an acid group may have a fluorine atom or an iodine atom.

Examples of the repeating unit having an acid group include the following repeating units.

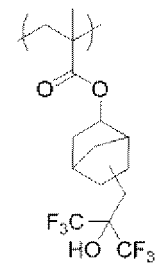
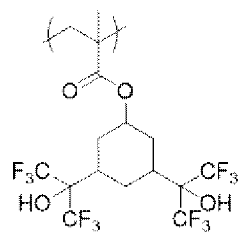
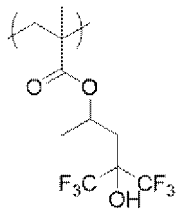
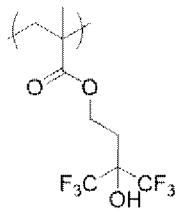
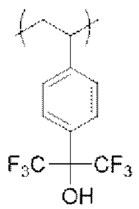
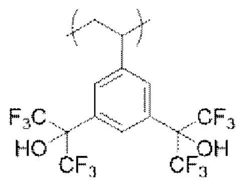
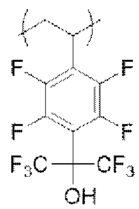
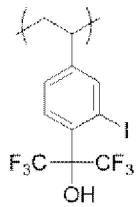
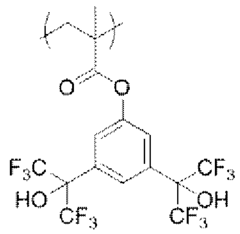
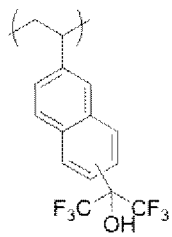

As the repeating unit having an acid group, a repeating unit represented by Formula (Y) is preferable.

The resin (A) preferably has the repeating unit represented by General Formula (Y).

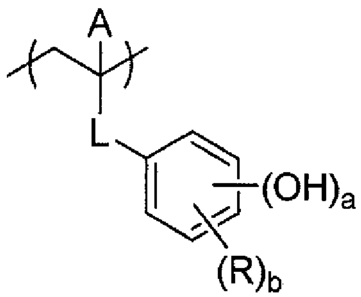

(Y)

In General Formula (Y),

A represents a hydrogen atom, an alkyl group, a cycloalkyl group, a halogen atom, or a cyano group,
L represents a single bond or a divalent linking group having an oxygen atom,
R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, where in a case of a plurality of R's, the plurality of R's may be the same or different from each other, in a case where a plurality of R's are present, the plurality of R's may be combined with each other to form a ring, R is preferably a hydrogen atom.
a represents an integer of 1 to 3, and
b represents an integer of 0 to (5 - a).

R in General Formula (Y) is preferably a hydrogen atom. L is preferably a single bond.

The repeating unit having an acid group is exemplified below. In the formulae, a represents 1 or 2.

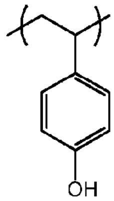
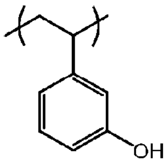
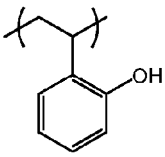

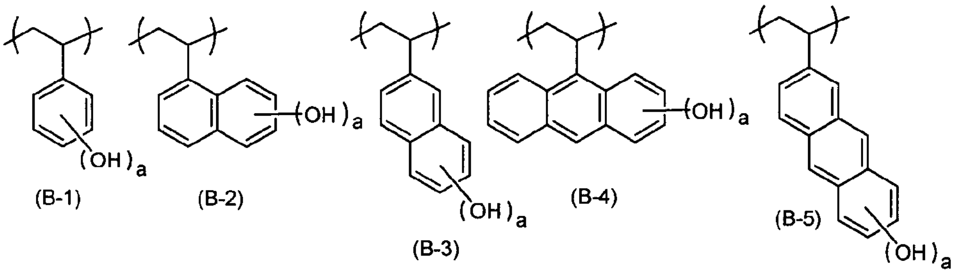
(B-1) (B-2) (B-3) (B-4) (B-5)

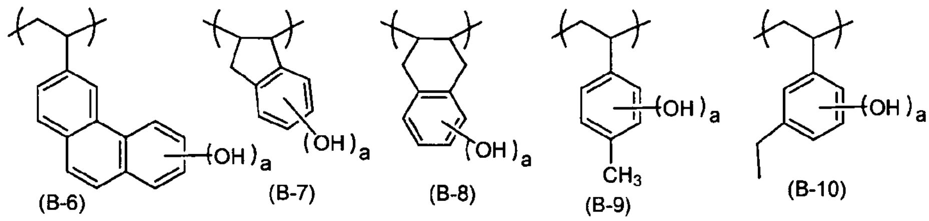
(B-6) (B-7) (B-8) (B-9) (B-10)

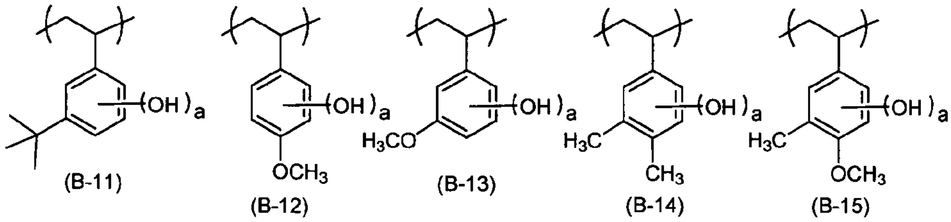
(B-11) (B-12) (B-13) (B-14) (B-15)

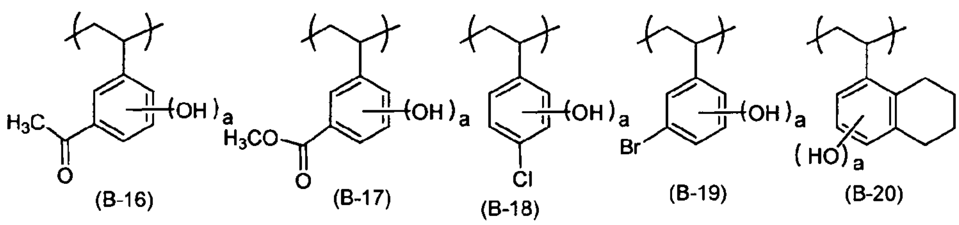
(B-16) (B-17) (B-18) (B-19) (B-20)

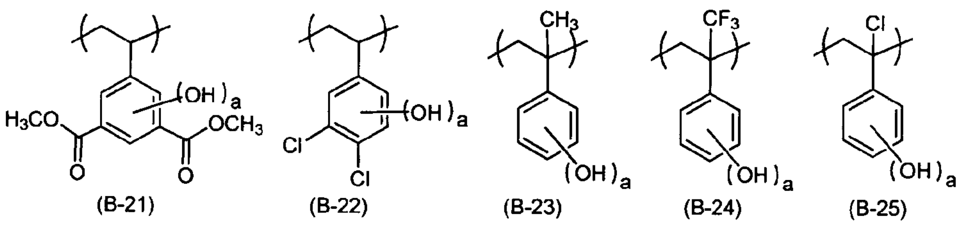
(B-21) (B-22) (B-23) (B-24) (B-25)

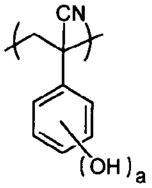

(B-26)

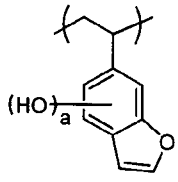

(B-27)

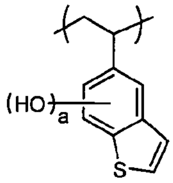

(B-28)

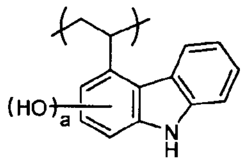

(B-29)

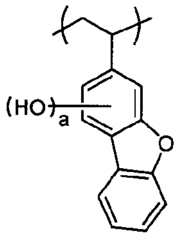

(B-30)

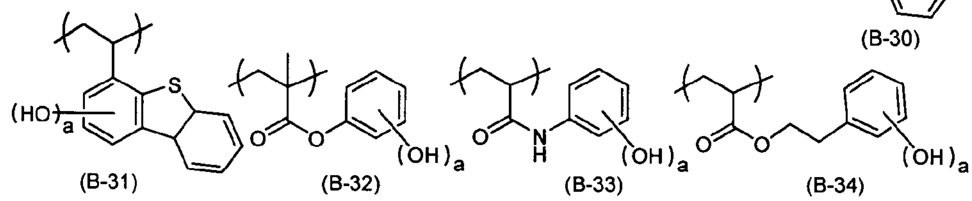

(B-31) (B-32) (B-33) (B-34)

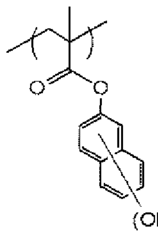

(B-35)

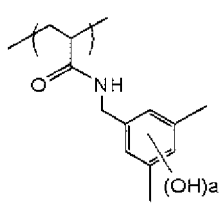

(B-36)

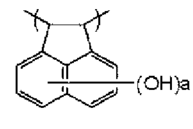

(B-37)

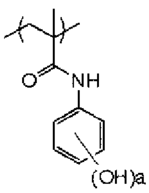

(B-38)

Among the above-described repeating units, repeating units specifically shown below are preferable. In the formulae, R represents a hydrogen atom or a methyl group, and a represents 2 or 3.

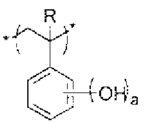

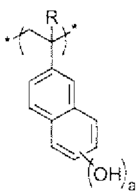

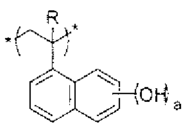

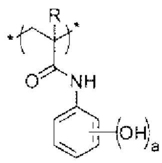

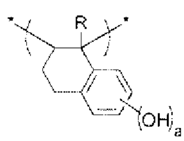

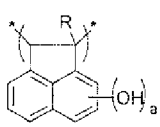

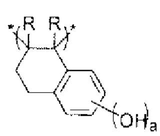

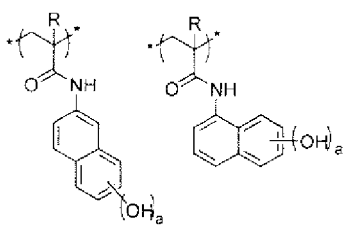

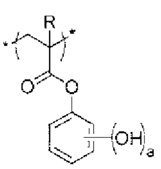

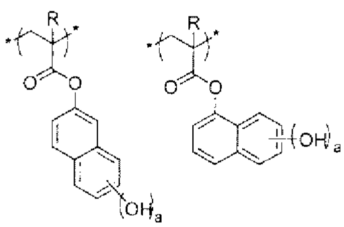

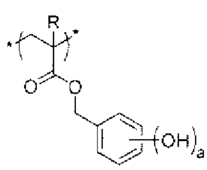

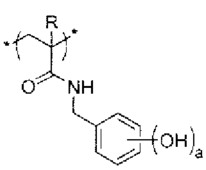

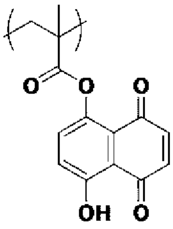 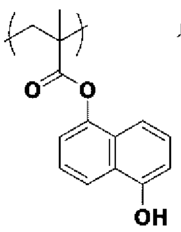 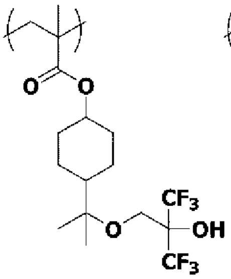 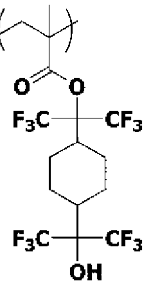 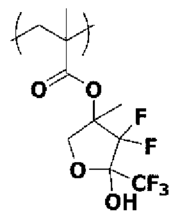 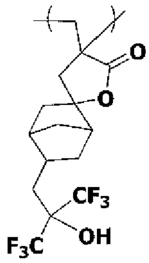

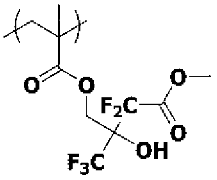 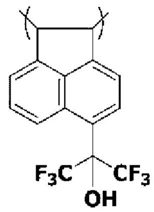 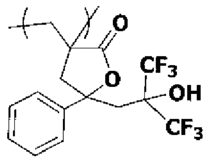 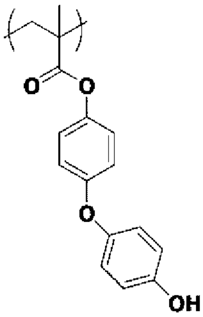 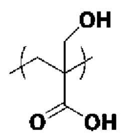 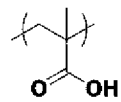

A content of the repeating unit having an acid group is preferably 10% by mole or more, and more preferably 15% by mole or more with respect to all repeating units in the resin (A). In addition, the upper limit value thereof is preferably 70% by mole or less, more preferably 65% by mole or less, and still more preferably 60% by mole or less with respect to all repeating units in the resin (A).

<Repeating Unit having Fluorine Atom, Bromine Atom, or Iodine Atom>

The resin (A) may have a repeating unit having a fluorine atom, a bromine atom, or an iodine atom, in addition to the above-described <repeating unit having an acid-decomposable group> and <repeating unit having an acid group>. In addition, it is preferable that the <repeating unit having a fluorine atom, a bromine atom, or an iodine atom> herein is different from other types of the repeating units belonging to the group A, such as <repeating unit having a lactone group, a sultone group, or a carbonate group> and <repeating unit having a photoacid generating group> described later.

As the repeating unit having a fluorine atom, a bromine atom, or an iodine atom, a repeating unit represented by Formula (C) is preferable.

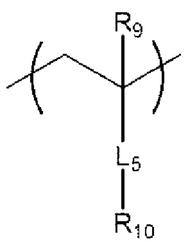 (C)

$L_5$ represents a single bond or an ester group.

$R_9$ represents a hydrogen atom or an alkyl group which may have a fluorine atom, a bromine atom, or an iodine atom.

$R_{10}$ represents a hydrogen atom, an alkyl group which may have a fluorine atom, a bromine atom, or an iodine atom, a cycloalkyl group which may have a fluorine atom, a bromine atom, or an iodine atom, an aryl group which may have a fluorine atom, a bromine atom, or an iodine atom, or a group formed by a combination thereof.

The repeating unit having a fluorine atom, a bromine atom, or an iodine atom is exemplified below.

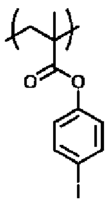 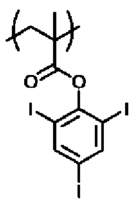 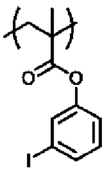 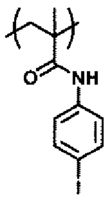 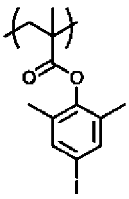 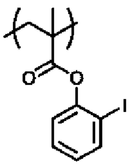 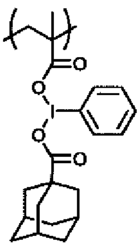 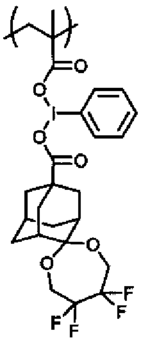 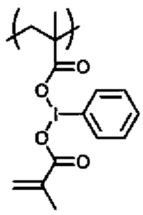

A content of the repeating unit having a fluorine atom, a bromine atom, or an iodine atom is preferably 0% by mole or more, more preferably 5% by mole or more, and still more preferably 10% by mole or more with respect to all repeating units in the resin (A). In addition, the upper limit value thereof is preferably 50% by mole or less, more preferably 45% by mole or less, and still more preferably 40% by mole or less with respect to all repeating units in the resin (A).

As described above, since the repeating unit having a fluorine atom, a bromine atom, or an iodine atom does not include the <repeating unit having an acid-decomposable group> and <repeating unit having an acid group>, the content of the repeating unit having a fluorine atom, a bromine atom, or an iodine atom is also intended to a content of the repeating unit having a fluorine atom, a bromine atom, or an iodine atom excluding the <repeating unit having an acid-decomposable group> and <repeating unit having an acid group>.

The total content of the repeating unit including at least any one of a fluorine atom, a bromine atom, or an iodine atom in the repeating units of the resin (A) is preferably 10% by mole or more, more preferably 20% by mole or more, still more preferably 30% by mole or more, and particularly preferably 40% by mole or more with respect to all repeating units of the resin (A). The upper limit value thereof is not particularly limited, and is, for example, 100% by mole or less with respect to all repeating units of the resin (A).

Examples of the repeating unit including at least any one of a fluorine atom, a bromine atom, or an iodine atom include a repeating unit having a fluorine atom, a bromine atom, or an iodine atom and having an acid-decomposable group, a repeating unit having a fluorine atom, a bromine atom, or an iodine atom and having an acid group, and a repeating unit having a fluorine atom, a bromine atom, or an iodine atom.

(Repeating Unit having At Least One Group selected from Lactone Group, Sultone Group, Carbonate Group, Hydroxyl Group, Cyano Group, or Alkali-soluble Group)

The resin (A) may have a repeating unit having at least one group selected from a lactone group, a sultone group, a carbonate group, a hydroxyl group, a cyano group, or an alkali-soluble group.

First, a repeating unit having at least one selected from the group consisting of a lactone group, a sultone group, and a carbonate group (hereinafter also collectively referred to as "repeating unit having a lactone group, a sultone group, or a carbonate group") will be described.

It is also preferable that the repeating unit having a lactone group, a sultone group, or a carbonate group has no hydroxyl group and acid group such as a hexafluoropropanol group.

The lactone group or the sultone group may have a lactone structure or a sultone structure. The lactone structure or the sultone structure is preferably a 5- to 7-membered ring lactone structure or a 5- to 7-membered ring sultone structure. Among these, the structure is more preferably a 5- to 7-membered ring lactone structure with which another ring structure is fused so as to form a bicyclo structure or a spiro structure or a 5- to 7-membered ring sultone structure with which another ring structure is fused so as to form a bicyclo structure or a spiro structure.

The resin (A) preferably has a repeating unit having a lactone group or a sultone group, formed by extracting one or more hydrogen atoms from a ring member atom of a lactone structure represented by any of Formulae (LC1-1) to (LC1-21) or a sultone structure represented by any of Formulae (SL1-1) to (SL1-3).

In addition, the lactone group or the sultone group may be bonded directly to the main chain. For example, a ring member atom of the lactone group or the sultone group may constitute the main chain of the resin (A).

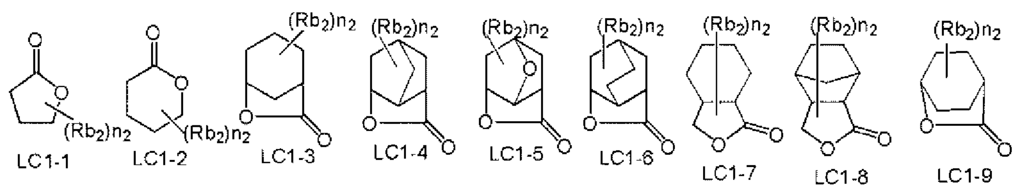

LC1-1 LC1-2 LC1-3 LC1-4 LC1-5 LC1-6 LC1-7 LC1-8 LC1-9

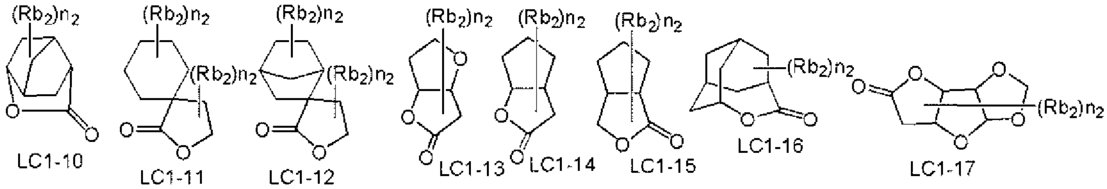

LC1-10 LC1-11 LC1-12 LC1-13 LC1-14 LC1-15 LC1-16 LC1-17

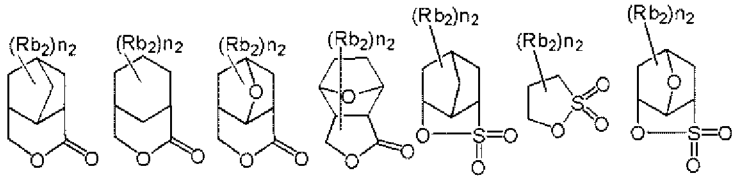

LC1-18 LC1-19 LC1-20 LC1-21 SL1-1 SL1-2 SL1-3

The above-described portion of lactone structure or sultone structure may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxy group, a halogen atom, a cyano group, and an acid-decomposable group. n2 represents an integer of 0 to 4. In a case where n2 is 2 or more, a plurality of $Rb_2$'s may be different from each other, and the plurality of $Rb_2$'s may be bonded to each other to form a ring.

Examples of the repeating unit having a group including the lactone structure represented by any of Formulae (LC1-1) to (LC1-21) or the sultone structure represented by any of Formulae (SL1-1) to (SL1-3) include a repeating unit represented by Formula (AI).

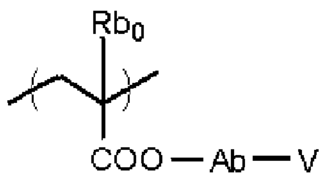

(AI)

In Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxy group, or a divalent group formed by a combination thereof. Among these, a single bond or a linking group represented by $-Ab_1-CO_2-$ is preferable. $Ab_1$ is a linear or branched alkylene group, or a monocyclic or polycyclic cycloalkylene group, and is preferably a methylene group, an ethylene group, a cyclohexylene group, an adamantylene group, or a norbomylene group.

V represents a group formed by extracting one hydrogen atom from a ring member atom of the lactone structure represented by any of Formulae (LC1-1) to (LC1-21) or a group formed by extracting one hydrogen atom from a ring member atom of the sultone structure represented by any of Formulae (SL1-1) to (SL1-3).

In a case where an optical isomer is present in the repeating unit having a lactone group or a sultone group, any of optical isomers may be used. In addition, one optical isomer may be used alone or a mixture of a plurality of the optical isomers may be used. In a case where one kind of optical isomers is mainly used, an optical purity (ee) thereof is preferably 90 or more, and more preferably 95 or more.

As the carbonate group, a cyclic carbonate ester group is preferable.

As the repeating unit having a cyclic carbonate ester group, a repeating unit represented by Formula (A-1) is preferable.

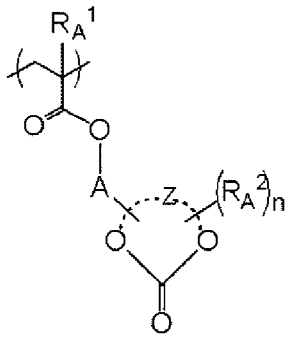

(A-1)

In Formula (A-1), $R_A^1$ represents a hydrogen atom, a halogen atom, or a monovalent organic group (preferably a methyl group).

n represents an integer of 0 or more.

$R_A^2$ represents a substituent. In a case where n is 2 or more, a plurality of $R_A^2$'s may be the same or different from each other.

A represents a single bond or a divalent linking group. As the above-described divalent linking group, an alkylene group, a divalent linking group having a monocyclic or polycyclic alicyclic hydrocarbon structure, an ether group, an ester group, a carbonyl group, a carboxy group, or a divalent group formed by a combination thereof is preferable.

Z represents an atomic group which forms a monocycle or polycycle with a group represented by -O-CO-O- in the formula.

The repeating unit having a lactone group, a sultone group, or a carbonate group is exemplified below.

(in the formulae, Rx is H, $CH_3$, $CH_2OH$, or $CF_3$)

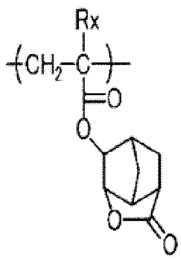 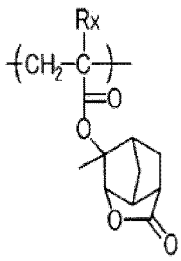 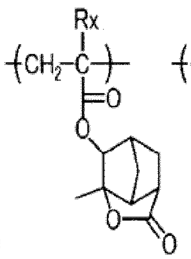 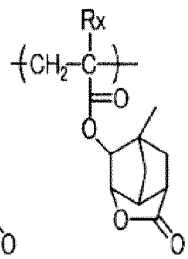

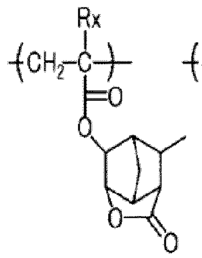 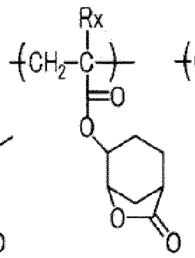 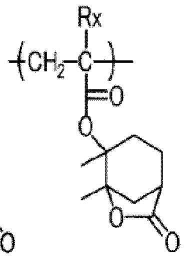 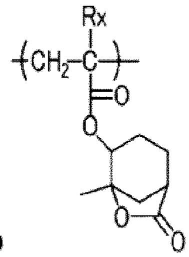

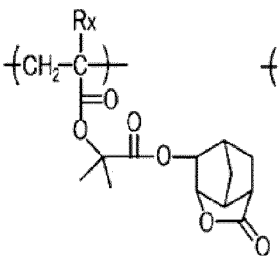 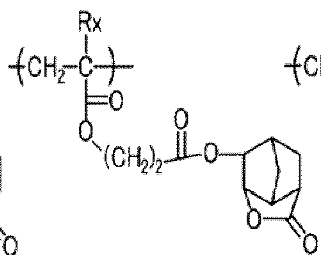 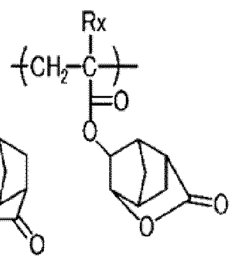 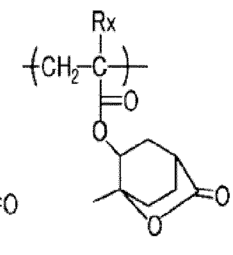

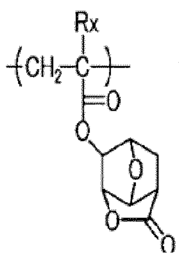
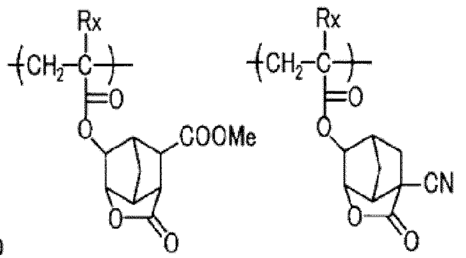
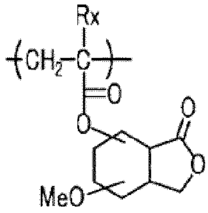

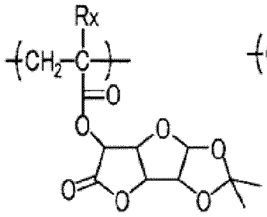
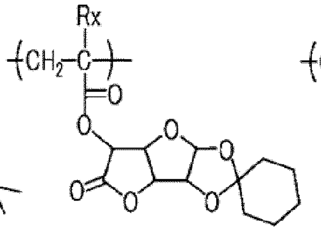
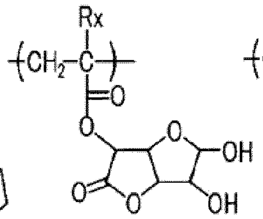
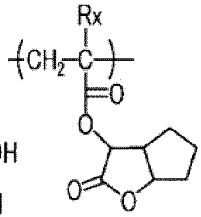

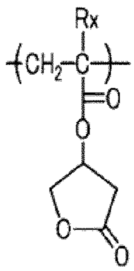
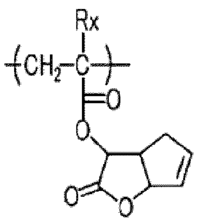
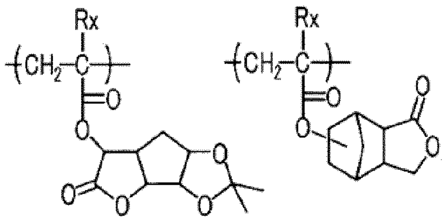
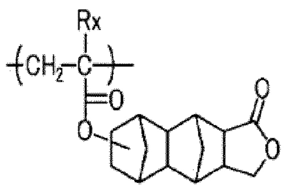

(in the formulae, Rx is H, $CH_3$, $CH_2OH$, or $CF_3$)

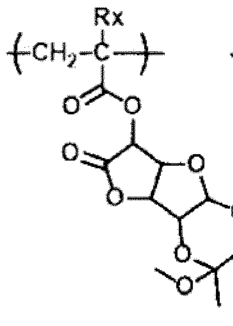
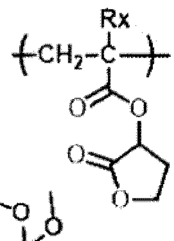
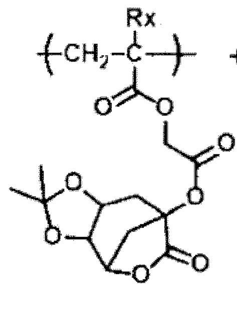
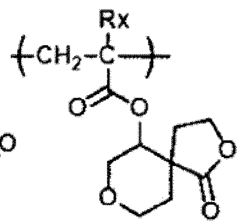

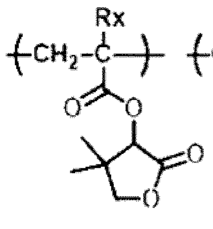
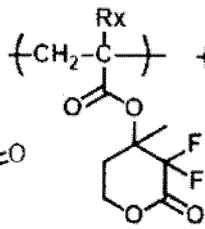
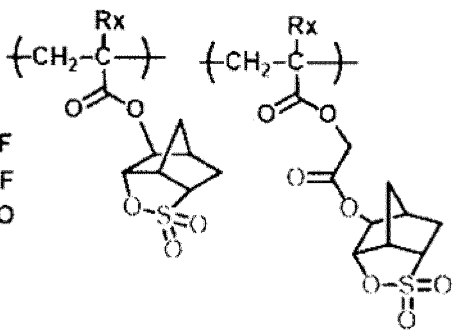
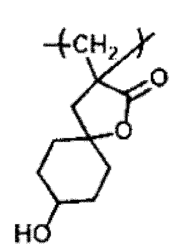

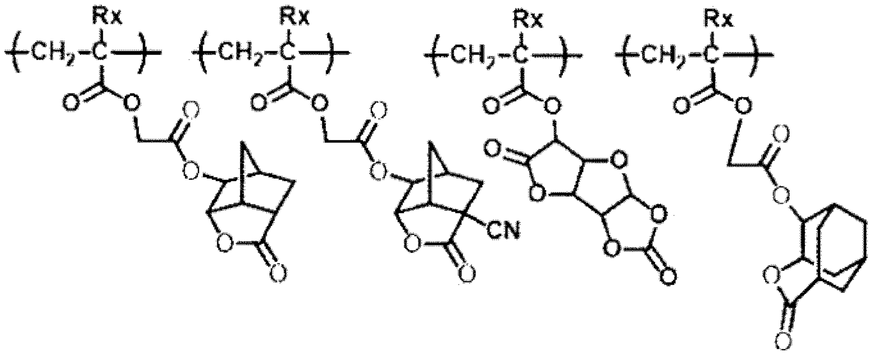

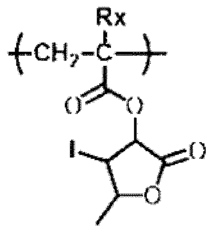

(in the formulae, Rx is H, $CR_3$, $CH_2OH$, or $CF_3$)

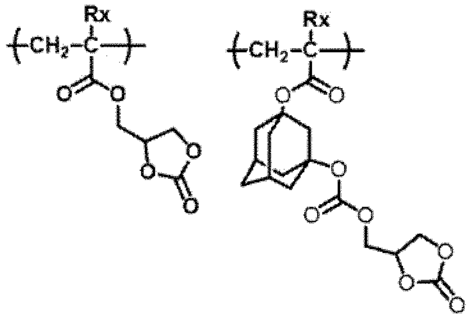

Next, the repeating unit having a hydroxyl group or a cyano group will be described.

The resin (A) may have a repeating unit having a hydroxyl group or a cyano group. As a result, adhesiveness to the substrate and affinity for a developer are improved.

The repeating unit having a hydroxyl group or a cyano group is preferably a repeating unit having an alicyclic hydrocarbon structure substituted with a hydroxyl group or a cyano group.

It is preferable that the repeating unit having a hydroxyl group or a cyano group does not have the acid-decomposable group. Examples of the repeating unit having a hydroxyl group or a cyano group include repeating units described in paragraphs [0081] to [0084] of JP2014-98921A.

Next, the repeating unit having an alkali-soluble group will be described.

The resin (A) may have a repeating unit having an alkali-soluble group.

Examples of the alkali-soluble group include a carboxy group, a sulfonamide group, a sulfonylimide group, a bissulfonylimide group, and an aliphatic alcohol (for example, a hexafluoroisopropanol group) in which the $\alpha$-position is substituted with an electron withdrawing group, and a carboxy group is preferable. In a case where the resin (A) includes the repeating unit having an alkali-soluble group, resolution for use in contact holes is increased. Examples of the repeating unit having an alkali-soluble group include repeating units described in paragraphs [0085] and [0086] of JP2014-98921A.

A content of the repeating unit having at least one group selected from a lactone group, a sultone group, a carbonate group, a hydroxyl group, a cyano group, or an alkali-soluble group is preferably 1% by mole or more, and more preferably 10% by mole or more with respect to all repeating units in the resin (A). In addition, the upper limit value thereof is preferably 85% by mole or less, more preferably 80% by mole or less, still more preferably 70% by mole or less, and particularly preferably 60% by mole or less with respect to all repeating units in the resin (A).

<Repeating Unit having Photoacid Generating Group>

The resin (A) may have, as a repeating unit other than those described above, a repeating unit having a group which generates an acid by irradiation with actinic ray or radiation (hereinafter, also referred to as a "photoacid generating group").

In this case, the repeating unit having a photoacid generating group can be considered to the above-described photoacid generator (B).

Examples of such a repeating unit include a repeating unit represented by Formula (4).

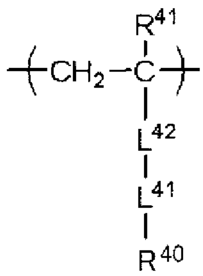

(4)

$R^{41}$ represents a hydrogen atom or a methyl group. $L^{41}$ represents a single bond or a divalent linking group. $L^{42}$ represents a divalent linking group. $R^{40}$ represents a structural moiety which is decomposed by irradiation with actinic ray or radiation to generate an acid in a side chain.

The repeating unit having a photoacid generating group is exemplified below.

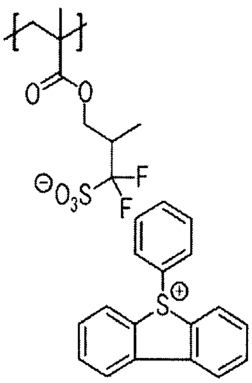

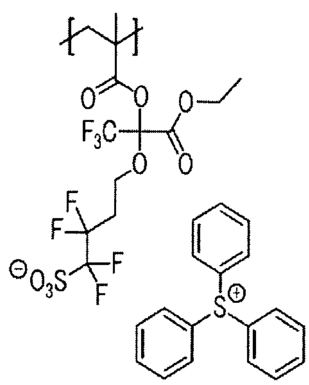

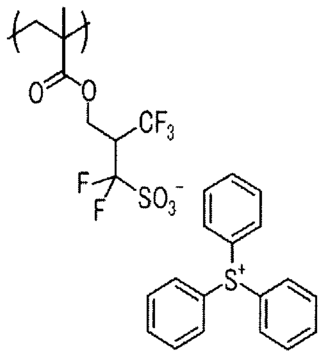

In addition, examples of the repeating unit represented by Formula (4) include repeating units described in paragraphs [0094] to [0105] of JP2014-041327A and repeating units described in paragraphs [0094] of WO2018/193954A.

A content of the repeating unit having a photoacid generating group is preferably 1% by mole or more, and more preferably 5% by mole or more with respect to all repeating units in the resin (A). In addition, the upper limit value thereof is preferably 40% by mole or less, more preferably 35% by mole or less, and still more preferably 30% by mole or less with respect to all repeating units in the resin (A).

<Repeating Unit represented by Formula (V-1) or Formula (V-2)>

The resin (A) may have a repeating unit represented by Formula (V-1) or Formula (V-2).

The repeating unit represented by Formula (V-1) and Formula (V-2) is preferably a repeating unit different from the above-described repeating units.

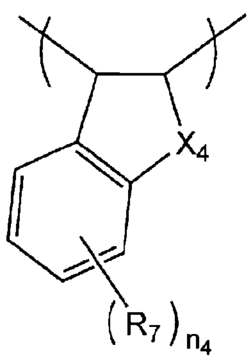

(V-1)

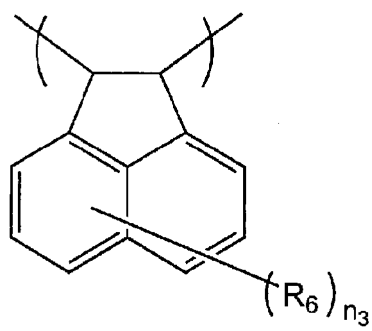

(V-2)

In the formulae,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR; R is an alkyl group or fluorinated alkyl group having 1 to 6 carbon atoms), or a carboxy group. As the alkyl group, a linear, branched, or cyclic alkyl group having 1 to 10 carbon atoms is preferable.
$n_3$ represents an integer of 0 to 6.
$n_4$ represents an integer of 0 to 4.
$X_4$ is a methylene group, an oxygen atom, or a sulfur atom.

The repeating unit represented by Formula (V-1) or (V-2) is exemplified below.
Examples of the repeating unit represented by Formula (V-1) or (V-2) include repeating units described in paragraph [0100] of WO2018/193954A.

<Repeating Unit for Reducing Mobility of Main Chain>

From the viewpoint that excessive diffusion of a generated acid or pattern collapse during development can be suppressed, the resin (A) preferably has a high glass transition temperature (Tg). The Tg is preferably higher than 90°C, more preferably higher than 100°C, still more preferably higher than 110°C, and particularly preferably higher than 125°C. Since an excessively high Tg causes a decrease in dissolution rate in a developer, the Tg is preferably 400°C or lower and more preferably 350°C or lower.
In the present specification, the glass transition temperature (Tg) of a polymer such as the resin (A) (hereinafter, "Tg of the repeating unit") is calculated by the following method. First, each Tg of homopolymers consisting of only the respective repeating units included in the polymer is calculated by the Bicerano method. Next, the mass proportion (%) of each repeating unit to all repeating units in the polymer is calculated. Next, the Tg at each mass proportion is calculated using a Fox's equation (described in Materials Letters 62 (2008) 3152, and the like), and these are summed to obtain the Tg (°C) of the polymer.
The Bicerano method is described in Prediction of polymer properties, Marcel Dekker Inc., New York (1993). In addition, the calculation of a Tg by the Bicerano method can be carried out using MDL Polymer (MDL Information Systems, Inc.), which is software for estimating physical properties of a polymer.
In order to raise the Tg of the resin (A) (preferably to raise the Tg to higher than 90°C), it is preferable to reduce the mobility of the main chain of the resin (A). Examples of a method for lowering the mobility of the main chain of the resin (A) include the following (a) to (e) methods.

(a) introduction of a bulky substituent into the main chain
(b) introduction of a plurality of substituents into the main chain
(c) introduction of a substituent causing an interaction between the resins (A) into the vicinity of the main chain
(d) formation of the main chain in a cyclic structure
(e) linking of a cyclic structure to the main chain

The resin (A) preferably has a repeating unit in which the homopolymer exhibits a Tg of 130°C or higher.
The type of the repeating unit in which the homopolymer exhibits a Tg of 130°C or higher is not particularly limited, and may be any of repeating units in which the homopolymer exhibits a Tg of 130°C or higher, as calculated by a Bicerano method. It corresponds to a repeating unit having a Tg of a homopolymer exhibiting 130°C or higher, depending on the type of a functional group in the repeating units represented by Formulae (A) to (E), which will be described later.

(Repeating Unit Represented by Formula (A))

As an example of a specific unit for accomplishing (a) above, a method of introducing a repeating unit represented by Formula (A) into the resin (A) may be mentioned.

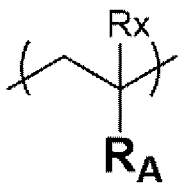

(A)

In Formula (A), $R_A$ represents a group including a polycyclic structure. $R_x$ represents a hydrogen atom, a methyl group, or an ethyl group. The group including a polycyclic structure is a group including a plurality of ring structures, and the plurality of ring structures may or may not be fused.

Specific examples of the repeating unit represented by Formula (A) include repeating units described in paragraphs [0107] to [0119] of WO2018/193954A.

(Repeating Unit Represented by Formula (B))

As an example of a specific unit for accomplishing (b) above, a method of introducing a repeating unit represented by Formula (B) into the resin (A) may be mentioned.

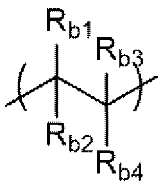 (B)

In Formula (B), $R_{b1}$ to $R_{b4}$ each independently represent a hydrogen atom or an organic group, and at least two or more of $R_{b1}$, ... , or $R_{b4}$ represent an organic group.

In addition, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more constituent atoms excluding hydrogen atoms.

Specific examples of the repeating unit represented by Formula (B) include repeating units described in paragraphs [0113] to [0115] of WO2018/193954A.

(Repeating Unit Represented by Formula (C))

As an example of a specific unit for accomplishing (c) above, a method of introducing a repeating unit represented by Formula (C) into the resin (A) may be mentioned.

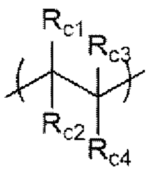 (C)

In Formula (C), $R_{c1}$ to $R_{c4}$ each independently represent a hydrogen atom or an organic group, and at least one of $R_{c1}$, ... , or $R_{c4}$ is a group including a hydrogen-bonding hydrogen atom with the number of atoms of 3 or less from the main chain carbon. Among these, it is preferable that the group has hydrogen-bonding hydrogen atoms with the number of atoms of 2 or less (on a side closer to the vicinity of the main chain) to cause an interaction between the main chains of the resin (A).

Specific examples of the repeating unit represented by Formula (C) include repeating units described in paragraphs [0119] to [0121] of WO2018/193954A.

(Repeating Unit Represented by Formula (D))

As an example of a specific unit for accomplishing (d) above, a method of introducing a repeating unit represented by Formula (D) into the resin (A) may be mentioned.

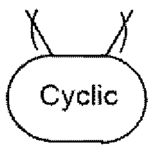 (D)

In Formula (D), "cylic" is a group which forms a main chain as a cyclic structure. The number of ring-constituting atoms is not particularly limited.

Specific examples of the repeating unit represented by Formula (D) include repeating units described in paragraphs [0126] and [0127] of WO2018/193954A.

(Repeating Unit Represented by Formula (E))

As an example of a specific unit for accomplishing (e) above, a method of introducing a repeating unit represented by Formula (E) into the resin (A) may be mentioned.

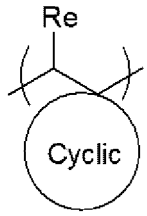

(E)

In Formula (E), Re's each independently represent a hydrogen atom or an organic group. Examples of the organic group include an alkyl group, a cycloalkyl group, an aryl group, an aralkyl group, and an alkenyl group, which may have a substituent.

"cylic" is a cyclic group including a carbon atom of a main chain. The number of atoms included in the cyclic group is not particularly limited.

Specific examples of the repeating unit represented by Formula (E) include repeating units described in paragraphs [0131] to [0133] of WO2018/193954A.

(Repeating Unit having Alicyclic Hydrocarbon Structure and Not Exhibiting Acid Decomposability)

The resin (A) may have a repeating unit having an alicyclic hydrocarbon structure and not exhibiting acid decomposability. As a result, it is possible to reduce elution of low-molecular-weight components from the resist film into the immersion liquid during liquid immersion exposure. Examples of such a repeating unit include a repeating unit derived from 1-adamantyl (meth)acrylate, diamantyl (meth)acrylate, tricyclodecanyl (meth)acrylate, or cyclohexyl (meth)acrylate.

(Repeating Unit Represented by Formula (III) having Neither Hydroxyl Group Nor Cyano Group)

The resin (A) may have a repeating unit represented by Formula (III), which has neither a hydroxyl group nor a cyano group.

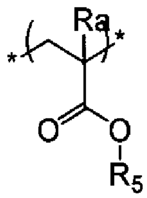

(III)

In Formula (III), $R_5$ represents a hydrocarbon group having at least one cyclic structure and having neither a hydroxyl group nor a cyano group.

Ra represents a hydrogen atom, an alkyl group, or a $-CH_2-O-Ra_2$ group. In the formula, $Ra_2$ represents a hydrogen atom, an alkyl group, or an acyl group.

Examples of the repeating unit represented by Formula (III), which has neither a hydroxyl group nor a cyano group, include repeating units described in paragraphs [0087] to [0094] of JP2014-98921A.

<Other Repeating Units>

Furthermore, the resin (A) may have a repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring

group, and a repeating unit having a hydantoin ring group.

Such repeating units are exemplified below.

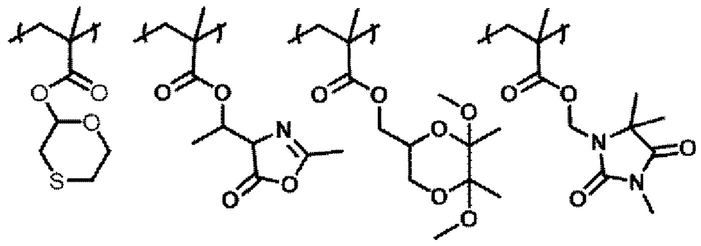

For the purpose of controlling dry etching resistance, suitability for a standard developer, substrate adhesiveness, resist profile, resolution, heat resistance, sensitivity, and the like, the resin (A) may have various repeating structural units in addition to the repeating structural units described above.

As the resin (A), (in particular, in a case where the composition is used as an actinic ray-sensitive or radiation-sensitive resin composition with ArF), it is preferable that all repeating units are composed of repeating units derived from a compound having an ethylenically unsaturated bond. In particular, it is also preferable that all repeating units are composed of (meth)acrylate-based repeating units. In this case, any resin of a resin in which all repeating units are methacrylate-based repeating units, a resin in which all repeating units are acrylate-based repeating units, or a resin with all repeating units consisting of a methacrylate-based repeating unit and an acrylate-based repeating unit can be used. In addition, the acrylate-based repeating unit is preferably 50% by mole or less of all repeating units.

The resin (A) can be synthesized in accordance with an ordinary method (for example, a radical polymerization).

A weight-average molecular weight of the resin (A) as a value expressed in terms of polystyrene by a GPC method is preferably 30,000 or less, preferably 1,000 to 30,000, more preferably 3,000 to 30,000, and still more preferably 5,000 to 15,000.

A dispersity (molecular weight distribution) of the resin (A) is usually 1 to 5, preferably 1 to 3, more preferably 1.2 to 3.0, and still more preferably 1.2 to 2.0. As the dispersity is smaller, resolution and resist shape are more excellent, and a side wall of a resist pattern is smoother and roughness is also more excellent.

In the resist composition, a content of the resin (A) is preferably 40.0% to 99.9% by mass, and more preferably 60.0% to 90.0% by mass with respect to the total solid content of the composition.

The resin (A) may be used alone or in combination of two or more kinds thereof.

[Solvent (F)]

The resist composition preferably contains a solvent (preferably, an organic solvent).

The solvent preferably includes at least one solvent of (M1) propylene glycol monoalkyl ether carboxylate or (M2) at least one selected from the group consisting of propylene glycol monoalkyl ether, lactic acid ester, acetic acid ester, alkoxypropionic acid ester, chain ketone, cyclic ketone, lactone, and alkylene carbonate. The above-described solvent may further include a component other than the components (M1) and (M2).

Details of the component (M1) and the component (M2) are described in paragraphs [0218] to [0226] of WO2020/004306A, the contents of which are incorporated herein by reference.

In a case where the solvent further contains a component other than the components (M1) and (M2), a content of the component other than the components (M1) and (M2) is preferably 5% to 30% by mass with respect to the total amount of the solvent.

A content of the solvent in the resist composition is preferably set such that the concentration of solid contents is 0.5% to 30% by mass, and more preferably set such that the concentration of solid contents is 1% to 20% by mass. With this content, the coating property of the resist composition can be further improved.

The solid content means all components excluding the solvent.

[Compound (B) which Generates Acid by Irradiation with Actinic Ray or Radiation (Photoacid Generator)]

The resist composition preferably contains a compound (B) (photoacid generator) which generates an acid by irradiation with actinic ray or radiation.

The compound (B) may be in a form of a low-molecular-weight compound or a form incorporated into a part of a polymer (for example, the above-described resin (A)). In addition, a combination of the form of a low-molecular-weight compound and the form incorporated into a part of a polymer (for example, the resin (A)) may also be used.

In a case where the compound (B) is in the form of a low-molecular-weight compound, a molecular weight of

the compound (B) is preferably 3,000 or less, more preferably 2,000 or less, and still more preferably 1,000 or less. The upper limit thereof is not particularly limited, and is preferably 100 or more.

In a case where the compound (B) is in the form incorporated into a part of a polymer, it may be incorporated into the part of the resin (A) or into a resin which is different from the resin (A).

The compound (B) is preferably a low-molecular-weight compound.

Examples of the compound (B) include a compound represented by "$M^+ X^-$" (onium salt), and a compound which generates an organic acid by exposure is preferable.

Examples of the above-described organic acid include sulfonic acids (an aliphatic sulfonic acid, an aromatic sulfonic acid, a camphor sulfonic acid, and the like), carboxylic acids (an aliphatic carboxylic acid, an aromatic carboxylic acid, an aralkylcarboxylic acid, and the like), a carbonylsulfonylimide acid, a bis(alkylsulfonyl)imide acid, and a tris(alkylsulfonyl)methide acid.

A molecular weight of the generated acid of the compound (B) is preferably 240 or more, more preferably 250 or more, still more preferably 260 or more, particularly preferably 270 or more, and most preferably 280 or more.

<Organic Cation>

In the compound represented by "$M^+ X^-$", $M^+$ represents an organic cation.

A structure of the above-described organic cation is not particularly limited. In addition, a valence of the organic cation may be 1 or 2 or more.

As the above-described organic cation, a cation represented by General Formula (ZaI) (hereinafter, also referred to as "cation (ZaI)") or a cation represented by General Formula (ZaII) (hereinafter, also referred to as "cation (ZaII)") is preferable.

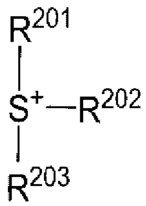

(ZaI)

$R^{204}$-$I^+$-$R^{205}$ (ZaII)

In General Formula (ZaI), $R^{201}$, $R^{202}$, and $R^{203}$ each independently represent an organic group.

In General Formula (ZaII), $R^{204}$ and $R^{205}$ each independently represent an organic group.

General Formulae (ZaI) and (ZaII) are described in detail below, but it is preferable that at least one of $R^{201}$, $R^{202}$, or $R^{203}$ in General Formula (ZaI) is an aryl group, or at least one of $R^{204}$ or $R^{205}$ in General Formula (ZaII) is an aryl group. The above-described aryl group may have a substituent, and the substituent is preferably a halogen atom (preferably a fluorine atom or an iodine atom) or an organic group.

In addition, it is also preferable that at least one of $R^{201}$, $R^{202}$, or $R^{203}$ in General Formula (ZaI) has an acid-decomposable group, or at least one of $R^{204}$ or $R^{205}$ in General Formula (ZaII) has an acid-decomposable group. The acid-decomposable group is the same as that in the resin (A). As the aspect in which at least one of $R^{201}$, $R^{202}$, or $R^{203}$ in General Formula (ZaI) has an acid-decomposable group, it is preferable that at least one of $R^{201}$, $R^{202}$, or $R^{203}$ is an aryl group substituted with an organic group including an acid-decomposable group. As the aspect in which at least one of $R^{204}$ or $R^{205}$ in General Formula (ZaII) has an acid-decomposable group, it is preferable that at least one of $R^{204}$ or $R^{205}$ is an aryl group substituted with an organic group including an acid-decomposable group.

The cation (ZaI) will be described.

The number of carbon atoms in the organic group of $R^{201}$, $R^{202}$, and $R^{203}$ is usually 1 to 30, and preferably 1 to 20. In addition, two of $R^{201}$ to $R^{203}$ may be bonded to each other to form a ring structure, and the ring structure may include an oxygen atom, a sulfur atom, an ester group, an amide group, or a carbonyl group in the ring. Examples of the group formed by the bonding of two of $R^{201}$ to $R^{203}$ include an alkylene group (for example, a butylene group and a pentylene group) and $-CH_2-CH_2-O-CH_2-CH_2-$.

Examples of suitable aspects of the organic cation in Formula (ZaI) include a cation (ZaI-1), a cation (ZaI-2), an organic cation (cation (ZaI-3b)) represented by Formula (ZaI-3b), and an organic cation (cation (ZaI-4b)) represented by Formula (ZaI-4b), each of which will be described later.

First, the cation (ZaI-1) will be described.

The cation (ZaI-1) is an arylsulfonium cation in which at least one of $R^{201}$, $R^{202}$, or $R^{203}$ of Formula (ZaI) described above is an aryl group.

In the arylsulfonium cation, all of $R_{201}$ to $R_{203}$ may be aryl groups, or some of $R_{201}$ to $R_{203}$ may be an aryl group and the rest may be an alkyl group or a cycloalkyl group.

In addition, one of $R_{201}$ to $R_{203}$ may be an aryl group, the remaining two of $R^{201}$ to $R^{203}$ may be bonded to each other to form a ring structure, and an oxygen atom, a sulfur atom, an ester group, an amide group, or a carbonyl group may be included in the ring. Examples of the group formed by the bonding of two of $R^{201}$ to $R^{203}$ include an alkylene group (for example, a butylene group, a pentylene group, and $-CH_2-CH_2-O-CH_2-CH_2-$) in which one or more methylene groups may be substituted with an oxygen atom, a sulfur atom, an ester group, an amide group, and/or a carbonyl group.

Examples of the arylsulfonium cation include a triarylsulfonium cation, a diarylalkylsulfonium cation, an aryldialkylsulfonium cation, a diarylcycloalkylsulfonium cation, and an aryldicycloalkylsulfonium cation.

The aryl group included in the arylsulfonium cation is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium cation has two or more aryl groups, the two or more aryl groups may be the same or different from each other.

The alkyl group or the cycloalkyl group included in the arylsulfonium cation as necessary is preferably a linear alkyl group having 1 to 15 carbon atoms, a branched alkyl group having 3 to 15 carbon atoms, or a cycloalkyl group having 3 to 15 carbon atoms, and more preferably a methyl group, an ethyl group, a propyl group, an n-butyl group, a sec-butyl group, a t-butyl group, a cyclopropyl group, a cyclobutyl group, or a cyclohexyl group.

The substituents which may be contained in the aryl group, alkyl group, and cycloalkyl group of $R^{201}$ to $R^{203}$ are each independently preferably an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkyl alkoxy group (for example, having 1 to 15 carbon atoms), a halogen atom (for example, fluorine and iodine), a hydroxyl group, a carboxy group, an ester group, a sulfinyl group, a sulfonyl group, an alkylthio group, or a phenylthio group.

The substituent may further have a substituent if possible, and it is also preferable that the above-described alkyl group has a halogen atom as the substituent to form an alkyl halide group such as a trifluoromethyl group.

In addition, it is also preferable to form an acid-decomposable group by any combination of the above-described substituents.

The acid-decomposable group is intended to a group which is decomposed by action of acid to form a polar group, and preferably has a structure in which a polar group is protected by a leaving group which is eliminated by action of acid. The above-described polar group and leaving group are as described above.

Next, the cation (ZaI-2) will be described.

The cation (ZaI-2) is a cation in which $R^{201}$ to $R^{203}$ in Formula (ZaI) are each independently a cation representing an organic group having no aromatic ring. The aromatic ring also encompasses an aromatic ring including a heteroatom.

The number of carbon atoms in the organic group as $R^{201}$ to $R^{203}$, which has no aromatic ring, is generally 1 to 30, and preferably 1 to 20.

$R^{201}$ to $R^{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

Examples of the alkyl group and cycloalkyl group of $R^{201}$ to $R^{203}$ include a linear alkyl group having 1 to 10 carbon atoms or a branched alkyl group having 3 to 10 carbon atoms (for example, a methyl group, an ethyl group, a propyl group, a butyl group, and a pentyl group), and a cycloalkyl group having 3 to 10 carbon atoms (for example, a cyclopentyl group, a cyclohexyl group, and a norbornyl group).

$R^{201}$ to $R^{203}$ may further be substituted with a halogen atom, an alkoxy group (for example, having 1 to 5 carbon atoms), a hydroxyl group, a cyano group, or a nitro group.

In addition, it is also preferable that the substituents of $R^{201}$ to $R^{203}$ each independently form an acid-decomposable group by any combination of the substituents.

Next, the cation (ZaI-3b) will be described.

The cation (ZaI-3b) is a cation represented by Formula (ZaI-3b).

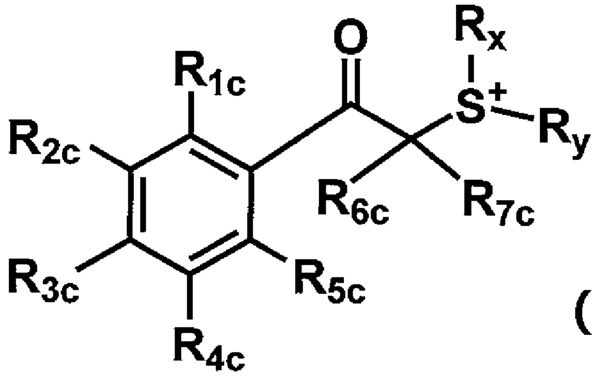

(ZaI-3b)

In General Formula (ZaI-3b),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group,

$R_{6c}$ and $R_{7c}$ each independently represent a hydrogen atom, an alkyl group (for example, a t-butyl group and the like), a cycloalkyl group, a halogen atom, a cyano group, or an aryl group, and

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

In addition, it is also preferable that the substituents of $R_{1c}$ to $R_{7c}$, $R_x$, and $R_y$ each independently form an acid-decomposable group by any combination of the substituents.

Any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ may each be bonded to each other to form a ring, and the rings may each independently include an oxygen atom, a sulfur atom, a ketone group, an ester bond, or an amide bond.

Examples of the above-described ring include an aromatic or non-aromatic hydrocarbon ring, an aromatic or non-aromatic heterocyclic ring, and a polycyclic fused ring formed by a combination of two or more of these rings. Examples of the ring include a 3- to 10-membered ring, and the ring is preferably a 4- to 8-membered ring and more preferably a 5- or 6-membered ring.

Examples of the group formed by the bonding of any two or more of $R_{1c}$, ... , or $R_{5c}$, $R_{6c}$ and $R_{7c}$, and $R_x$ and $R_y$ include an alkylene group such as a butylene group and a pentylene group. A methylene group in this alkylene group may be substituted with a heteroatom such as an oxygen atom.

As the group formed by the bonding of $R_{5c}$ and $R_{6c}$, and $R_{5c}$ and $R_x$, a single bond or an alkylene group is preferable. Examples of the alkylene group include a methylene group and an ethylene group.

The ring formed by bonding $R_{1c}$ to $R_{5c}$, $R_{6c}$, $R_{7c}$, $R_x$, $R_y$, any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ to each other may have a substituent.

Next, the cation (ZaI-4b) will be described.

The cation (ZaI-4b) is a cation represented by Formula (ZaI-4b).

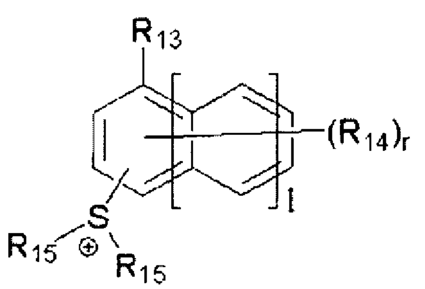

(ZaI-4b)

In Formula (ZaI-4b),

1 represents an integer of 0 to 2.

r represents an integer of 0 to 8.

$R_{13}$ represents a hydrogen atom, a halogen atom (for example, a fluorine atom, an iodine atom, or the like), a hydroxyl group, an alkyl group, an alkyl halide group, an alkoxy group, a carboxy group, an alkoxycarbonyl group, or a group having a cycloalkyl group (which may be the cycloalkyl group itself or a group including the cycloalkyl group in a part thereof). These groups may have a substituent.

$R_{14}$ represents a hydroxyl group, a halogen atom (for example, a fluorine atom, an iodine atom, or the like), an alkyl group, an alkyl halide group, an alkoxy group, an alkoxycarbonyl group, an alkylcarbonyl group, an alkylsulfonyl group, a cycloalkylsulfonyl group, or a group including a cycloalkyl group (which may be the cycloalkyl group itself or a group including the cycloalkyl group in a part thereof). These groups may have a substituent. In a case of a plurality of $R_{14}$'s, $R_{14}$'s each independently represent the above-described group such as a hydroxyl group.

$R_{15}$'s each independently represent an alkyl group, a cycloalkyl group, or a naphthyl group. Two $R_{15}$'s may be bonded to each other to form a ring. In a case where two $R_{15}$'s are bonded to each other to form a ring, the ring skeleton may include a heteroatom such as an oxygen atom and a nitrogen atom. In one aspect, it is preferable that two $R_{15}$'s are alkylene groups and are bonded to each other to form a ring structure. The above-described alkyl group, the above-described cycloalkyl group, the above-descried naphthyl group, and the ring formed by bonding two $R_{15}$'s to each other may have a substituent.

In Formula (ZaI-4b), the alkyl group of $R_{13}$, $R_{14}$, and $R_{15}$ may be linear or branched. The number of carbon atoms in the alkyl group is preferably 1 to 10. The alkyl group is more preferably a methyl group, an ethyl group, an n-butyl group, a t-butyl group, or the like.

In addition, it is also preferable that the substituents of $R_{13}$ to $R_{15}$, $R_x$, and $R_y$ each independently form an acid-decomposable group by any combination of the substituents.

Next, Formula (ZaII) will be described.

In Formula (ZaII), $R^{204}$ and $R^{205}$ each independently represent an organic group, preferably represent an aryl group, an alkyl group, or a cycloalkyl group.

The aryl group of $R^{204}$ and $R^{205}$ is preferably a phenyl group or a naphthyl group, and more preferably a phenyl group. The aryl group of $R^{204}$ and $R^{205}$ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of $R^{204}$ and $R^{205}$ are preferably a linear alkyl group having 1 to 10 carbon atoms or a branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group).

The aryl group, the alkyl group, and the cycloalkyl group of $R^{204}$ and $R^{205}$ may each independently have a substituent. Examples of the substituent which may be included in each of the aryl group, the alkyl group, and the cycloalkyl group of $R^{204}$ and $R^{205}$ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group. In addition, it is also preferable that the substituents of $R^{204}$ and $R^{205}$ each independently form an acid-decomposable group by any combination of the substituents.

Specific examples of the organic cation represented by $M^+$ are shown below, but the present invention is not limited thereto.

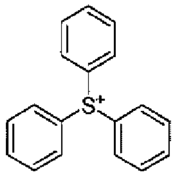
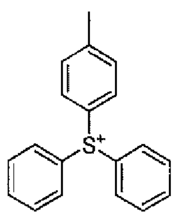
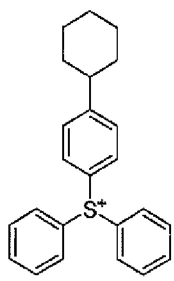
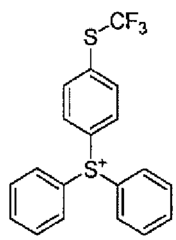

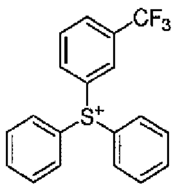
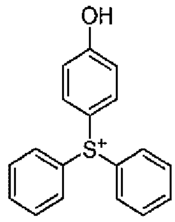
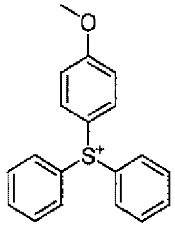
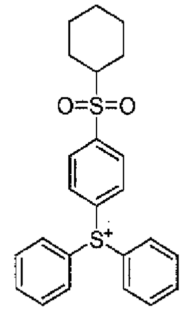

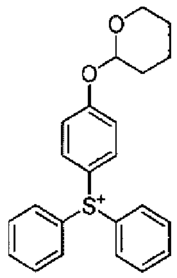
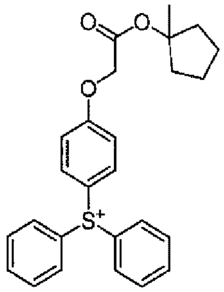
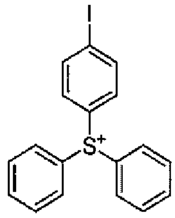
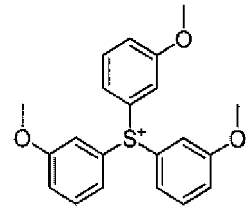

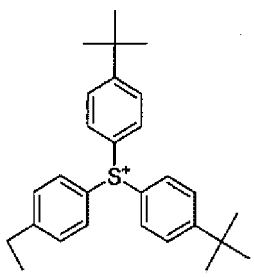
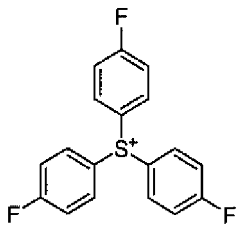
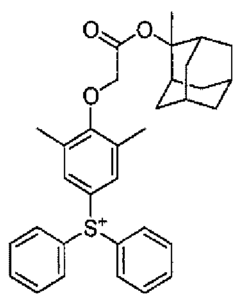
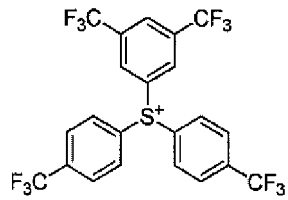

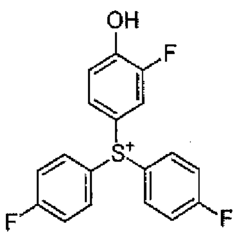
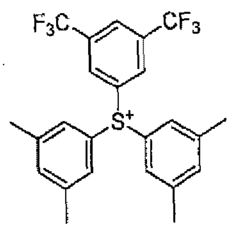
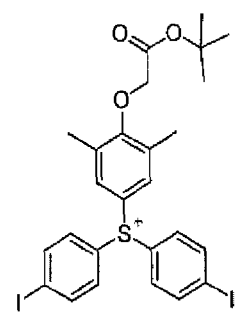
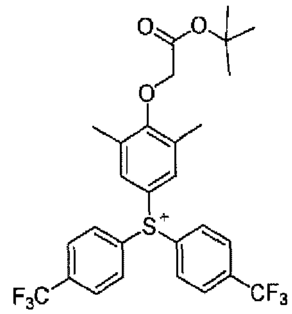

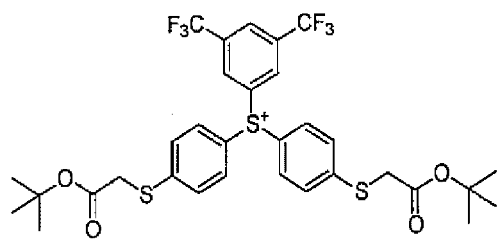
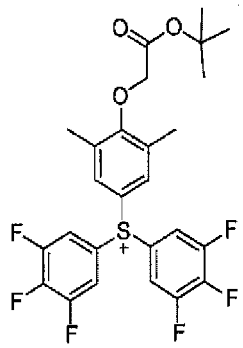
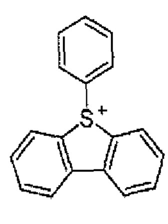

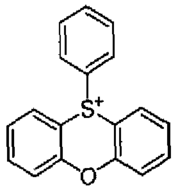
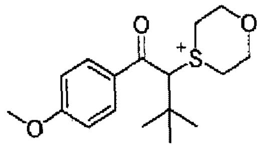
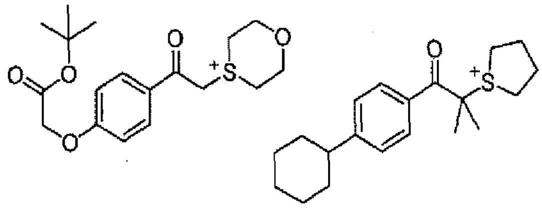

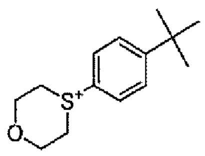
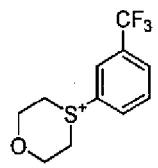
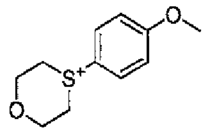
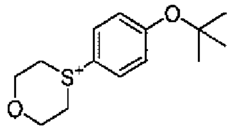

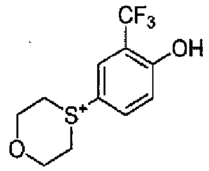
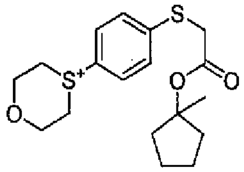
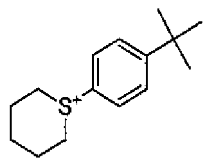
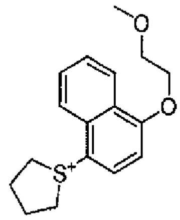

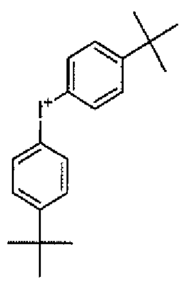
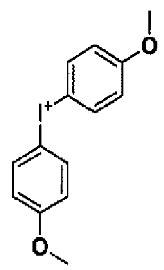
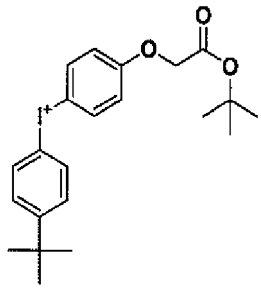

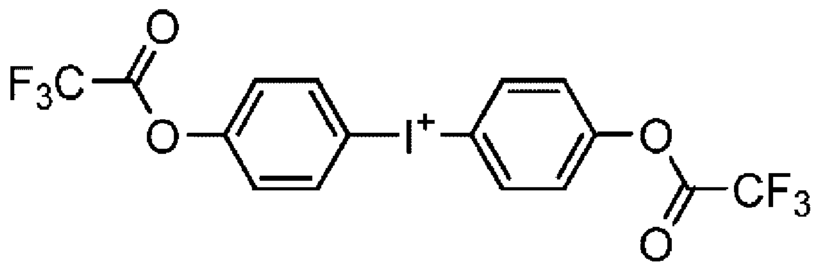

<Organic Anion>

In the compound represented by "$M^+ X^-$", $X^-$ represents an organic anion.

The organic anion is not particularly limited, and examples thereof include a monovalent or di- or higher valent organic anion.

The organic anion is preferably an anion with significantly lower ability to undergo nucleophilic reaction, and more preferably a non-nucleophilic anion.

Examples of the non-nucleophilic anion include a sulfonate anion (an aliphatic sulfonate anion, an aromatic sulfonate anion, a camphor sulfonate anion, and the like), a carboxylate anion (an aliphatic carboxylate anion, an aromatic carboxylate anion, an aralkyl carboxylate anion, and the like), a sulfonylimide anion, a bis(alkylsulfonyl)imide anion, and

a tris(alkylsulfonyl)methide anion.

An aliphatic moiety in the aliphatic sulfonate anion and the aliphatic carboxylate anion may be a linear or branched alkyl group or a cycloalkyl group, and a linear or branched alkyl group having 1 to 30 carbon atoms or a cycloalkyl group having 3 to 30 carbon atoms is preferable.

The above-described alkyl group may be, for example, a fluoroalkyl group (which may have a substituent other than a fluorine atom and may be a perfluoroalkyl group).

An aryl group in the aromatic sulfonate anion and the aromatic carboxylate anion is preferably an aryl group having 6 to 14 carbon atoms, and examples thereof include a phenyl group, a tolyl group, and a naphthyl group.

The alkyl group, cycloalkyl group, and aryl group mentioned above may have a substituent. The substituent is not particularly limited, and specific examples thereof include a nitro group, a halogen atom such as a fluorine atom and a chlorine atom, a carboxy group, a hydroxyl group, an amino group, a cyano group, an alkoxy group (preferably having 1 to 15 carbon atoms), an alkyl group (preferably having 1 to 10 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), and an aryloxysulfonyl group (preferably having 6 to 20 carbon atoms).

As the aralkyl group in the aralkyl carboxylate anion, an aralkyl group having 7 to 14 carbon atoms is preferable.

Examples of the aralkyl group having 7 to 14 carbon atoms include a benzyl group, a phenethyl group, a naphthylmethyl group, a naphthylethyl group, and a naphthylbutyl group.

Examples of the sulfonylimide anion include a saccharin anion.

As the alkyl group in the bis(alkylsulfonyl)imide anion and the tris(alkylsulfonyl)methide anion, an alkyl group having 1 to 5 carbon atoms is preferable. Examples of a substituent of these alkyl group include a halogen atom, an alkyl group substituted with a halogen atom, an alkoxy group, an alkylthio group, an alkyloxysulfonyl group, an aryloxysulfonyl group, and a cycloalkylaryloxysulfonyl group, and a fluorine atom or an alkyl group substituted with a fluorine atom is preferable.

In addition, the alkyl groups in the bis(alkylsulfonyl)imide anion may be bonded to each other to form a ring structure. As a result, acid strength is increased.

Examples of other non-nucleophilic anions include fluorinated phosphorus (for example, $PF_6^-$), fluorinated boron (for example, $BF_4^-$), and fluorinated antimony (for example, $SbF_6^-$).

As the non-nucleophilic anion, an aliphatic sulfonate anion in which at least an $\alpha$-position of the sulfonic acid is substituted with a fluorine atom, an aromatic sulfonate anion substituted with a fluorine atom or a group having a fluorine atom, a bis(alkylsulfonyl)imide anion in which an alkyl group is substituted with a fluorine atom, or a tris(alkylsulfonyl)methide anion in which an alkyl group is substituted with a fluorine atom is preferable. Among these, a perfluoroaliphatic sulfonate anion (preferably having 4 to 8 carbon atoms) or benzenesulfonate anion having a fluorine atom is more preferable, and a nonafluorobutanesulfonate anion, a perfluorooctanesulfonate anion, a pentafluorobenzenesulfonate anion, or a 3,5-bis(trifluoromethyl)benzenesulfonate anion is still more preferable.

Preferred examples of the non-nucleophilic anion include an anion represented by Formula (AN4).

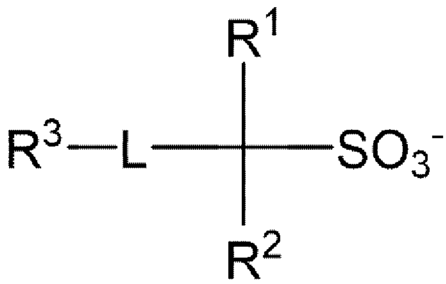

(AN4)

In Formula (AN4), $R^1$ to $R^3$ each independently represent an organic group or a hydrogen atom. L represents a divalent linking group.

In Formula (AN4), L represents a divalent linking group.

In a case of a plurality of L's, L's may be the same or different from each other.

Examples of the divalent linking group include -O-CO-O-, -COO-, -CONH-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), and a divalent linking group formed by a combination of a plurality of these groups. Among these, as the divalent linking group, -O-CO-O-, -COO-, -CONH-, -CO-, -O-, $-SO_2-$, -O-CO-O-alkylene group-, -COO-alkylene group-, or -CONH-alkylene group-, and more preferably -O-CO-O-, -O-CO-O-alkylene group-, -COO-, -CONH-, $-SO_2-$, or -COO-alkylene group-.

For example, L is preferably a group represented by Formula (AN4-2).

$$*^a-(CR^{2a}_2)_X-Q-(CR^{2b}_2)_Y-*^b \qquad (AN4-2)$$

In Formula (AN4-2), $*^a$ represents a bonding position with $R^3$ in Formula (AN4).

$*^b$ represents a bonding position $-C(R^1)(R^2)-$ in Formula (AN4).

X and Y each independently represent an integer of 0 to 10, preferably an integer of 0 to 3.

$R^{2a}$ and $R^{2b}$ each independently represent a hydrogen atom or a substituent.

In a case where $R^{2a}$'s and $R^{2b}$'s are present in a plural number, the $R^{2a}$'s and $R^{2b}$'s which are present in a plural number may be the same or different from each other.

However, in a case where Y is 1 or more, $R^{2b}$ in $CR^{2b}_2$ which is directly bonded to $-C(R^1)(R^2)-$ in Formula (AN4) is not a fluorine atom.

Q represents $*^A-O-CO-O-*^B$, $*^A-CO-*^B$, $*^A-CO-O-*^B$, $*^A-O-CO-*^B$, $*^A-O-*^B$, $*^A-S-*^B$, or $*^A-SO_2-*^B$.

However, in a case where X + Y in Formula (AN4-2) is 1 or more and $R^{2a}$ and $R^{2b}$ in Formula (AN4-2) are all hydrogen atoms, Q represents $*^A-O-CO-O-*^B$, $*^A-CO-*^B$, $*^A-O-CO-*^B$, $*^A-O-*^B$, $*^A-S-*^B$, or $*^A-SO_2-*^B$.

$*^A$ represents a bonding position on the $R^3$ side in Formula (AN4), and *B represents a bonding position on the $-SO_3^-$ side in Formula (AN4).

In Formula (AN4), $R^1$ to $R^3$ each independently represent an organic group.

The above-described organic group is not limited as long as it has one or more carbon atoms, and may be a linear group (for example, a linear alkyl group) or a branched group (for example, a branched alkyl group such as a t-butyl group), and may be a cyclic group. The above-described organic group may or may not have a substituent. The above-described organic group may or may not have a heteroatom (oxygen atom, sulfur atom, nitrogen atom, and/or the like).

Examples of the above-described organic group include a substituent which is not an electron withdrawing group.

Examples of the substituent which is not an electron withdrawing group include a hydrocarbon group, a hydroxyl group, an oxyhydrocarbon group, an oxycarbonyl hydrocarbon group, an amino group, a hydrocarbon-substituted amino group, and a hydrocarbon-substituted amide group.

In addition, the substituents which are not an electron withdrawing group are each independently preferably -R', -OH, -OR', -OCOR', $-NH_2$, $-NR'_2$, -NHR', or -NHCOR'. R' is a monovalent hydrocarbon group.

Examples of the above-described monovalent hydrocarbon group represented by R' include an alkyl group such as a methyl group, an ethyl group, a propyl group, and a butyl group; an alkenyl group such as an ethenyl group, a propenyl group, and a butenyl group; a monovalent linear or branched hydrocarbon group of an alkynyl group or the like, such as an ethynyl group, a propynyl group, and a butynyl group; a cycloalkyl group such as a cyclopropyl group, a cyclobutyl group, a cyclopentyl group, a cyclohexyl group, a norbornyl group, and an adamantyl group; a monovalent alicyclic hydrocarbon group of a cycloalkenyl group or the like, such as a cyclopropenyl group, a cyclobutenyl group, a cyclopentenyl group, and a norbornenyl group; an aryl group such as a phenyl group, a tolyl group, a xylyl group, a mesityl group, a naphthyl group, a methylnaphthyl group, an anthryl group, and a methylanthryl group; and a monovalent aromatic hydrocarbon group of an aralkyl group or the like, such as a benzyl group, a phenethyl group, a phenylpropyl group, a naphthylmethyl group, and an anthrylmethyl group.

Among these, $R^1$ and $R^2$ are each independently a hydrocarbon group (preferably, a cycloalkyl group) or a hydrogen atom.

Among these, $R^3$ is preferably an organic group having a cyclic structure. The above-described cyclic structure may be monocyclic or polycyclic, and may have a substituent. The ring of the organic group including a cyclic structure is preferably directly bonded to L in Formula (AN4).

For example, the above-described organic group having a cyclic structure may or may not have a heteroatom (oxygen atom, sulfur atom, nitrogen atom, and/or the like). The heteroatom may be substituted on one or more carbon atoms forming the cyclic structure.

As the above-described organic group having a cyclic structure, for example, a hydrocarbon group having a cyclic structure, a lactone ring group, or a sultone ring group is preferable. Among these, the above-described organic group having a cyclic structure is preferably a hydrocarbon group having a cyclic structure.

The above-described hydrocarbon group having a cyclic structure is preferably a monocyclic or polycyclic cycloalkyl group. These groups may have a substituent.

The above-described cycloalkyl group may be a monocycle (cyclohexyl group or the like) or a polycycle (adamantyl group or the like), and the number of carbon atoms is preferably 5 to 12.

As the above-described lactone group and sultone group, for example, a group obtained by removing one hydrogen atom from ring member atoms constituting the lactone structure or the sultone structure in any of the structures represented by Formulae (LC1-1) to (LC1-21) described above and the structures represented by Formulae (SL1-1) to

(SL1-3) described above is preferable.

As the non-nucleophilic anion, an anion represented by Formula (AN1) is also preferable.

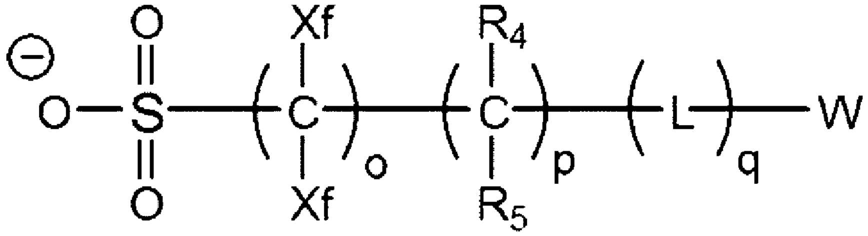

(AN1)

In Formula (AN1), o represents an integer of 1 to 3. p represents an integer of 0 to 10. q represents an integer of 0 to 10.

Xf represents a fluorine atom or an organic group. The above-described organic group may be an organic group substituted with at least one fluorine atom, or may be an organic group having no fluorine atom. The number of carbon atoms in the above-described organic group (preferably, an alkyl group) is preferably 1 to 10 and more preferably 1 to 4. In addition, the organic group (preferably, an alkyl group) substituted with at least one fluorine atom is preferably a perfluoroalkyl group.

At least one of Xf's is preferably a fluorine atom or a perfluoroalkyl group having 1 to 4 carbon atoms and more preferably a fluorine atom or $CF_3$, and it is still more preferable that both Xf's are fluorine atoms.

$R_4$ and $R_5$ each independently represent a hydrogen atom, a fluorine atom, an alkyl group, or an alkyl group substituted with at least one fluorine atom. In a case of a plurality of $R_4$'s and Rs's, $R_4$'s and $R_5$'s may be the same or different from each other.

The alkyl group represented by $R_4$ and $R_5$ preferably has 1 to 4 carbon atoms. The above-described alkyl group may further have a substituent. $R_4$ and $R_5$ are preferably a hydrogen atom.

Specific examples and suitable aspects of the alkyl group substituted with at least one fluorine atom are the same as the specific examples and suitable aspects of Xf in Formula (AN1).

L represents a divalent linking group.

In a case of a plurality of L's, L's may be the same or different from each other.

Examples of the divalent linking group include -O-CO-O-, -COO-, -CONH-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), and a divalent linking group formed by a combination of a plurality of these groups. Among these, as the divalent linking group, -O-CO-O-, -COO-, -CONH-, -CO-, -O-, $-SO_2-$, -O-CO-O-alkylene group-, -COO-alkylene group-, or -CONH-alkylene group-, and more preferably -O-CO-O-, -O-CO-O-alkylene group-, -COO-, -CONH-, $-SO_2-$, or -COO-alkylene group-.

W represents an organic group including a cyclic structure. Among these, a cyclic organic group is preferable.

Examples of the cyclic organic group include an alicyclic group, an aryl group, and a heterocyclic group.

The alicyclic group may be monocyclic or polycyclic. Examples of the monocyclic alicyclic group include a monocyclic cycloalkyl group such as a cyclopentyl group, a cyclohexyl group, and a cyclooctyl group. Examples of the polycyclic alicyclic group include a polycyclic cycloalkyl group such as a norbornyl group, a tricyclodecanyl group, a tetracyclodecanyl group, a tetracyclododecanyl group, and an adamantyl group. Among these, an alicyclic group having a bulky structure with 7 or more carbon atoms, such as a norbornyl group, a tricyclodecanyl group, a tetracyclodecanyl group, a tetracyclododecanyl group, and an adamantyl group, is preferable.

The aryl group may be monocyclic or polycyclic. Examples of the above-described aryl group include a phenyl group, a naphthyl group, a phenanthryl group, and an anthryl group.

The heterocyclic group may be monocyclic or polycyclic. Among these, in a case of a polycyclic heterocyclic group, the diffusion of the acid can be further suppressed. In addition, the heterocyclic group may or may not have aromaticity. Examples of a heterocycle having aromaticity include a furan ring, a thiophene ring, a benzofuran ring, a benzothiophene ring, a dibenzofuran ring, a dibenzothiophene ring, and a pyridine ring. Examples of a heterocycle not having aromaticity include a tetrahydropyran ring, a lactone ring, a sultone ring, and a decahydroisoquinoline ring. As the heterocycle in the heterocyclic group, a furan ring, a thiophene ring, a pyridine ring, or a decahydroisoquinoline ring is preferable.

The above-described cyclic organic group may have a substituent. Examples of the above-described substituent include an alkyl group (may be linear or branched; preferably having 1 to 12 carbon atoms), a cycloalkyl group (may be monocyclic, polycyclic, or spirocyclic; preferably having 3 to 20 carbon atoms), an aryl group (preferably having 6 to 14 carbon atoms), a hydroxyl group, an alkoxy group, an ester group, an amide group, a urethane group, a ureido group, a thioether group, a sulfonamide group, and a sulfonic acid ester group. A carbon constituting the cyclic organic group

(carbon contributing to ring formation) may be a carbonyl carbon. In addition, two or more substituents may be bonded to each other to form a ring. Examples thereof include a case where two alkoxy groups or a hydroxyl group and an alkoxy group are bonded to each other to form a ring having a cyclic acetal structure. The ring may have a substituent. Examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms).

As the anion represented by Formula (AN1), $SO_3^-$-$CF_2$-$CH_2$-OCO-$(L)_{q'}$-W, $SO_3^-$-$CF_2$-CHF-$CH_2$-OCO-$(L)_{q'}$-W, $SO_3^-$-$CF_2$-COO-$(L)_{q'}$-W, $SO_3^-$-$CF_2$-$CF_2$-$CH_2$-$CH_2$-$(L)_q$-W, or $SO_3^-$-$CF_2$-CH($CF_3$)-OCO-$(L)_{q'}$-W is preferable. Here, L, q, and W are the same as in Formula (AN1). q' represents an integer of 0 to 10.

As the anion represented by Formula (AN1), the following aspects (AN2) and (AN3) are also preferable.

Aspect (AN2): in Formula (AN1), o represents 2; p represents 0; two Xf's bonded to a carbon atom directly bonded to -$SO_3^-$ (hereinafter, this carbon atom is also referred to as "carbon atom Z1") each independently represent a hydrogen atom or an organic group having no fluorine atom; and two Xf's bonded to a carbon atom adjacent to the carbon atom (hereinafter, this carbon atom is also referred to as "carbon atom Z2") each independently represent a hydrogen atom or an organic group. Preferred aspects of q, L, and W are the same as those described above.

The two Xf's bonded to the carbon atom Z1 are preferably hydrogen atoms.

It is preferable that at least one of the two Xf's bonded to the carbon atom Z2 is a fluorine atom or an organic group having a fluorine atom, it is more preferable that both are a fluorine atom or an organic group having a fluorine atom, and it is still more preferable that both are an alkyl group substituted with fluorine.

Aspect (AN3): in Formula (AN1), each one of two Xf's independently represents a fluorine atom or an alkyl group substituted with at least one fluorine atom; and the other independently represents a hydrogen atom or an organic group having no fluorine atom. Preferred aspects of o, p, q, $R_4$, $R_5$, L, and W are the same as those described above.

The non-nucleophilic anion may be a benzenesulfonate anion, and is preferably a benzenesulfonate anion substituted with a branched alkyl group or a cycloalkyl group.

As the non-nucleophilic anion, an aromatic sulfonate anion represented by Formula (AN5) is also preferable.

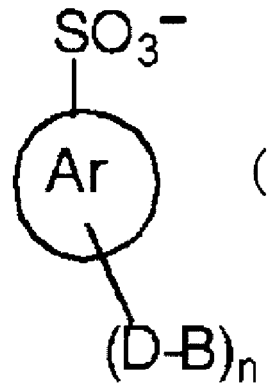
(AN5)

In Formula (AN5), Ar represents an aryl group (phenyl group or the like), and may further have a substituent other than a sulfonate anion and a -(D-B) group. Examples of the substituent which may be further included include a fluorine atom and a hydroxyl group.

n represents an integer of 0 or more. n is preferably 1 to 4, more preferably 2 or 3, and still more preferably 3.

D represents a single bond or a divalent linking group. Examples of the divalent linking group include an ether group, a thioether group, a carbonyl group, a sulfoxide group, a sulfone group, a sulfonic acid ester group, an ester group, and a group consisting of a combination of two or more of these groups.

B represents a hydrocarbon group.

B preferably has an aliphatic hydrocarbon structure. B is more preferably an isopropyl group, a cyclohexyl group, or an aryl group which may further have a substituent (such as a tricyclohexylphenyl group).

In addition, B may further have a substituent represented by "-$(L)_q$-W". L, q, and W have the same meaning as L, q, and W in Formula (AN1) described above, and specific examples and preferred range thereof are also the same.

As the non-nucleophilic anion, a disulfonamide anion is also preferable.

The disulfonamide anion is, for example, an anion represented by $N^-(SO_2\text{-}R^q)_2$.

Here, $R^q$ represents an alkyl group which may have a substituent, and is preferably a fluoroalkyl group and more preferably a perfluoroalkyl group. Two $R^q$'s may be bonded to each other to form a ring. The group formed by bonding two $R^q$'s to each other is preferably an alkylene group which may have a substituent, preferably a fluoroalkylene group, and still more preferably a perfluoroalkylene group. The number of carbon atoms in the above-described alkylene group is preferably 2 to 4.

In addition, examples of the non-nucleophilic anion include anions represented by Formulae (d1-1) to (d1-4).

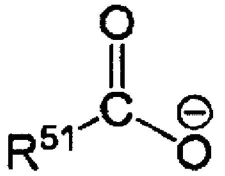

(d1-1)

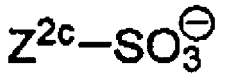

(d1-2)

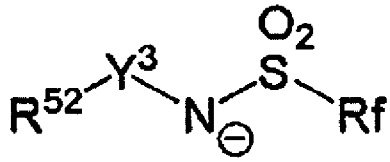

(d1-3)

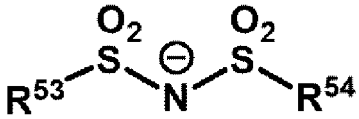

(d1-4)

In Formula (d1-1), $R^{51}$ represents a hydrocarbon group (for example, an aryl group such as a phenyl group) which may have a substituent (for example, a hydroxyl group).

In Formula (d1-2), $Z^{2c}$ represents a hydrocarbon group having 1 to 30 carbon atoms, which may have a substituent (provided that a carbon atom adjacent to S is not substituted with a fluorine atom).

The above-described divalent hydrocarbon group in $Z^{2c}$ may be linear or branched, may have a cyclic structure. In addition, carbon atoms in the above-described hydrocarbon group (preferably, carbon atoms which are ring member atoms in a case where the above-described hydrocarbon group has a cyclic structure) may be a carbonyl carbon (-CO-). Examples of the hydrocarbon group include a group having a norbornyl group which may have a substituent. Carbon atoms forming the above-described norbornyl group may be a carbonyl carbon.

In addition, it is preferable that "$Z^{2c}$-$SO_3^-$" in Formula (d1-2) is different from the anion represented by Formula (AN4), (AN1), or (AN5). For example, $Z^{2c}$ is preferably a group other than an aryl group. In addition, for example, in $Z^{2c}$, atoms at α-position and β-position with respect to -$SO_3^-$ are preferably atoms other than carbon atoms having a fluorine atom as a substituent. For example, in $Z^{2c}$, it is preferable that the atom at α-position and/or the atom at β-position with respect to -$SO_3^-$ is a ring member atom in a cyclic group.

In Formula (d1-3), $R^{52}$ represents an organic group (preferably, a hydrocarbon group having a fluorine atom), $Y^3$ represents a linear, branched, or cyclic alkylene group, an arylene group, or a carbonyl group, and Rf represents a hydrocarbon group.

In Formula (d1-4), $R^{53}$ and $R^{54}$ represent an organic group (preferably, a hydrocarbon group having a fluorine atom). $R^{53}$ and $R^{54}$ may be bonded to each other to form a ring.

The organic anion may be used alone or in combination of two or more kinds thereof.

It is also preferable that the resist composition contains two or more types of the compound (B), or the compound (B) is at least one selected from the group consisting of the following compound (I) and the following compound (II).

<Compound (I) and Compound (II)>

It is also preferable that the compound (B) is at least one selected from the group consisting of the following compound (I) and the following compound (II).

(Compound (I))

The compound (I) is a compound having one or more of the following structural moieties X and one or more of the following structural moieties Y, in which the compound generates an acid including the following first acidic moiety derived from the following structural moiety X and the following second acidic moiety derived from the following structural moiety Y by irradiation with actinic ray or radiation.

Structural moiety X: a structural moiety which consists of an anionic moiety $A_1^-$ and a cationic moiety $M_1^+$, and forms a first acidic moiety represented by $HA_1$ by irradiation with actinic ray or radiation

Structural moiety Y: a structural moiety which consists of an anionic moiety $A_2^-$ and a cationic moiety $M_2^+$, and forms a second acidic moiety represented by $HA_2$ by irradiation with actinic ray or radiation

It is preferable that the cationic moiety $M_1^+$ and the cationic moiety $M_2^+$ each independently represent an organic cation, and specific examples and preferred ranges thereof are the same as those of the above-described organic cation

represented by $M^+$.

In addition, the above-described compound (I) satisfies the following condition I.

Condition I: a compound PI, which is formed by, in the compound (I), replacing the cationic moiety $M_1^+$ in the structural moiety X and the cationic moiety $M_2^+$ in the structural moiety Y with $H^+$, has an acid dissociation constant a1 derived from the acidic moiety represented by $HA_1$, formed by replacing the cationic moiety $M_1^+$ in the structural moiety X with $H^+$, and has an acid dissociation constant a2 derived from the acidic moiety represented by $HA_2$, formed by replacing the cationic moiety $M_2^+$ in the structural moiety Y with $H^+$, in which the acid dissociation constant a2 is larger than the acid dissociation constant a1

Hereinafter, the condition I will be described in more detail.

In a case where the compound (I) is, for example, a compound that generates an acid having one first acidic moiety derived from the above-described structural moiety X and one second acidic moiety derived from the above-described structural moiety Y, the compound PI corresponds to "compound having $HA_1$ and $HA_2$".

As the acid dissociation constant a1 and the acid dissociation constant a2 of such a compound PI, more specifically, in a case of obtaining acid dissociation constants of the compound PI, a pKa in a case where the compound PI is to be "compound having $A_1^-$ and $HA_2$" is defined as the acid dissociation constant a1, and a pKa in a case where the "compound having $A_1^-$ and $HA_2$" is to be "compound having $A_1^-$ and $A_2^-$" is defined as the acid dissociation constant a2.

In addition, in a case where the compound (I) is, for example, a compound that generates an acid having two first acidic moieties derived from the above-described structural moiety X and one second acidic moiety derived from the above-described structural moiety Y, the compound PI corresponds to "compound having two $HA_1$'s and one $HA_2$".

In a case of obtaining acid dissociation constants of such a compound PI, an acid dissociation constant in a case where the compound PI is to be "compound having one $A_1^-$, one $HA_1$, and one $HA_2$" and an acid dissociation constant in a case where the "compound having one $A_1^-$, one $HA_1$, and one $HA_2$" is to be "compound having two $A_1^-$ and one $HA_2$" correspond to the above-described acid dissociation constant a1. In addition, an acid dissociation constant in a case where the "compound having two $A_1^-$ and one $HA_2$" is to be "compound having two $A_1^-$ and one $A_2^-$" corresponds to the acid dissociation constant a2. That is, in the compound PI, in a case of a plurality of acid dissociation constants derived from the acidic moiety represented by $HA_1$, which is formed by replacing the above-described cationic moiety $M_1^+$ in the above-described structural moiety X with $H^+$, a value of the acid dissociation constant a2 is larger than the largest value of the plurality of acid dissociation constants a1. In a case where the acid dissociation constant in a case where the compound PI is to be the "compound having one $A_1^-$, one $HA_1$, and one $HA_2$" is defined as aa, and the acid dissociation constant in a case where the "compound having one $A_1^-$, one $HA_1$, and one $HA_2$" is to be the "compound having two $A_1^-$ and one $HA_2$" is defined as ab, a relationship between aa and ab satisfies aa < ab.

The acid dissociation constant a1 and the acid dissociation constant a2 can be obtained by the above-described method for measuring an acid dissociation constant.

The above-described compound PI corresponds to an acid generated in a case where the compound (I) is irradiated with actinic ray or radiation.

In a case where the compound (I) has two or more of the structural moieties X, the structural moieties X may be the same or different from each other. In addition, two or more of $A_1^-$'s and two or more of $M_1^+$ may be the same or different from each other.

In addition, in the compound (I), $A_1^-$ and $A_2^-$, and $M_1^+$ and $M_2^+$ may be the same or different from each other, but it is preferable that $A_1^-$ and $A_2^-$ are different from each other.

In the above-described compound PI, a difference (absolute value) between the acid dissociation constant a1 (in a case of a preferably of acid dissociation constants a1, the maximum value thereof) and the acid dissociation constant a2 is preferably 0.1 or more, more preferably 0.5 or more, and still more preferably 1.0 or more. The upper limit value of the difference (absolute value) between the acid dissociation constant a1 (in a case of a preferably of acid dissociation constants a1, the maximum value thereof) and the acid dissociation constant a2 is not particularly limited, but is, for example, 16 or less.

In the above-described compound PI, the acid dissociation constant a2 is, for example, 20 or less, preferably 15 or less. The lower limit value of the acid dissociation constant a2 is preferably -4.0 or more.

In addition, in the above-described compound PI, the acid dissociation constant a1 is, for example, 2.0 or less, preferably 0 or less. The lower limit value of the acid dissociation constant a1 is preferably -20.0 or more.

The anionic moiety $A_1^-$ and the anionic moiety $A_2^-$ are structural moieties including a negatively charged atom or atomic group, and examples thereof include structural moieties selected from the group consisting of Formulae (AA-1) to (AA-3), and Formulae (BB-1) to (BB-6).

The anionic moiety $A_1^-$ is preferably an acidic moiety capable of forming an acidic moiety having a small acid dissociation constant, and among these, any one of Formulae (AA-1) to (AA-3) is more preferable and any one of Formula (AA-1) or (AA-3) is still more preferable.

In addition, the anionic moiety $A_2^-$ is preferably an acidic moiety capable of forming an acidic moiety having a larger acid dissociation constant than the anionic moiety $A_1^-$, and any one of Formulae (BB-1) to (BB-6) is more preferable

and any one of Formula (BB-1) or (BB-4) is still more preferable.

In Formulae (AA-1) to (AA-3) and Formulae (BB-1) to (BB-6), * represents a bonding position.

In Formula (AA-2), $R^A$'s each independently represent a monovalent organic group.

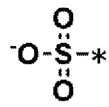
AA-1

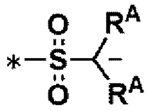
AA-2

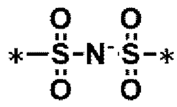
AA-3

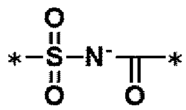
BB-1

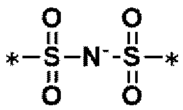
BB-2

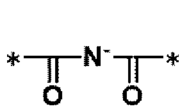
BB-3

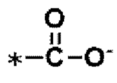
BB-4

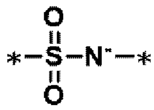
BB-5

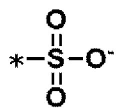
BB-6

A specific structure of the compound (I) is not particularly limited, and examples thereof include compounds represented by Formulae (Ia-1) to (Ia-5) described below.

-Compound Represented by Formula (Ia-1)-

Hereinafter, first, the compound represented by Formula (Ia-1) will be described.

$$M_{11}^+ A_{11}^- \text{-} L_1 \text{-} A_{12}^- M_{12}^+ \qquad \text{(Ia-1)}$$

The compound represented by Formula (Ia-1) generates an acid represented by $HA_{11}$-$L_1$-$A_{12}H$ by irradiation with actinic ray or radiation.

In Formula (Ia-1), $M_{11}^+$ and $M_{12}^+$ each independently represent an organic cation.

$A_{11}^-$ and $A_{12}^-$ each independently represent a monovalent anionic functional group.

$L_1$ represents a divalent linking group.

$M_{11}^+$ and $M_{12}^+$ may be the same or different from each other.

$A_{11}^-$ and $A_{12}^-$ may be the same or different from each other, but it is preferable to be different from each other.

However, in the compound PIa ($HA_{11}$-$L_1$-$A_{12}H$) formed by replacing cations represented by $M_{11}^+$ and $M_{12}^+$ with $H^+$ in Formula (Ia-1), the acid dissociation constant a2 derived from the acidic moiety represented by $A_{12}H$ is larger than the acid dissociation constant a1 derived from the acidic moiety represented by $HA_{11}$. Suitable values of the acid dissociation constant a1 and the acid dissociation constant a2 are as described above. In addition, the acid generated from the compound PIa and the acid generated from the compound represented by Formula (Ia-1) by irradiation with actinic ray or radiation are the same.

In addition, at least one of $M_{11}^+$, $M_{12}^+$, $A_{11}^-$, $A_{12}^-$, or $L_1$ may have an acid-decomposable group as a substituent.

In Formula (Ia-1), the organic cation represented by $M_{11}^+$ and $M_{12}^+$ is the same as that of $M^+$ described above.

The monovalent anionic functional group represented by $A_{11}^-$ is intended to be a monovalent group including the above-described anionic moiety $A_1^-$. In addition, the monovalent anionic functional group represented by $A_{12}^-$ is intended to be a monovalent group including the above-described anionic moiety $A_2^-$.

As the monovalent anionic functional group represented by $A_{11}^-$ and $A_{12}^-$, a monovalent anionic functional group including the anionic moiety of any of Formulae (AA-1) to (AA-3) and Formulae (BB-1) to (BB-6) described above is preferable, and a monovalent anionic functional group selected from the group consisting of Formulae (AX-1) to (AX-3) and Formulae (BX-1) to (BX-7) is more preferable. Among these, as the monovalent anionic functional group represented by $A_{11}^-$, a monovalent anionic functional group represented by any of Formulae (AX-1) to (AX-3) is preferable. In addition, as the monovalent anionic functional group represented by $A_{12}^-$, a monovalent anionic functional group represented by any of Formulae (BX-1) to (BX-7) is preferable, and a monovalent anionic functional group represented by any of Formulae (BX-1) to (BX-6) is more preferable.

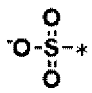
AX-1

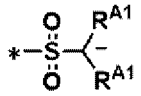
AX-2

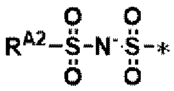
AX-3

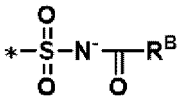
BX-1

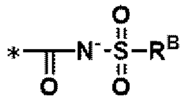
BX-2

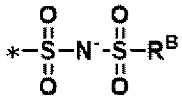
BX-3

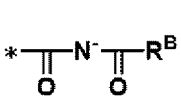
BX-4

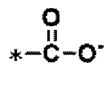
BX-5

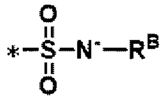
BX-6

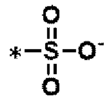
BX-7

In Formulae (AX-1) to (AX-3), $R^{A1}$ and $R^{A2}$ each independently represent a monovalent organic group. * represents a bonding position.

Examples of the monovalent organic group represented by $R^{A1}$ include a cyano group, a trifluoromethyl group, and a methanesulfonyl group.

As the monovalent organic group represented by $R^{A2}$, a linear, branched, or cyclic alkyl group, or an aryl group is preferable.

The number of carbon atoms in the above-described alkyl group is preferably 1 to 15, more preferably 1 to 10, and still more preferably 1 to 6.

The above-described alkyl group may have a substituent. As the substituent, a fluorine atom or a cyano group is preferable, and a fluorine atom is more preferable. In a case where the above-described alkyl group has a fluorine atom as the substituent, the substituent may be a perfluoroalkyl group.

The above-described aryl group is preferably a phenyl group or a naphthyl group, and more preferably a phenyl group.

The above-described aryl group may have a substituent. As the substituent, a fluorine atom, an iodine atom, a perfluoroalkyl group (for example, preferably having 1 to 10 carbon atoms and more preferably having 1 to 6 carbon atoms), or a cyano group is preferable, and a fluorine atom, an iodine atom, or a perfluoroalkyl group is more preferable.

In Formulae (BX-1) to (BX-4) and (BX-6), $R^B$ represents a monovalent organic group. * represents a bonding position.

As the monovalent organic group represented by $R^B$, a linear, branched, or cyclic alkyl group, or an aryl group is preferable.

The number of carbon atoms in the above-described alkyl group is preferably 1 to 15, more preferably 1 to 10, and still more preferably 1 to 6.

The above-described alkyl group may have a substituent. The substituent is not particularly limited, but a fluorine atom or a cyano group is preferable, and a fluorine atom is more preferable. In a case where the above-described alkyl group has a fluorine atom as the substituent, the substituent may be a perfluoroalkyl group.

In a case where the carbon atom to be the bonding position in the alkyl group (for example, in the case of Formulae (BX-1) and (BX-4), a carbon atom directly bonded to -CO- specified in the alkyl group of the formulae; in the case of Formulae (BX-2) and (BX-3), a carbon atom directly bonded to $-SO_2-$ specified in the alkyl group of the formulae; and in the case of Formula (BX-6), a carbon atom directly bonded to $N^-$ specified in the alkyl group of the formula) has a substituent, the substituent is also preferably a fluorine atom or a substituent other than a cyano group.

In addition, the above-described alkyl group may have a carbon atom substituted with a carbonyl carbon.

The above-described aryl group is preferably a phenyl group or a naphthyl group, and more preferably a phenyl group.

The above-described aryl group may have a substituent. As the substituent, a fluorine atom, an iodine atom, a perfluoroalkyl group (for example, preferably having 1 to 10 carbon atoms and more preferably having 1 to 6 carbon atoms), a cyano group, an alkyl group (for example, preferably having 1 to 10 carbon atoms and more preferably having 1 to 6 carbon atoms), an alkoxy group (for example, preferably having 1 to 10 carbon atoms and more preferably having 1 to 6 carbon atoms), or an alkoxycarbonyl group (for example, preferably having 2 to 10 carbon atoms and more preferably having 2 to 6 carbon atoms) is preferable; and a fluorine atom, an iodine atom, a perfluoroalkyl group, an alkyl group, an alkoxy group, or an alkoxycarbonyl group is more preferable.

In Formula (Ia-1), the divalent liking group represented by $L_1$ is not particularly limited, and examples thereof include -CO-, -NR-, -CO-, -O-, -S-, -SO-, $-SO_2-$, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent linking group formed by a combination of a plurality of these groups. Examples of R include a hydrogen atom and a monovalent organic group. The monovalent organic group is not particularly limited, but is preferably, for example, an alkyl group (preferably having 1 to 6 carbon atoms).

The above-described alkylene group, the above-described cycloalkylene group, the above-described alkenylene group, and the above-described divalent aliphatic heterocyclic group, divalent aromatic heterocyclic group, and divalent aromatic hydrocarbon ring group may have a substituent. Examples of the substituent include a halogen atom (preferably, a fluorine atom).

Among these, as the divalent linking group represented by $L_1$, a divalent linking group represented by Formula (L1) is preferable.

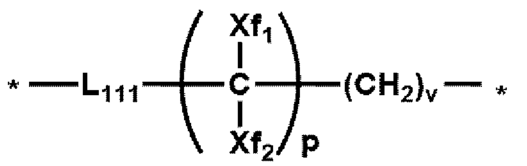

(L1)

In Formula (L1), $L_{111}$ represents a single bond or a divalent linking group.

The divalent linking group represented by $L_{111}$ is not particularly limited, and examples thereof include -CO-, -NH-, -O-, -SO-, $-SO_2-$, an alkylene group which may have a substituent (preferably having 1 to 6 carbon atoms; may be linear or branched), a cycloalkylene group which may have a substituent (preferably having 3 to 15 carbon atoms), an aryl group which may have a substituent (preferably having 6 to 10 carbon atoms), and a divalent linking group formed by a combination of a plurality of these groups. The substituent is not particularly limited, and examples thereof include a halogen atom.

p represents an integer of 0 to 3, and preferably represents an integer of 1 to 3.

v represents an integer of 0 or 1.

$Xf_1$'s each independently represent a fluorine atom or an alkyl group substituted with at least one fluorine atom. The number of carbon atoms in the alkyl group is preferably 1 to 10 and more preferably 1 to 4. In addition, the alkyl group substituted with at least one fluorine atom is preferably a perfluoroalkyl group.

$Xf_2$'s each independently represent a hydrogen atom, an alkyl group which may have a fluorine atom as a substituent, or a fluorine atom. The number of carbon atoms in the alkyl group is preferably 1 to 10 and more preferably 1 to 4. Among these, $Xf_2$ preferably represents a fluorine atom or an alkyl group substituted with at least one fluorine atom, and more preferably represents a fluorine atom or a perfluoroalkyl group.

Among these, as each of $Xf_1$ and $Xf_2$, a fluorine atom or a perfluoroalkyl group having 1 to 4 carbon atoms is preferable, and a fluorine atom or $CF_3$ is more preferable. In particular, it is still more preferable that both $Xf_1$ and $Xf_2$ are fluorine atoms.

* represents a bonding position.

In a case where $L_{11}$ in Formula (Ia-1) represents the divalent linking group represented by Formula (L1), it is preferable that the bonding site (*) on the $L_{111}$ side of Formula (L1) is bonded to $A_{12}^-$ of Formula (Ia-1).

-Compounds Represented by Formulae (Ia-2) to (Ia-4)-

Next, the compounds represented by Formulae (Ia-2) to (Ia-4) will be described.

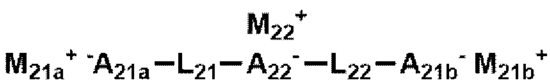

(Ia-2)

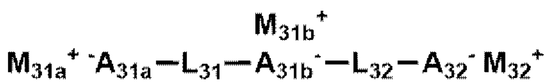

(Ia-3)

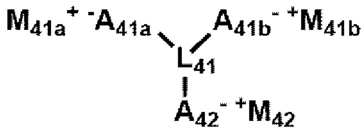

(Ia-4)

In Formula (Ia-2), $A_{21a}^-$ and $A_{21b}^-$ each independently represent a monovalent anionic functional group. Here, the monovalent anionic functional group represented by $A_{21a}^-$ and $A_{21b}^-$ is intended to be a monovalent group including the above-described anionic moiety $A_1^-$. The monovalent anionic functional group represented by $A_{21a}^-$ and $A_{21b}^-$ is not particularly limited, and examples thereof include the monovalent anionic functional group selected from the group consisting of Formulae (AX-1) to (AX-3) described above.

$A_{22}^-$ represents a divalent anionic functional group. Here, the divalent anionic functional group represented by $A_{22}^-$ is intended to be a divalent group including the above-described anionic moiety $A_2^-$. Examples of the divalent anionic functional group represented by $A_{22}^-$ include a divalent anionic functional group represented by Formulae (BX-8) to (BX-11).

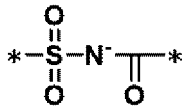

BX-8

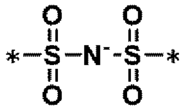

BX-9

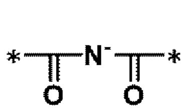

BX-10

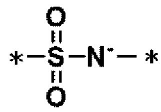

BX-11

$M_{21a}^+$, $M_{21b}^+$, and $M_{22}^+$ each independently represent an organic cation. The organic cation represented by $M_{21a}^+$, $M_{21b}^+$, and $M_{22}^+$ has the same meaning as $M_1^+$ described above, and a suitable aspect thereof is also the same.

$L_{21}$ and $L_{22}$ each independently represent a divalent organic group.

In addition, in a compound PIa-2 of Formula (Ia-2), in which the organic cation represented by $M_{21a}^+$, $M_{21b}^+$, and $M_{22}^+$ is replaced with $H^+$, an acid dissociation constant a2 derived from an acidic moiety represented by $A_{22}H$ is larger than an acid dissociation constant a1-1 derived from $A_{21a}H$ and an acid dissociation constant a1-2 derived from an acidic moiety represented by $A_{21b}H$. The acid dissociation constant a1-1 and the acid dissociation constant a1-2 correspond to the above-described acid dissociation constant a1.

$A_{21a}^-$ and $A_{21b}^-$ may be the same or different from each other. In addition, $M_{21a}^+$, $M_{21b}^+$, and $M_{22}^+$ may be the same or different from each other.

In addition, at least one of $M_{21a}^+$, $M_{21b}^+$, $M_{22}^+$, $A_{21a}^-$, $A_{21b}^-$, $L_{21}$, or $L_{22}$ may have an acid-decomposable group as a substituent.

In Formula (Ia-3), $A_{31a}^-$ and $A_{32}^-$ each independently represent a monovalent anionic functional group. The definition of the monovalent anionic functional group represented by $A_{31a}^-$ is the same as $A_{21a}^-$ and $A_{21b}^-$ in Formula (Ia-2), and a suitable aspect thereof is also the same.

The monovalent anionic functional group represented by $A_{32}^-$ is intended to be a monovalent group including the above-described anionic moiety $A_2^-$. The monovalent anionic functional group represented by $A_{32}^-$ is not particularly limited, and examples thereof include the monovalent anionic functional group selected from the group consisting of Formulae (BX-1) to (BX-7) described above.

$A_{31b}^-$ represents a divalent anionic functional group. Here, the divalent anionic functional group represented by $A_{31b}^-$ is intended to be a divalent group including the above-described anionic moiety $A_1^-$. Examples of the divalent anionic functional group represented by $A_{31b}^-$ include a divalent anionic functional group represented by Formula (AX-4).

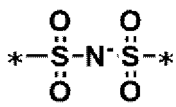

AX-4

$M_{31a}^+$, $M_{31b}^+$, and $M_{32}^+$ each independently represent a monovalent organic cation. The organic cation represented by $M_{31a}^+$, $M_{31b}^+$, and $M_{32}^+$ has the same meaning as $M_1^+$ described above, and a suitable aspect thereof is also the same.

$L_{31}$ and $L_{32}$ each independently represent a divalent organic group.

In addition, in a compound PIa-3 of Formula (Ia-3), in which the organic cation represented by $M_{31a}^+$, $M_{31b}^+$, and $M_{32}^+$ is replaced with $H^+$, an acid dissociation constant a2 derived from an acidic moiety represented by $A_{32}H$ is larger than an acid dissociation constant a1-3 derived from an acidic moiety represented by $A_{31a}H$ and an acid dissociation constant a1-4 derived from an acidic moiety represented by $A_{31b}H$. The acid dissociation constant a1-3 and the acid dissociation constant a1-4 correspond to the above-described acid dissociation constant a1.

$A_{31a}^-$ and $A_{32}^-$ may be the same or different from each other. In addition, $M_{31a}^+$, $M_{31b}^+$, and $M_{32}^+$ may be the same or different from each other.

In addition, at least one of $M_{31a}^+$, $M_{31b}^+$, $M_{32}^+$, $A_{31a}^-$, $A_{32}^-$, $L_{31}$, or $L_{32}$ may have an acid-decomposable group as a substituent.

In Formula (Ia-4), $A_{41a}^-$, $A_{41b}^-$, and $A_{42}^-$ each independently represent a monovalent anionic functional group. The definition of the monovalent anionic functional group represented by $A_{41a}^-$ and $A_{41b}^-$ is the same as $A_{21a}^-$ and $A_{21b}^-$ in Formula (Ia-2). In addition, the definition of the monovalent anionic functional group represented by $A_{42}^-$ is the same as $A_{32}^-$ in Formula (Ia-3), and a suitable aspect thereof is also the same.

$M_{41a}^+$, $M_{41b}^+$, and $M_{42}^+$ each independently represent an organic cation.

$L_{41}$ represents a trivalent organic group.

In addition, in a compound PIa-4 of Formula (Ia-4), in which the organic cation represented by $M_{41a}^+$, $M_{41b}^+$, and $M_{42}^+$ is replaced with $H^+$, an acid dissociation constant a2 derived from an acidic moiety represented by $A_{42}H$ is larger than an acid dissociation constant a1-5 derived from an acidic moiety represented by $A_{41a}H$ and an acid dissociation constant a1-6 derived from an acidic moiety represented by $A_{41b}H$. The acid dissociation constant a1-5 and the acid dissociation constant a1-6 correspond to the above-described acid dissociation constant a1.

$A_{41a}^-$, $A_{41b}^-$, and $A_{42}^-$ may be the same or different from each other. In addition, $M_{41,}^+$, $M_{41b}^+$, and $M_{42}^+$ may be the same or different from each other.

In addition, at least one of $M_{41a}^+$, $M_{41b}^+$, $M_{42}^+$, $A_{41a}^-$, $A_{41b}^-$, $A_{42}^-$, or $L_{41}$ may have an acid-decomposable group as a substituent.

The divalent organic group represented by $L_{21}$ and $L_{22}$ in Formula (Ia-2) and $L_{31}$ and $L_{32}$ in Formula (Ia-3) is not particularly limited, and examples thereof include -CO-, -NR-, -O-, -S-, -SO-, $-SO_2-$, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent organic group formed by a combination of a plurality of these groups. Examples of R include a hydrogen atom and a monovalent organic group. The monovalent organic group is not particularly limited, but is preferably, for example, an alkyl group (preferably having 1 to 6 carbon atoms).

The above-described alkylene group, the above-described cycloalkylene group, the above-described alkenylene group, and the above-described divalent aliphatic heterocyclic group, divalent aromatic heterocyclic group, and divalent aromatic hydrocarbon ring group may have a substituent. Examples of the substituent include a halogen atom (preferably, a fluorine atom).

As the divalent organic group represented by $L_{21}$ and $L_{22}$ in Formula (Ia-2) and $L_{31}$ and $L_{32}$ in Formula (Ia-3), for example, a divalent organic group represented by Formula (L2) is also preferable.

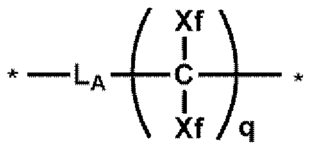

(L2)

In Formula (L2), q represents an integer of 1 to 3. * represents a bonding position.

Xf's each independently represent a fluorine atom or an alkyl group substituted with at least one fluorine atom. The number of carbon atoms in the alkyl group is preferably 1 to 10 and more preferably 1 to 4. In addition, the alkyl group substituted with at least one fluorine atom is preferably a perfluoroalkyl group.

Xf is preferably a fluorine atom or a perfluoroalkyl group having 1 to 4 carbon atoms, and more preferably a fluorine atom or $CF_3$. In particular, it is still more preferable that both Xf's are fluorine atoms.

$L_A$ represents a single bond or a divalent linking group.

The divalent linking group represented by $L_A$ is not particularly limited, and examples thereof include -CO-, -O-, -SO-, $-SO_2-$, an alkylene group (preferably having 1 to 6 carbon atoms; may be linear or branched), a cycloalkylene

group (preferably having 3 to 15 carbon atoms), a divalent aromatic hydrocarbon ring group (preferably a 6- to 10-membered ring, and more preferably a 6-membered ring), and a divalent linking group formed by a combination of a plurality of these groups.

In addition, the above-described alkylene group, the above-described cycloalkylene group, and the divalent aromatic hydrocarbon ring group may have a substituent. Examples of the substituent include a halogen atom (preferably, a fluorine atom).

Examples of the divalent organic group represented by Formula (L2) include *-$CF_2$-*, *-$CF_2$-$CF_2$-*, *-$CF_2$-$CF_2$-$CF_2$-*, *-Ph-O-$SO_2$-$CF_2$-*, *-Ph-O-$SO_2$-$CF_2$-$CF_2$-*, *-Ph-O-$SO_2$-$CF_2$-$CF_2$-$CF_2$-*, and *-Ph-OCO-$CF_2$-*. Ph is a phenylene group which may have a substituent, and is preferably a 1,4-phenylene group. The substituent is not particularly limited, and an alkyl group (for example, preferably having 1 to 10 carbon atoms and more preferably having 1 to 6 carbon atoms) or an alkoxy group (for example, preferably having 1 to 10 carbon atoms and more preferably having 1 to 6 carbon atoms), or an alkoxycarbonyl group (for example, preferably having 2 to 10 carbon atoms and more preferably having 2 to 6 carbon atoms) is preferable.

In a case where $L_{21}$ and $L_{22}$ in Formula (Ia-2) represents the divalent organic group represented by Formula (L2), it is preferable that the bonding site (*) on the $L_A$ side of Formula (L2) is bonded to $A_{21a}^-$ and $A_{21b}^-$ of Formula (Ia-2).

In addition, in a case where $L_{31}$ and $L_{32}$ in Formula (Ia-3) represents the divalent organic group represented by Formula (L2), it is preferable that the bonding site (*) on the $L_A$ side of Formula (L2) is bonded to $A_{31a}^-$ and $A_{32b}^-$ of Formula (Ia-3).

-Compound Represented by Formula (Ia-5)-

Next, Formula (Ia-5) will be described.

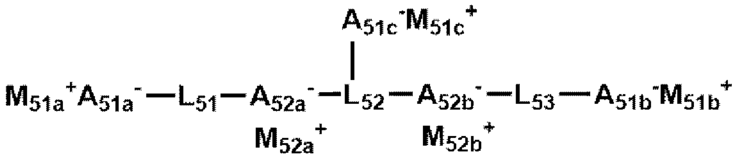

(Ia-5)

In Formula (Ia-5), $A_{51a}^-$, $A_{51b}^-$, and $A_{51c}^-$ each independently represent a monovalent anionic functional group. Here, the monovalent anionic functional group represented by $A_{51a}^-$, $A_{51b}^-$, and $A_{51c}^-$ is intended to be a monovalent group including the above-described anionic moiety $A_1^-$. The monovalent anionic functional group represented by $A_{51a}^-$, $A_{51b}^-$, and $A_{51c}^-$ is not particularly limited, and examples thereof include the monovalent anionic functional group selected from the group consisting of Formulae (AX-1) to (AX-3) described above.

$A_{52a}^-$ and $A_{52b}^-$ represents a divalent anionic functional group. Here, the divalent anionic functional group represented by $A_{52a}^-$ and $A_{52b}^-$ is intended to be a divalent group including the above-described anionic moiety $A_2^-$. Examples of the divalent anionic functional group represented by $A_{52a}^-$ and $A_{52b}^-$ include the divalent anionic functional group selected from the group consisting of Formulae (BX-8) to (BX-11) described above.

$M_{51a}^+$, $M_{51b}^+$, $M_{51c}^+$, $M_{52a}^+$, and $M_{52b}^+$ each independently represent an organic cation. The organic cation represented by $M_{51a}^+$, $M_{51b}^+$, $M_{51c}^+$, $M_{52a}^+$, and $M_{52b}^+$ has the same meaning as $M_1^+$ described above, and a suitable aspect thereof is also the same.

$L_{51}$ and $L_{53}$ each independently represent a divalent organic group. The divalent organic group represented by $L_{51}$ and $L_{53}$ has the same meaning as $L_{21}$ and $L_{22}$ in Formula (Ia-2) described above, and a suitable aspect thereof is also the same.

$L_{52}$ represents a trivalent organic group. The trivalent organic group represented by $L_{52}$ has the same meaning as $L_{41}$ in Formula (Ia-4) described above, and a suitable aspect thereof is also the same.

In addition, in a compound PIa-5 of Formula (Ia-5), in which the organic cation represented by $M_{51a}^+$, $M_{51b}^+$, $M_{51c}^+$, $M_{52a}^+$, and $M_{52b}^+$ is replaced with $H^+$, an acid dissociation constant a2-1 derived from an acidic moiety represented by $A_{52a}H$ and an acid dissociation constant a2-2 derived from an acidic moiety represented by $A_{52b}H$ are larger than an acid dissociation constant a1-1 derived from an acidic moiety represented by $A_{51a}H$, an acid dissociation constant a1-2 derived from an acidic moiety represented by $A_{51b}H$, and an acid dissociation constant a1-3 derived from an acidic moiety represented by $A_{51c}H$. The acid dissociation constants a1-1 to a1-3 correspond to the above-described acid dissociation constant a1, and the acid dissociation constants a2-1 and a2-2 correspond to the above-described acid dissociation constant a2.

$A_{51a}^-$, $A_{51b}^-$, and $A_{51c}^-$ may be the same or different from each other. In addition, $A_{52a}^-$ and $A_{52b}^-$ may be the

same or different from each other. In addition, $M_{51a}^+$, $M_{51b}^+$, $M_{51c}^+$, $M_{52a}^+$, and $M_{52b}^+$ may be the same or different from each other.

In addition, at least one of $M_{51b}^+$, $M_{51c}^+$, $M_{52a}^+$, $M_{52b}^+$, $A_{51a}^-$, $A_{51b}^-$, $A_{51c}^-$, $L_{51}$, $L_{52}$, or $L_{53}$ may have an acid-decomposable group as a substituent.

(Compound (II))

The compound (II) is a compound having two or more of the structural moieties X and one or more of the following structural moieties Z, in which the compound generates an acid including two or more of the above-described first acidic moieties derived from the above-described structural moiety X and a structural moiety Z by irradiation with actinic ray or radiation.

Structural moiety Z: a non-ionic moiety capable of neutralizing an acid

In the compound (II), the definition of the structural moiety X and the definitions of $A_1^-$and $M_1^+$ are the same as the definition of the structural moiety X and the definitions of $A_1^-$ and $M_1^+$ in the above-described compound (I), and suitable aspects thereof are also the same.

In a compound PII formed by replacing the above-described cationic moiety $M_1^+$ in the above-described structural moiety X with $H^+$ in the above-described compound (II), a suitable range of an acid dissociation constant a1 derived from the acidic moiety represented by $HA_1$, formed by replacing the above-described cationic moiety $M_1^+$ in the above-described structural moiety X with $H^+$, is the same as in the acid dissociation constant a1 of the above-described compound PI.

In a case where the compound (II) is, for example, a compound which generates an acid having two of the above-described first acidic moieties derived from the above-described structural moiety X and the above-described structural moiety Z, the compound PII corresponds to "compound having two $HA_1$". In a case of obtaining acid dissociation constants of the compound PII, an acid dissociation constant in a case where the compound PII is to be "compound having one $A_1^-$ and one $HA_1$" and an acid dissociation constant in a case where the "compound having one $A_1^-$ and one $HA_1$" is to be "compound having two $A_1^-$" correspond to the acid dissociation constant a1.

The acid dissociation constant a1 can be obtained by the above-described method for measuring an acid dissociation constant.

The above-described compound PII corresponds to an acid generated in a case where the compound (II) is irradiated with actinic ray or radiation.

The above-described two or more of the structural moieties X may be the same or different from each other. In addition, two or more of $A_1^-$'s and two or more of $M_1^+$ may be the same or different from each other.

The non-ionic moiety capable of neutralizing an acid in the structural moiety Z is not particularly limited, and is preferably, for example, a moiety including a functional group having a group or an electron which is capable of electrostatically interacting with a proton.

Examples of the functional group having a group or electron capable of electrostatically interacting with a proton include a functional group with a macrocyclic structure, such as a cyclic polyether, or a functional group having a nitrogen atom having an unshared electron pair not contributing to $\pi$-conjugation. For example, the nitrogen atom having the unshared electron pair, which does not contribute to the $\pi$-conjugation, is a nitrogen atom having a partial structure represented by the following formula.

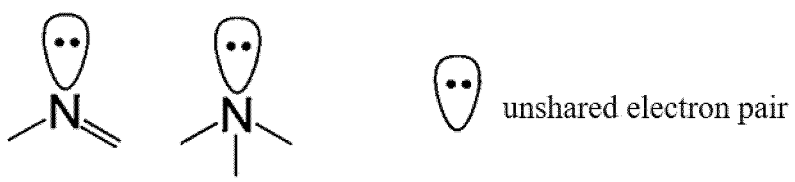


Examples of the partial structure of the functional group having a group or electron which is capable of electrostatically interacting with a proton include a crown ether structure, an azacrown ether structure, primary to tertiary amine structures, a pyridine structure, an imidazole structure, and a pyrazine structure, and among these, primary to tertiary amine structures are preferable.

The compound (II) is not particularly limited, and examples thereof include compounds represented by Formula (IIa-1) and Formula (IIa-2).

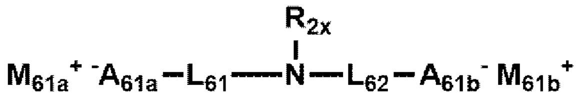

(IIa-1)

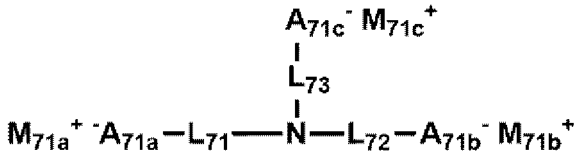

(IIa-2)

In Formula (IIa-1), $A_{61a}^-$ and $A_{61b}^-$ have the same meaning as $A_{11}^-$ in Formula (Ia-1) described above, and suitable aspects thereof are also the same. In addition, $M_{61a}^+$ and $M_{61b}^+$ have the same meaning as $M_{11}^+$ in Formula (Ia-1) described above, and suitable aspects thereof are also the same.

In Formula (IIa-1), $L_{61}$ and $L_{62}$ have the same meaning as $L_1$ in Formula (Ia-1) described above, and suitable aspects thereof are also the same.

In Formula (IIa-1), $R_{2X}$ represents a monovalent organic group. The monovalent organic group represented by $R_{2X}$ is not particularly limited, and examples thereof include an alkyl group (which preferably has 1 to 10 carbon atoms, and may be linear or branched), a cycloalkyl group (preferably having 3 to 15 carbon atoms), and an alkenyl group (preferably having 2 to 6 carbon atoms), in which $-CH_2-$ may be substituted with one or a combination of two or more selected from the group consisting of -CO-, -NH-, -O-, -S-, -SO-, and $-SO_2-$.

In addition, the above-described alkylene group, the above-described cycloalkylene group, and the above-described alkenylene group may have a substituent. The substituent is not particularly limited, and examples thereof include a halogen atom (preferably, a fluorine atom).

In addition, in a compound PIIa-1 of Formula (IIa-1), in which the organic cation represented by $M_{61a}^+$ and $M_{61b}^+$ is replaced with $H^+$, an acid dissociation constant a1-7 derived from an acidic moiety represented by $A_{61a}H$ and an acid dissociation constant a1-8 derived from an acidic moiety represented by $A_{61b}H$ correspond to the above-described acid dissociation constant a1.

The compound PIIa-1 formed by replacing the above-described cationic moieties $M_{61a}^+$ and $M_{61b}^+$ in the above-described structural moiety X with $H^+$ in the above-described compound (IIa-1) corresponds to $HA_{61a}-L_{61}-N(R_{2X})-L_{62}-A_{61b}H$. In addition, the acid generated from the compound PIIa-1 and the acid generated from the compound represented by Formula (IIa-1) by irradiation with actinic ray or radiation are the same.

In addition, at least one of $M_{61a}^+$, $M_{61b}^+$, $A_{61a}^-$, $A_{61b}^-$, $L_{61}$, $L_{62}$, or $R_{2X}$ may have an acid-decomposable group as a substituent.

In Formula (IIa-2), $A_{71a}^-$, $A_{71b}^-$, and $A_{71c}^-$ have the same meaning as $A_{11}^-$ in Formula (Ia-1) described above, and suitable aspects thereof are also the same. In addition, $M_{71a}^+$, $M_{71b}^+$, and $M_{71c}^+$ have the same meaning as $M_{11}^+$ in Formula (Ia-1) described above, and suitable aspects thereof are also the same.

In Formula (IIa-2), $L_{71}$, $L_{72}$, and $L_{73}$ have the same meaning as $L_1$ in Formula (Ia-1) described above, and suitable aspects thereof are also the same.

In addition, in a compound PIIa-2 of Formula (IIa-2), in which the organic cation represented by $M_{71a}^+$, $M_{71b}^+$, and $M_{71c}^+$ is replaced with $H^+$, an acid dissociation constant a1-9 derived from an acidic moiety represented by $A_{71a}H$, an acid dissociation constant a1-10 derived from an acidic moiety represented by $A_{71b}H$, and an acid dissociation constant a1-11 derived from an acidic moiety represented by $A_{71c}H$ correspond to the above-described acid dissociation constant a1.

The compound PIIa-2 formed by replacing the above-described cationic moieties $M_{71a}^+$,$M_{71b}^+$, and $M_{71c}^+$ in the above-described structural moiety X with $H^+$ in the above-described compound (IIa-1) corresponds to $HA_{71a}-L_{71}-N(L_{73}-A_{71c}H)-L_{72}-A_{71b}H$. In addition, the acid generated from the compound PIIa-2 and the acid generated from the compound represented by Formula (IIa-2) by irradiation with actinic ray or radiation are the same.

In addition, at least one of $M_{71a}^+$, $M_{71b}^+$, $M_{71c}^+$, $A_{71a}^-$, $A_{71b}^-$, $A_{71c}^-$, $L_{71}$, $L_{72}$, or $L_{73}$ may have an acid-decomposable group as a substituent.

Anionic moieties which can be included in the compound (I) and the compound (II) are shown below, but the present invention is not limited thereto.

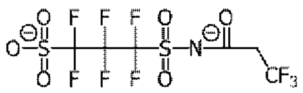
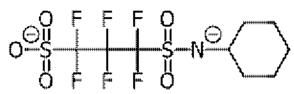
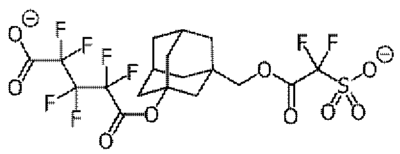
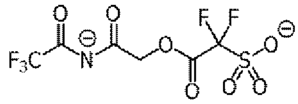
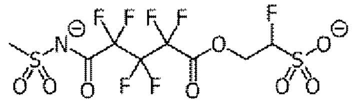
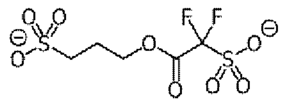
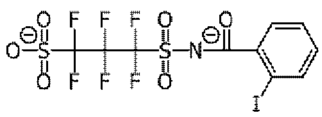
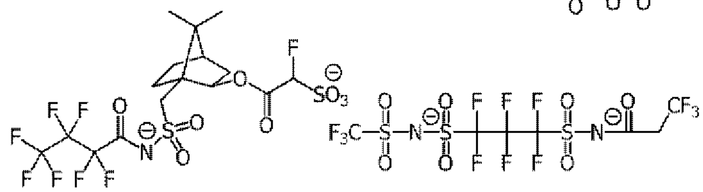
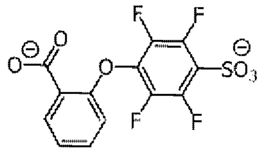
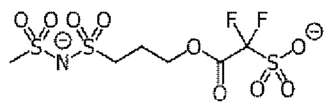
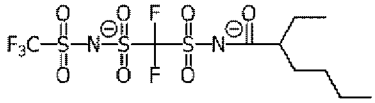
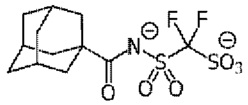
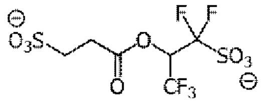
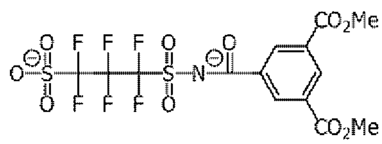
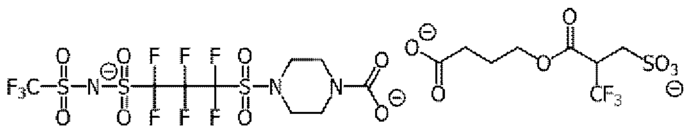
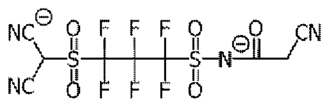
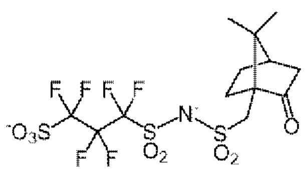
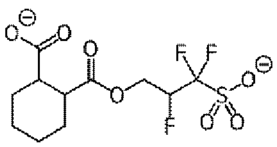
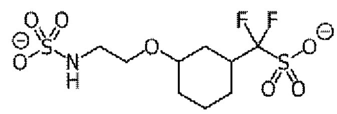
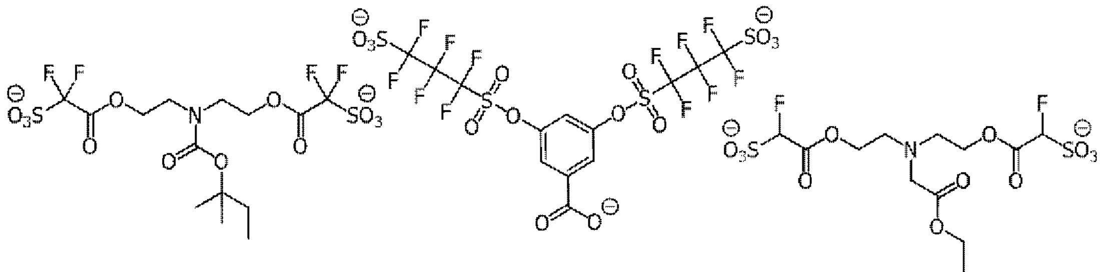
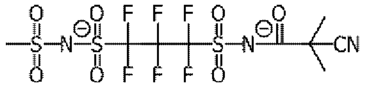

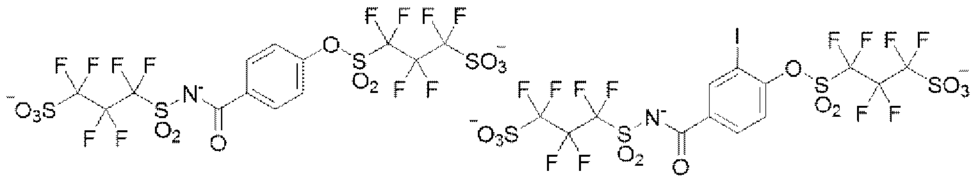

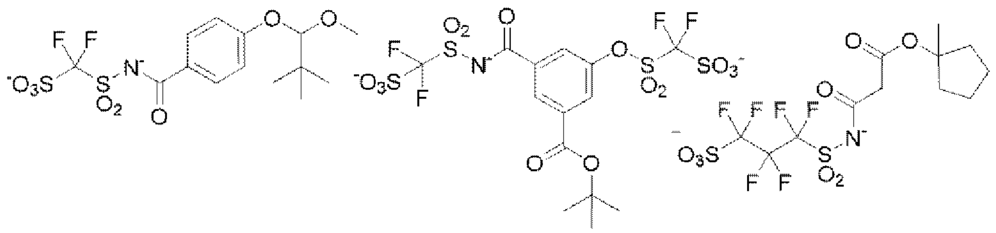

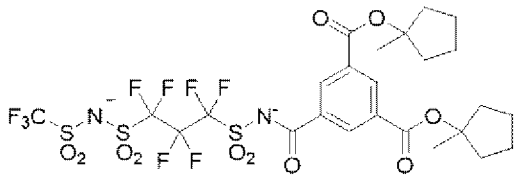

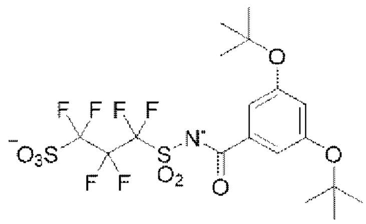

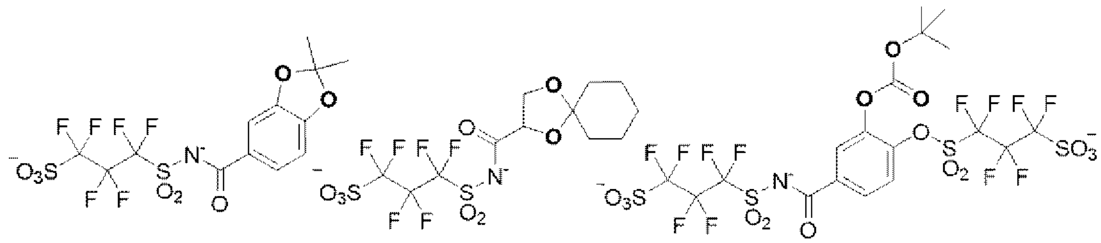

As the compound (B), for example, it is also preferable to use photoacid generators described in paragraphs [0135] to [0171] of WO2018/193954A, paragraphs [0077] to [0116] of WO2020/066824A, and paragraphs [0018] to [0075] and [0334] and [0335] of WO2017/154345A.

A content of the compound (B) in the resist composition is not particularly limited, but from the viewpoint of making the cross-sectional shape of the formed pattern more rectangular, it is preferably 1% by mass or more, more preferably 5% by mass or more, and still more preferably 10% by mass or more with respect to the total solid content of the resist composition. In addition, the content of the compound (B) is preferably 80% by mass or less, more preferably 70% by mass or less, and still more preferably 60% by mass or less with respect to the total solid content of the resist composition.

The compound (B) may be used alone or in combination of two or more kinds thereof.

In addition, the compound (B) may be the following compound (X).

<Compound (X)>

The compound (X) is a salt containing a cation (specific cation) represented by Formula (X).

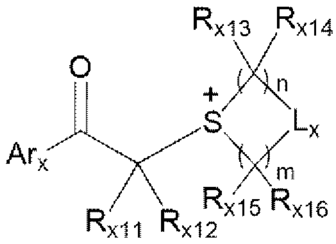

(X)

In Formula (X), Arx represents an aryl group substituted with a group containing a halogen atom.
The aryl group represented by $Ar_x$ may be monocyclic or polycyclic. In addition, the above-described aryl group may be a heterocyclic ring containing an oxygen atom, a nitrogen atom, a sulfur atom, or the like.
Examples of the above-described heterocyclic ring include a pyrrole ring, a furan ring, a thiophene ring, an indole ring, a benzofuran ring, and a benzothiophene ring.
The number of carbon atoms in the above-described aryl group (the number of carbon atoms in Arx) is preferably 6 to 20, more preferably 6 to 15, and still more preferably 6 to 10.
The group containing a halogen atom means the halogen atom itself and a group which contains a halogen atom as a part of a substituent.
Examples of the halogen atom include a fluorine atom, a chlorine atom, a bromine atom, and an iodine atom, and a fluorine atom or an iodine atom is preferable.
Examples of the group containing a halogen atom include a halogen atom, an alkyl halide group, alkoxy halide group, and an aryl halide group.
The number of halogen atoms contained in the above-described aryl group is preferably 1 to 20, more preferably 1 to 15, and still more preferably 1 to 10.
The number of groups containing a halogen atom, which are included in the above-described aryl group, is preferably 1 to 10, more preferably 1 to 5, and still more preferably 1 to 3.
The above-described aryl group may be further substituted with a group not containing a halogen atom, in addition to the group containing a halogen atom. As the above-described group not containing a halogen atom, an alkyl group (preferably having 1 to 6 carbon atoms), an alkoxy group, or an alkoxycarbonyl group is preferable, and an alkyl group (preferably having 1 to 6 carbon atoms) or an alkoxy group (preferably having 1 to 6 carbon atoms) is more preferable.
The above-described aryl group is preferably a phenyl group or a naphthyl group, and more preferably a phenyl group.
Rxn to $R_{X16}$ each independently represent a hydrogen atom or a hydrocarbon group.
At least one of $R_{X11}$ or $R_{X12}$ is preferably a hydrocarbon group. $R_{X13}$ to $R_{X16}$ preferably represent hydrogen atoms.
The above-described hydrocarbon group may be linear, branched, or cyclic.
Examples of the above-described hydrocarbon group include an alkyl group, a cycloalkyl group, an alkenyl group, and an aryl group, and an alkyl group is preferable.
The number of carbon atoms in the above-described hydrocarbon group is preferably 1 to 20, more preferably 1 to 10, and still more preferably 1 to 5.
$R_{X11}$ and $R_{X12}$ may be bonded to each other to form a ring, and $R_{X11}$ and at least one of $R_{X13}$ to $R_{X16}$, or $R_{X12}$ and at least one of $R_{X13}$ to $R_{X16}$ may be bonded to each other to form a ring.

n and m each independently represent an integer of 1 or more.
n and m are preferably 1 to 10, more preferably 1 to 5, still more preferably 1 to 3, and particularly preferably 2. In addition, it is preferable that n and m represent the same integer.

In a case where n represents an integer of 2 or more, two or more $R_{X13}$'s and two or more $R_{X14}$'s may be the same or different from each other. In addition, in a case where m represents an integer of 2 or more, two or more $R_{X15}$'s and two or more $R_{X16}$'s may be the same or different from each other.
Lx represents a divalent linking group.
Examples of the divalent linking group include -CO-, $-NR_A-$, -O-, -S-, -SO-, $-SO_2-$, $-N(SO_2-R_A)-$, an alkylene group, a cycloalkylene group, an alkenylene group, and a divalent linking group formed by a combination of a plurality of these groups. Among these, a divalent linking group containing an oxygen atom is preferable.
Examples of the divalent linking group containing an oxygen atom include -CO-, -O-, -SO-, $-SO_2-$, $-N(SO_2-R_A-)$,

and a divalent linking group formed by a combination of a plurality of these groups. Examples of $R_A$ include a hydrogen atom and an alkyl group having 1 to 6 carbon atoms.

Among these, as the divalent linking group containing an oxygen atom, -O-, -CO-, or $-N(SO_2-R_A)-$ is preferable, and -O- or -CO- is more preferable.

The divalent linking group containing an oxygen atom means the oxygen atom itself and a divalent linking group which contains an oxygen atom as a part of the divalent linking group.

The number of oxygen atoms contained in the divalent linking group containing an oxygen atom is preferably 1 to 3, more preferably 1 or 2, and still more preferably 1.

The specific cation is preferably a cation represented by Formula (X-1).

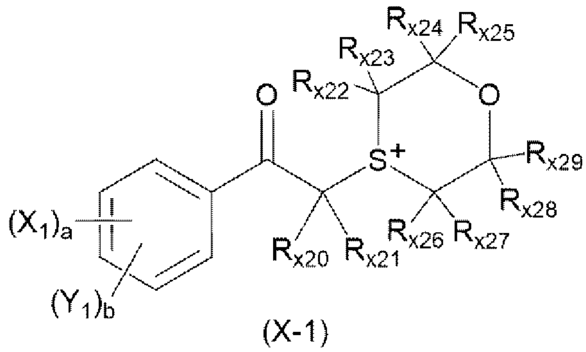

(X-1)

In Formula (X-1), $X_1$ represents a group containing a halogen atom.

$X_1$ is the same as the group containing a halogen atom, which is included in $Ar_x$ of Formula (X) described above, and a suitable aspect thereof is also the same.

$Y_1$ represents a group not containing a halogen atom.

As the above-described group not containing a halogen atom, an alkyl group (preferably having 1 to 6 carbon atoms), an alkoxy group, or an alkoxycarbonyl group is preferable, and an alkyl group (preferably having 1 to 6 carbon atoms) or an alkoxy group is more preferable.

The group not containing a halogen atom means a group which does not contain a halogen atom as a part of a substituent. That is, $Y_1$ represents a group other than the group containing a halogen atom, represented by $X_1$.

a represents an integer of 1 to 5, b represents an integer of 0 to 4, and a + b is 1 to 5.
a is preferably 1 to 4. b is preferably 1 to 4.

$R_{X20}$ to $R_{X29}$ each independently represent a hydrogen atom or a hydrocarbon group.

$R_{X20}$ and $R_{X21}$ are the same as $R_{X11}$ and $R_{X12}$ of Formula (X) described above, and suitable aspects thereof are also the same.

The hydrocarbon group represented by $R_{X22}$ to $R_{X29}$ may be linear, branched, or cyclic.

Examples of the above-described hydrocarbon group represented by $R_{X22}$ to $R_{X29}$ include an alkyl group, a cycloalkyl group, an alkenyl group, and an aryl group, and an alkyl group is preferable.

The number of carbon atoms in the hydrocarbon group represented by $R_{X22}$ to $R_{X29}$ is preferably 1 to 20, more preferably 1 to 10, and still more preferably 1 to 5.

$R_{X20}$ and $R_{X21}$ may be bonded to each other to form a ring, and $R_{20}$ and at least one of $R_{X22}$ to $R_{X25}$, or $R_{X21}$ and at least one of $R_{X26}$ to $R_{X29}$ may be bonded to each other to form a ring.

The specific cation may be used alone or in combination of two or more kinds thereof.

A molecular weight of the compound (X) is preferably 100 to 10,000, more preferably 100 to 2,500, and still more preferably 100 to 1,500.

A preferred range of the content of the compound (X) is the same as the preferred range of the content of the compound (B) described above.

The compound (X) may be used alone or in combination of two or more kinds thereof. In a case where two or more kinds of the compounds are used, a total content thereof is preferably within the suitable content range.

Specific examples of the compound (X) are shown below, but the present invention is not limited thereto.

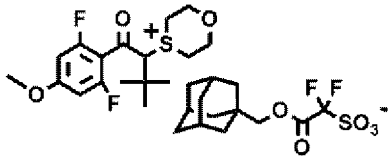

X-1

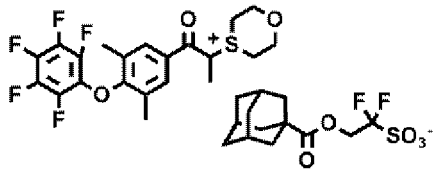

X-2

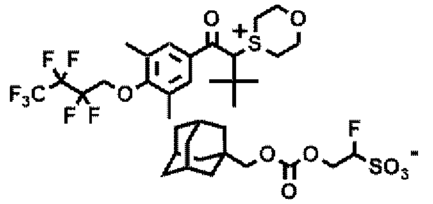

X-3

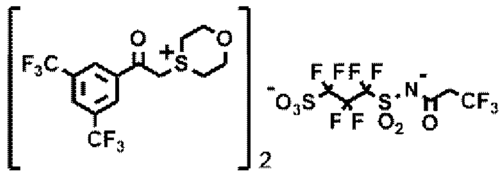

X-4

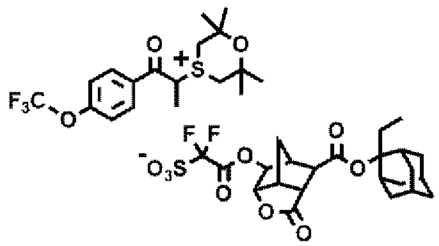

X-5

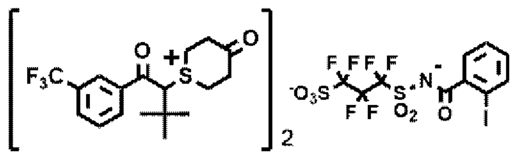

X-6

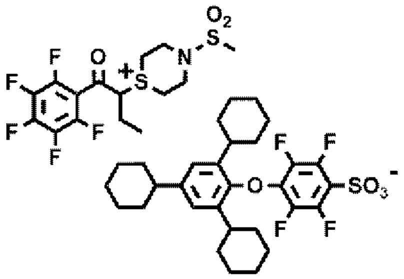

X-7

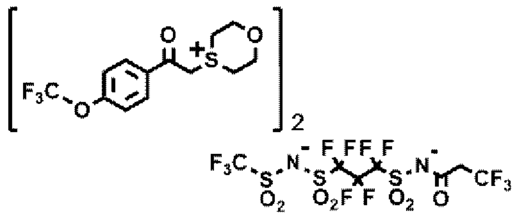

X-8

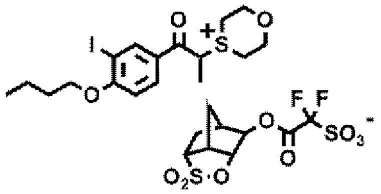

X-9

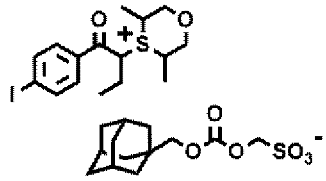

X-10

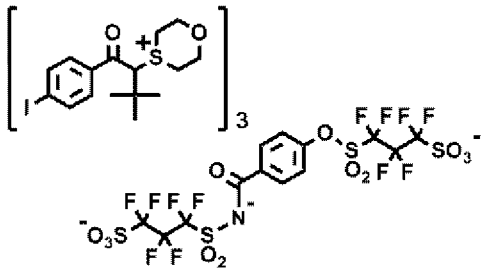

X-11

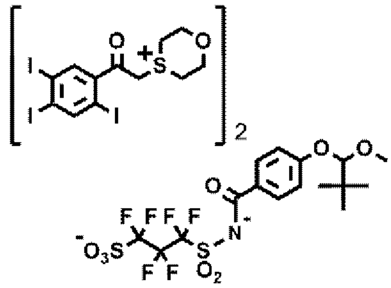

X-12

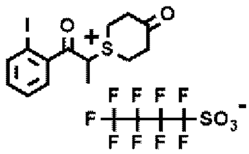

X-13

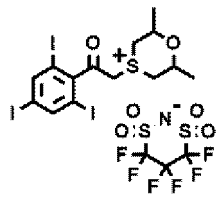

X-14

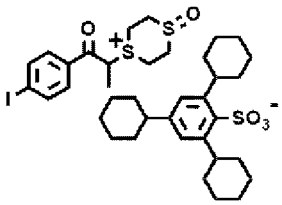

X-15

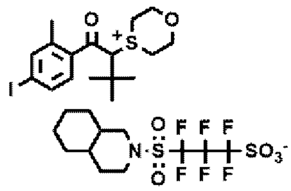

X-16

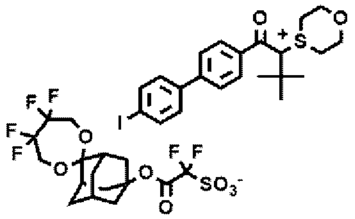

X-17

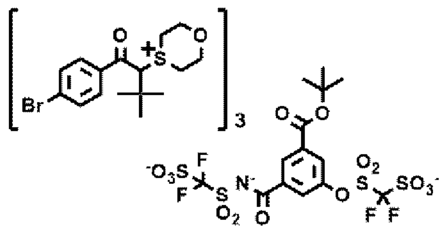

X-18

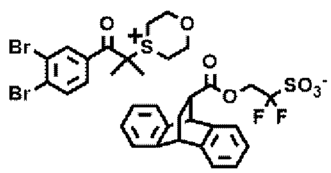

X-19

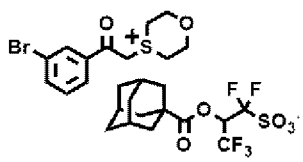

X-20

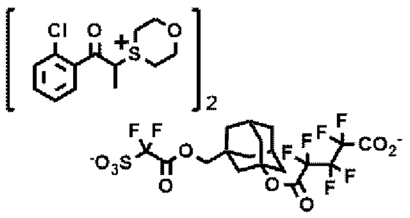

X-21

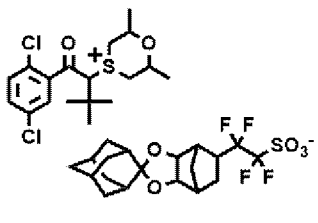

X-22

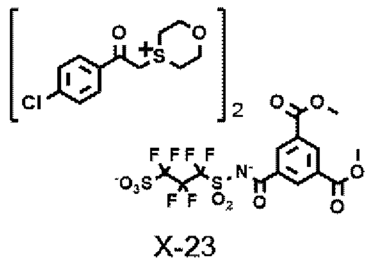

X-23

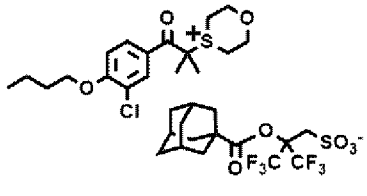

X-24

[Acid Diffusion Control Agent]

The resist composition may contain an acid diffusion control agent.

The acid diffusion control agent acts as a quencher which suppresses a reaction of an acid-decomposable resin in a non-exposed portion by excessive generated acids by trapping the acids generated from the photoacid generator and the like during exposure.

Examples of the acid diffusion control agent include a basic compound (CA), a low-molecular-weight compound (CB) having a nitrogen atom and a group which is eliminated by action of acid, and a compound (CC) in which ability to control acid diffusion decreases or disappears in a case of being irradiated with actinic ray or radiation.

Examples of the above-described compound (CC) include an onium salt compound (CD) which is a relatively weak acid with respect to the photoacid generator, and a basic compound (CE) in which basicity decreases or disappears in a case of being irradiated with actinic ray or radiation.

As the acid diffusion control agent, a known acid diffusion control agent can be appropriately used.

For example, as the acid diffusion control agent, known compounds described in paragraphs [0627] to [0664] of US2016/0070167A1, paragraphs [0095] to [0187] of US2015/0004544A1, paragraphs [0403] to [0423] of US2016/0237190A1, and paragraphs [0259] to [0328] of US2016/0274458A1 can be suitably used.

In addition, specific examples of the basic compound (CA) include compounds described in paragraphs [0132] to [0136] of WO2020/066824A; specific examples of the basic compound (CD) in which basicity decreases or disappears in a case of being irradiated with actinic ray or radiation include compounds described in paragraphs [0137] to [0155] of WO2020/066824A; specific examples of the low-molecular-weight compound (CB) having a nitrogen atom and a group which is eliminated by action of acid include paragraphs [0156] to [0163] of WO2020/066824A; and specific examples of the onium salt compound (CE) having a nitrogen atom in the cationic moiety include paragraph [0164] of WO2020/066824A.

In addition, specific examples of the onium salt compound (CD) which is a relatively weak acid with respect to the photoacid generator include compounds described in paragraphs [0305] to [0314] of WO2020/158337A, paragraphs [0455] to [0464] of WO2020/158467A, paragraphs [0298] to [0307] of WO2020/158366A, and paragraphs [0357] to [0366] of WO2020/158417A.

In a case where the resist composition contains the acid diffusion control agent, a content of the acid diffusion control agent (in a case of a plurality of types, the total thereof) is preferably 0.1% to 15.0% by mass, and more preferably 1.0% to 15.0% by mass with respect to the total solid content of the composition.

In the resist composition, the acid diffusion control agent may be used alone or in combination of two or more kinds thereof.

[Hydrophobic Resin (D)]

The resist composition may further contain a hydrophobic resin different from the resin (A).

Although it is preferable that the hydrophobic resin is designed to be unevenly distributed on a surface of the resist film, it is not necessary to have a hydrophilic group in the molecule as different from a surfactant, and is not

necessary to contribute to uniform mixing of polar materials and non-polar materials.

Examples of an effect caused by the addition of the hydrophobic resin include a control of static and dynamic contact angles of a surface of the resist film with respect to water and suppression of outgas.

From the viewpoint of uneven distribution on the film surface layer, the hydrophobic resin preferably has any one or more of a fluorine atom, a silicon atom, and a $CH_3$ partial structure which is included in a side chain moiety of a resin, and more preferably has two or more kinds thereof. In addition, the above-described hydrophobic resin preferably has a hydrocarbon group having 5 or more carbon atoms. These groups may be included in the main chain of the resin or may be substituted in the side chain of the resin.

Examples of the hydrophobic resin include compounds described in paragraphs [0275] to [0279] of WO2020/004306A.

In a case where the resist composition contains a hydrophobic resin, a content of the hydrophobic resin is preferably 0.01% to 20.0% by mass, and more preferably 0.1% to 15.0% by mass with respect to the total solid content of the resist composition.

[Surfactant (E)]

The resist composition may contain a surfactant. In a case where the surfactant is included, it is possible to form a pattern having more excellent adhesiveness and fewer development defects.

The surfactant is preferably a fluorine-based and/or silicon-based surfactant.

Examples of the fluorine-based and/or silicon-based surfactant include surfactants described in paragraphs [0218] and [0219] of WO2018/19395A.

The surfactant may be used alone or in combination of two or more kinds thereof.

In a case where the resist composition contains a surfactant, a content of the surfactant is preferably 0.0001% to 2.0% by mass, more preferably 0.0005% to 1.0% by mass, and still more preferably 0.1% to 1.0% by mass with respect to the total solid content of the composition.

[Other Additives]

The resist composition may further contain a dissolution inhibiting compound, a dye, a plasticizer, a photosensitizer, a light absorbing agent, and/or a compound promoting a solubility in a developer (for example, a phenol compound having a molecular weight of 1000 or less or an alicyclic or aliphatic compound including a carboxy group), or the like.

The resist composition may further contain a dissolution inhibiting compound. Here, the "dissolution inhibiting compound" is intended to be a compound having a molecular weight of 3000 or less, in which solubility in an organic developer decreases by decomposition due to action of acid.

The resist composition according to the embodiment of the present invention is suitably used as a photosensitive composition for EUV light.

Since the EUV light has a wavelength of 13.5 nm and has a shorter wavelength than that of ArF (wavelength: 193 nm), the number of incident photons in a case of being exposed with the same sensitivity is small. Therefore, influence of "photon shot noise" in which the number of photons varies probabilistically is large, which causes deterioration of LER and bridge defects. In order to reduce the photon shot noise, there is a method of increasing the number of incident photons by increasing an exposure amount, but there is a trade-off with the demand for higher sensitivity.

In a case where an A value obtained by Expression (1) is high, absorption efficiency of EUV light and electron beams of the resist film formed from the resist composition is high, which is effective in reducing the photon shot noise. The A value represents the absorption efficiency of EUV light and electron beams of the resist film in terms of a mass proportion.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

The A value is preferably 0.120 or more. An upper limit thereof is not particularly limited, but in a case where the A value is extremely high, the transmittance of EUV light and electron beams of the resist film is lowered and the optical image profile in the resist film is deteriorated, which results in difficulty in obtaining a good pattern shape, and therefore, the upper limit is preferably 0.240 or less, and more preferably 0.220 or less.

In Expression (1), [H] represents a molar ratio of hydrogen atoms derived from a total solid content with respect to all atoms of the total solid content in the actinic ray-sensitive or radiation-sensitive resin composition, [C] represents a molar ratio of carbon atoms derived from the total solid content with respect to all the atoms of the total solid content

in the actinic ray-sensitive or radiation-sensitive resin composition, [N] represents a molar ratio of nitrogen atoms derived from the total solid content with respect to all the atoms of the total solid content in the actinic ray-sensitive or radiation-sensitive resin composition, [O] represents a molar ratio of oxygen atoms derived from the total solid content with respect to all the atoms of the total solid content in the actinic ray-sensitive or radiation-sensitive resin composition, [F] represents a molar ratio of fluorine atoms derived from the total solid content with respect to all the atoms of the total solid content in the actinic ray-sensitive or radiation-sensitive resin composition, [S] represents a molar ratio of sulfur atoms derived from the total solid content with respect to all the atoms of the total solid content in the actinic ray-sensitive or radiation-sensitive resin composition, and [I] represents a molar ratio of iodine atoms derived from the total solid content with respect to all the atoms of the total solid content in the actinic ray-sensitive or radiation-sensitive resin composition.

For example, in a case where the resist composition includes a resin (acid-decomposable resin) having polarity that increases by action of acid, a photoacid generator, an acid diffusion control agent, and a solvent, the resin, the photoacid generator, and the acid diffusion control agent correspond to the solid content. That is, all the atoms of the total solid content correspond to a sum of all the atoms derived from the resin, all the atoms derived from the photoacid generator, and all the atoms derived from the acid diffusion control agent. For example, [H] represents a molar ratio of hydrogen atoms derived from the total solid content with respect to all the atoms in the total solid content, and by way of description based on the example above, [H] represents a molar ratio of a sum of the hydrogen atoms derived from the resin, the hydrogen atoms derived from the photoacid generator, and the hydrogen atoms derived from the acid diffusion control agent with respect to a sum of all the atoms derived from the resin, all the atoms derived from the photoacid generator, and all the atoms derived from the acid diffusion control agent.

The A value can be calculated by computation of the structure of constituent components of the total solid content in the resist composition, and the ratio of the number of atoms contained in a case where the content is already known. In addition, even in a case where the constituent component is not known yet, it is possible to calculate a ratio of the number of constituent atoms by subjecting a resist film obtained after evaporating the solvent components of the resist composition to computation according to an analytic approach such as elemental analysis.

[Method for Manufacturing Electronic Device]

In addition, the present invention further relates to a method for manufacturing an electronic device, including the above-described pattern forming method, and an electronic device manufactured by this manufacturing method.

Examples of a suitable aspect of the electronic device according to the embodiment of the present invention include an aspect of being mounted on electric and electronic apparatus (for example, home appliances, office automation (OA)-related equipment, media-related equipment, optical equipment, telecommunication equipment, and the like).

## Examples

Hereinbelow, the present invention will be described in more detail with reference to Examples. The materials, the amounts of materials used, the proportions, the treatment details, and the treatment procedure in Examples below may be appropriately modified as long as the modifications do not depart from the spirit of the present invention. Therefore, the scope of the present invention should not be construed as being limited to Examples shown below.

[Various Components of Resist Composition]

[Resin]

As resins Pol-1 to Pol-32, those synthesized according to a known method were used. A ratio (content ratio (% by mole)) of each repeating unit, a weight-average molecular weight (Mw), and a dispersity (Mw/Mn) are shown in Tables 1 and 2.

The weight-average molecular weight (Mw) and the dispersity (Mw/Mn) of the resins Pol-01 to Pol-32 were measured by GPC (carrier: tetrahydrofuran (THF)) (an amount expressed in terms of polystyrene). In addition, the ratio of each unit was measured by means of $^{13}C$-nuclear magnetic resonance (NMR).

[Table 1]

| Resin | First unit | Ratio of first unit (% by mole) | Second unit | Ratio of second unit (% by mole) | Third unit | Ratio of third unit (% by mole) | Fourth unit | Ratio of fourth unit (% by mole) | Mw | Mw/Mn |
|---|---|---|---|---|---|---|---|---|---|---|
| Pol-01 | U-01 | 50 | U-19 | 50 | - | - | - | - | 8700 | 1.23 |
| Pol-02 | U-02 | 60 | U-26 | 10 | U-21 | 30 | - | - | 12700 | 1.40 |
| Pol-03 | U-03 | 40 | U-25 | 30 | U-23 | 30 | - | - | 14000 | 1.45 |
| Pol-04 | U-04 | 65 | U-24 | 15 | U-22 | 20 | - | - | 11300 | 1.32 |
| Pol-05 | U-05 | 35 | U-29 | 15 | U-20 | 50 | - | - | 7300 | 1.44 |
| Pol-06 | U-06 | 45 | U-28 | 35 | U-35 | 20 | - | - | 11700 | 1.22 |
| Pol-07 | U-07 | 55 | U-27 | 10 | U-37 | 35 | - | - | 6200 | 1.45 |
| Pol-08 | U-08 | 65 | U-34 | 35 | - | - | - | - | 15000 | 1.40 |
| Pol-09 | U-09 | 70 | U-32 | 30 | - | - | - | - | 15000 | 1.34 |
| Pol-10 | U-10 | 35 | U-30 | 5 | U-19 | 60 | - | - | 10300 | 1.21 |
| Pol-11 | U-11 | 65 | U-20 | 30 | U-33 | 5 | - | - | 15800 | 1.46 |
| Pol-12 | U-12 | 70 | U-21 | 30 | - | - | - | - | 13000 | 1.49 |
| Pol-13 | U-13 | 40 | U-24 | 20 | U-22 | 40 | - | - | 10100 | 1.28 |
| Pol-14 | U-01 | 30 | U-25 | 10 | U-23 | 30 | U-09 | 30 | 14000 | 1.56 |
| Pol-15 | U-03 | 45 | U-35 | 55 | - | - | - | - | 15300 | 1.25 |
| Pol-16 | U-05 | 35 | U-37 | 15 | U-38 | 30 | U-10 | 20 | 12600 | 1.53 |
| Pol-17 | U-07 | 65 | U-28 | 35 | - | - | - | - | 11500 | 1.29 |
| Pol-18 | U-09 | 40 | U-30 | 50 | U-31 | 10 | - | - | 14700 | 1.50 |
| Pol-19 | U-11 | 50 | U-30 | 50 | - | - | - | - | 15500 | 1.45 |
| Pol-20 | U-13 | 45 | U-33 | 30 | U-36 | 25 | - | - | 6200 | 1.58 |
| Pol-21 | U-14 | 40 | U-19 | 60 | - | - | - | - | 12100 | 1.40 |

(continued)

| Resin | First unit | Ratio of first unit (% by mole) | Second unit | Ratio of second unit (% by mole) | Third unit | Ratio of third unit (% by mole) | Fourth unit | Ratio of fourth unit (% by mole) | Mw | Mw/Mn |
|---|---|---|---|---|---|---|---|---|---|---|
| Pol-22 | U-15 | 50 | U-30 | 10 | U-19 | 40 | - | - | 10100 | 1.46 |
| Pol-23 | U-16 | 65 | U-25 | 20 | U-23 | 15 | - | - | 10100 | 1.59 |
| Pol-24 | U-17 | 50 | U-35 | 50 | - | - | - | - | 8800 | 1.23 |
| Pol-25 | U-18 | 40 | U-33 | 30 | U-36 | 30 | - | - | 8900 | 1.53 |
| Pol-26 | U-19 | 50 | U-20 | 50 | - | - | - | - | 11500 | 1.20 |

[Table 2]

| Resin | First unit | Ratio of first unit (% by mole) | Second unit | Ratio of second unit (% by mole) | Third unit | Ratio of third unit (% by mole) | Fourth unit | Ratio of fourth unit (% by mole) | Fifth unit | Ratio of fifth unit (% by mole) | Mw | Mw/Mn |
|---|---|---|---|---|---|---|---|---|---|---|---|---|
| Pol-27 | U-02 | 30 | U-10 | 30 | U-29 | 20 | U-35 | 20 | - | - | 11300 | 1.32 |
| Pol-28 | U-42 | 25 | U-43 | 35 | U-19 | 35 | U-38 | 5 | - | - | 7300 | 1.44 |
| Pol-29 | U-42 | 60 | U-19 | 20 | U-26 | 20 | - | - | - | - | 11700 | 1.22 |
| Pol-30 | U-40 | 25 | U-04 | 30 | U-20 | 30 | U-26 | 15 | - | - | 6200 | 1.45 |
| Pol-31 | U-41 | 25 | U-04 | 20 | U-45 | 10 | U-44 | 10 | U-19 | 35 | 10100 | 1.28 |
| Pol-32 | U-41 | 33 | U-03 | 14 | U-39 | 2 | U-28 | 16 | U-19 | 35 | 10100 | 1.28 |

Structural formulae of the repeating units (units) shown in Tables 1 and 2 are shown below.

U-01
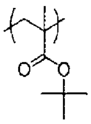
U-02
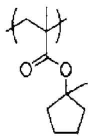
U-03
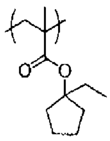
U-04
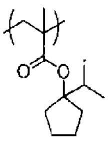
U-05
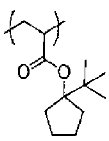
U-06
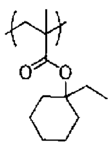
U-07
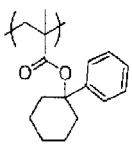

U-08
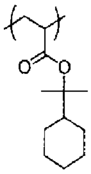
U-09
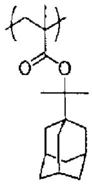
U-10
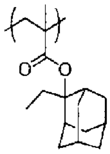
U-11
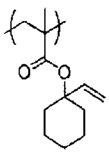
U-12
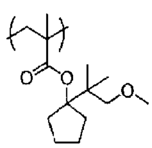
U-13
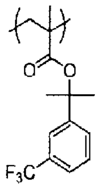
U-14
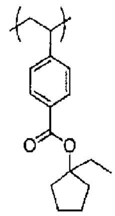
U-15
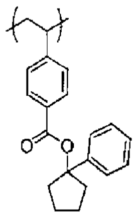

U-16
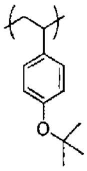
U-17
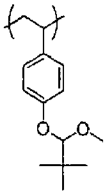
U-18
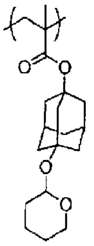
U-19
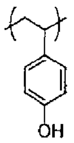
U-20
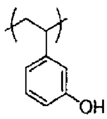
U-21
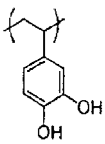
U-22
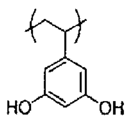
U-23
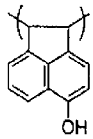

U-24
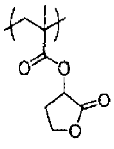
U-25
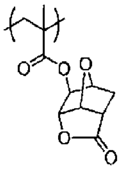
U-26
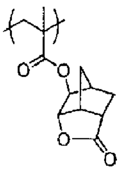
U-27
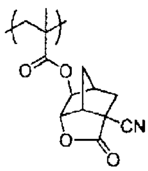
U-28
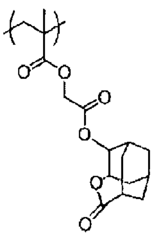
U-29
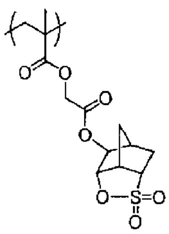

U-30
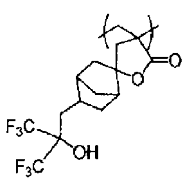
U-31
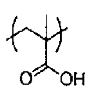
U-32
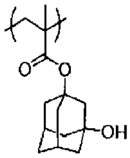
U-33
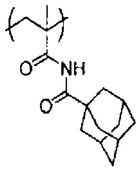
U-34
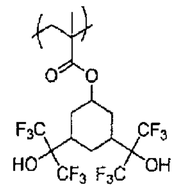

U-35
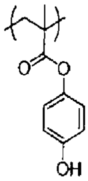
U-36
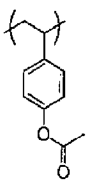
U-37
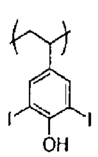
U-38
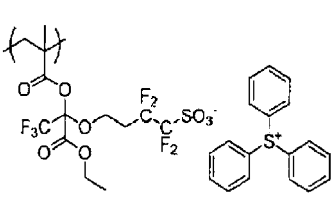

U-39

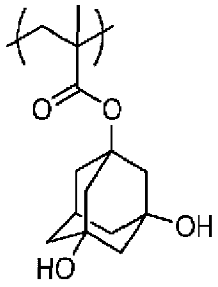

U-40

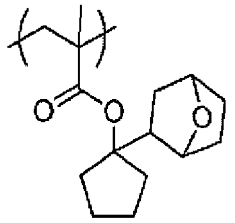

U-41

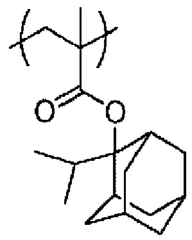

U-42

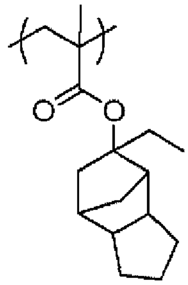

U-43

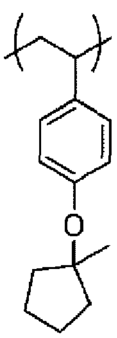

U-44

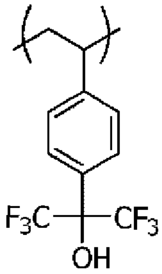

U-45

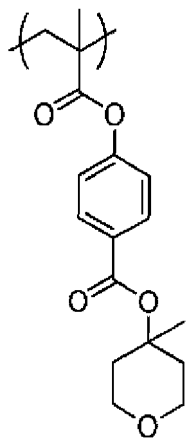

[Photoacid Generator]

Structures of photoacid generators (PAG-1 to PAG-27) used are shown below.

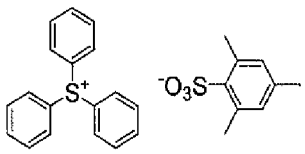

PAG-1

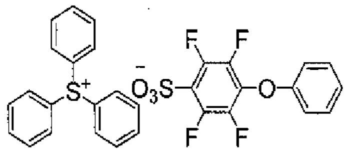

PAG-2

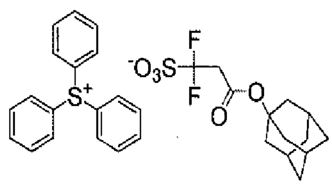

PAG-3

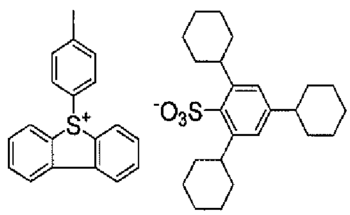

PAG-4

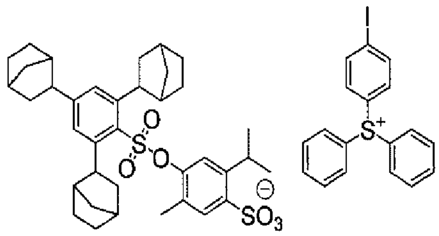

PAG-5

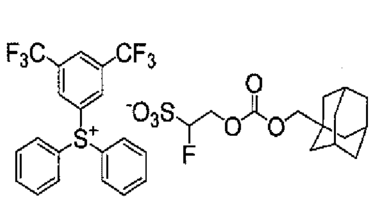

PAG-6

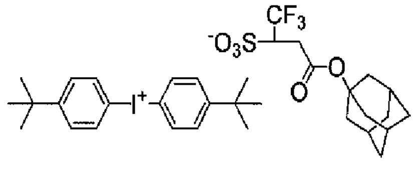

PAG-7

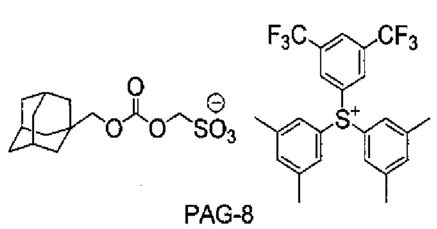

PAG-8

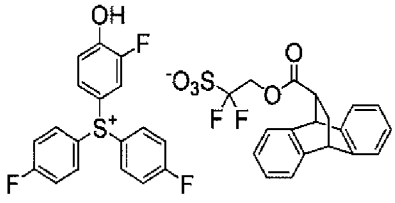

PAG-9

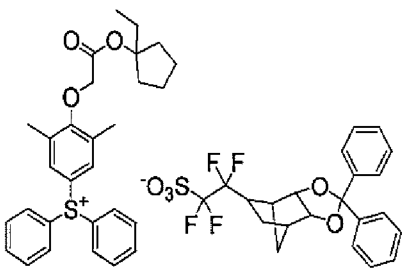

PAG-10

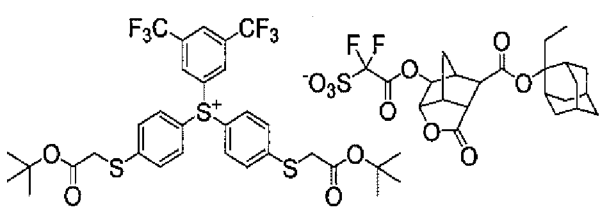

PAG-11

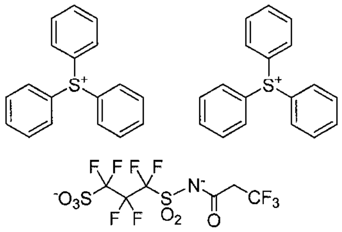

PAG-12

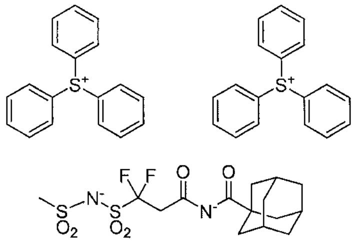

PAG-13

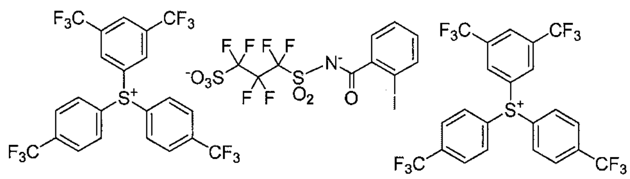

PAG-14

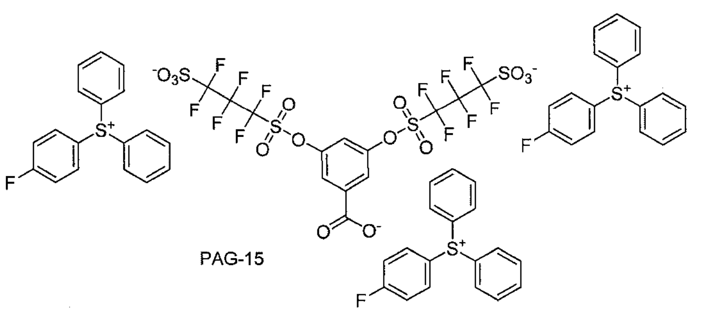

PAG-15

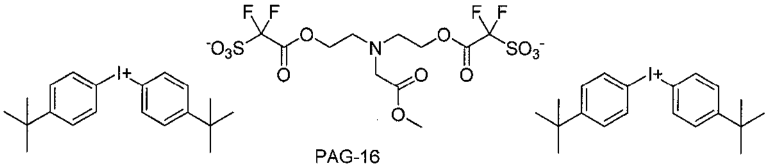

PAG-16

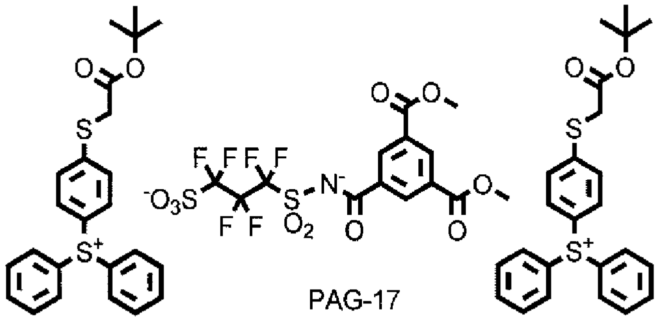

PAG-17

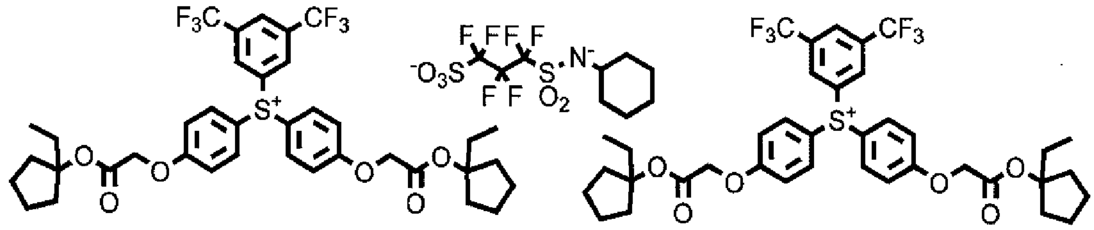

PAG-18

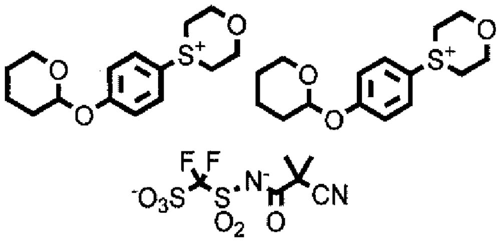

PAG-19

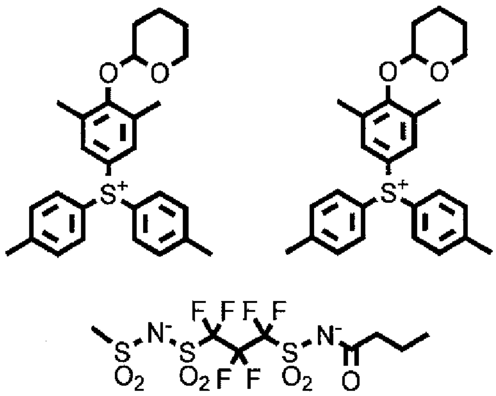

PAG-20

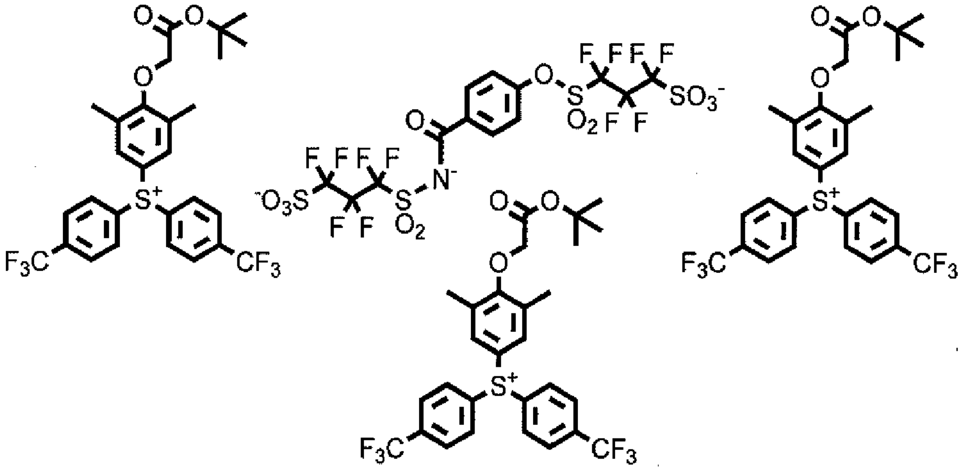

PAG-21

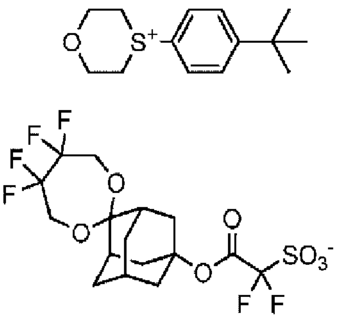

**PAG-22**

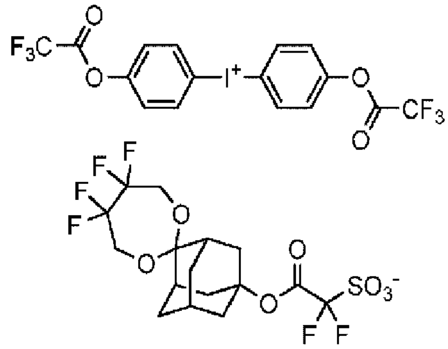

**PAG-23**

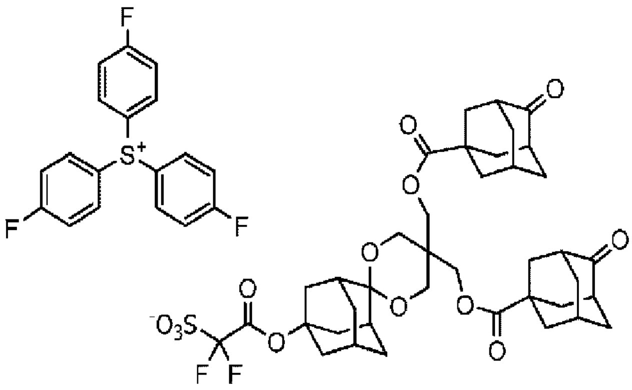

**PAG-24**

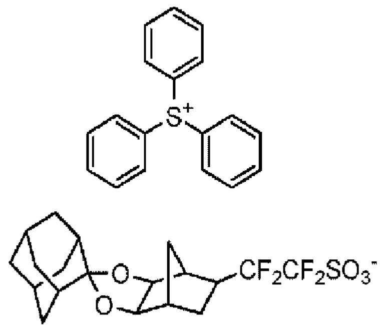

**PAG-25**

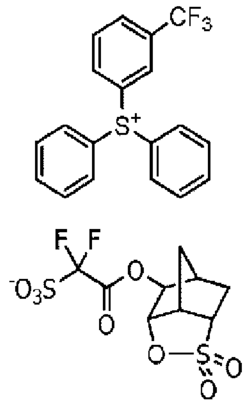

**PAG-26**

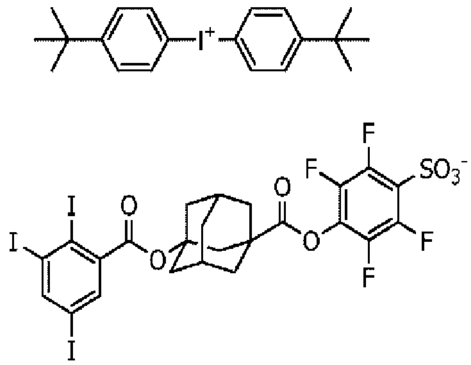

**PAG-27**

Tables 3 and 4 show molecular weights of generated acids of the photoacid generators.

[Table 3]

| Photoacid generator | Molecular weight of generated acid |
|---|---|
| PAG-1 | 200 |
| PAG-2 | 322 |
| PAG-3 | 324 |
| PAG-4 | 405 |
| PAG-5 | 653 |
| PAG-6 | 336 |
| PAG-7 | 356 |
| PAG-8 | 304 |
| PAG-9 | 394 |
| PAG-10 | 472 |
| PAG-11 | 517 |
| PAG-12 | 421 |
| PAG-13 | 428 |
| PAG-14 | 541 |
| PAG-15 | 742 |
| PAG-16 | 493 |
| PAG-17 | 531 |
| PAG-18 | 393 |
| PAG-19 | 322 |
| PAG-20 | 458 |
| PAG-21 | 725 |

[Table 4]

| Photoacid generator | Molecular weight of generated acid |
|---|---|
| PAG-22 | 468 |

(continued)

| Photoacid generator | Molecular weight of generated acid |
|---|---|
| PAG-23 | 468 |
| PAG-24 | 795 |
| PAG-25 | 440 |
| PAG-26 | 348 |
| PAG-27 | 906 |

[Acid Diffusion Control Agent and Other Additives]

Structures of acid diffusion control agents (PQ-01 to PQ-08 and Q-01 to Q-04) and structures of other additives (CL-1) are shown below. In addition, E-3 is PF656 (manufactured by OMNOVA Solutions Inc., fluorine-based surfactant).

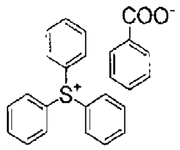

PQ-01

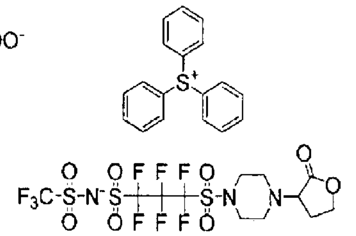

PQ-02

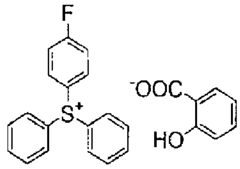

PQ-03

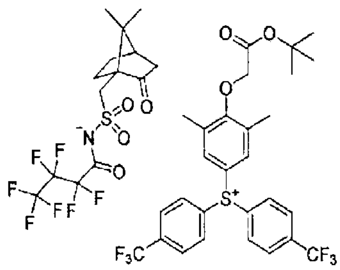

PQ-04

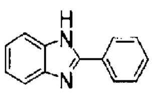

Q-01

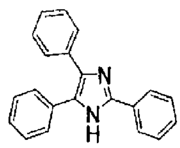

Q-02

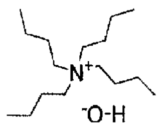

Q-03

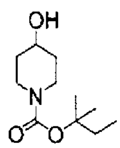

Q-04

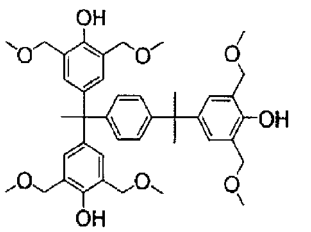

CL-1

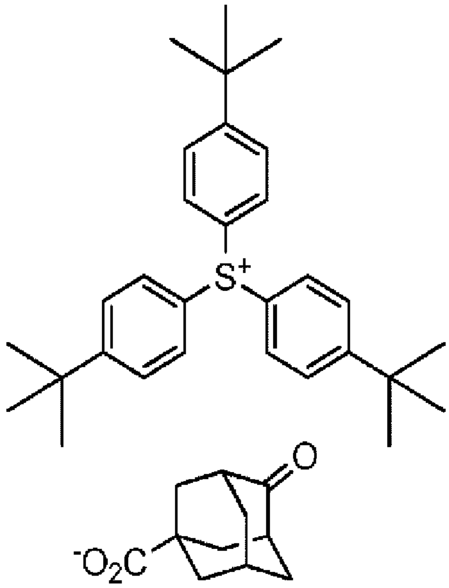

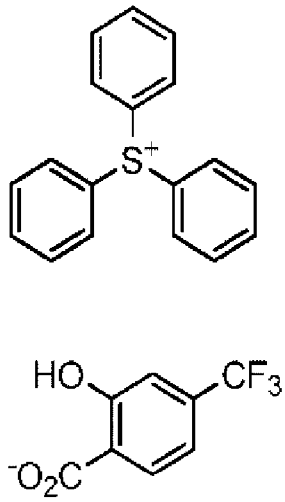

PQ-05

PQ-06

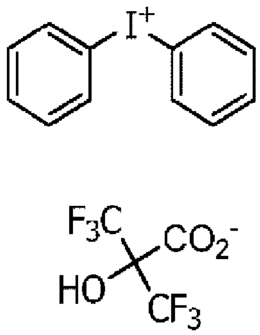

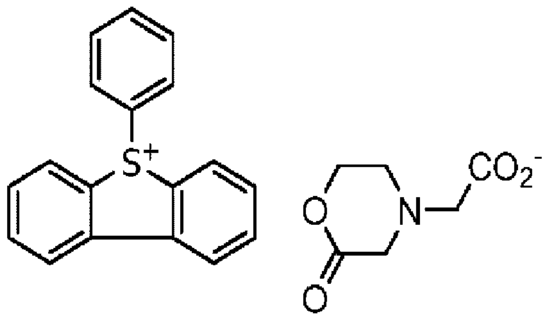

PQ-08

PQ-07

[Hydrophobic Resin]

As hydrophobic resins D-1 to D-3, those synthesized according to a known method were used. A ratio (content ratio (% by mole)) of each repeating unit, a weight-average molecular weight (Mw), and a dispersity (Mw/Mn) are shown in Table 5.

The weight-average molecular weight (Mw) and the dispersity (Mw/Mn) of the hydrophobic resins D-1 to D-3 were measured by GPC (carrier: tetrahydrofuran (THF)) (an amount expressed in terms of polystyrene). In addition, the compositional ratio (molar ratio) of the resin was measured by means of $^{13}$C-nuclear magnetic resonance (NMR).

[Table 5]

| Hydrophobic resin | First unit | Ratio of first unit(% by mole) | Second unit | Ratio of second unit (% by mole) | Third unit | Ratio of third unit(% by mole) | Fourth unit | Ratio of fourth unit (% by mole) | Mw | Mw/Mn |
|---|---|---|---|---|---|---|---|---|---|---|
| D-1 | ME-1 | 50 | ME-6 | 50 | - | - | - | - | 12000 | 1.5 |
| D-2 | ME-2 | 40 | ME-7 | 50 | ME-3 | 5 | ME-5 | 5 | 6000 | 1.3 |
| D-3 | ME-8 | 85 | ME-4 | 15 | - | - | - | - | 11000 | 1.4 |

Structural formulae of the repeating units (units) shown in Table 5 are shown below.

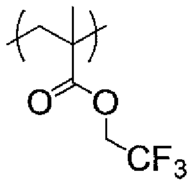

**ME-1**

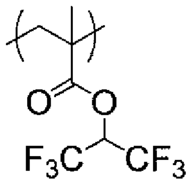

**ME-2**

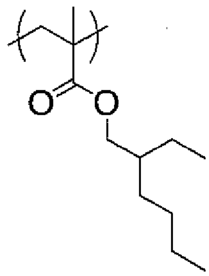

**ME-3**

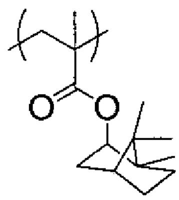

**ME-4**

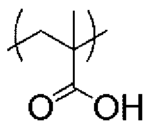

**ME-5**

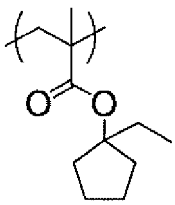

**ME-6**

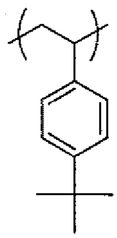

**ME-7**

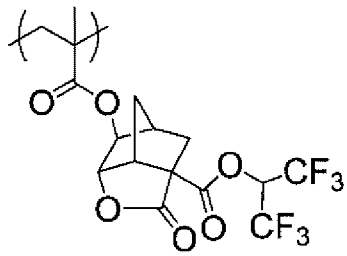

**ME-8**

[Solvent]

The solvents used are shown below.

F-1: Propylene glycol monomethyl ether acetate (PGMEA)
F-2: Propylene glycol monomethyl ether (PGME)
F-3: Propylene glycol monoethyl ether (PGEE)
F-4: Cyclohexanone
F-5: Cyclopentanone
F-6: 2-Heptanone
F-7: Ethyl lactate
F-8: γ-Butyrolactone
F-9: Propylene carbonate

[Preparation of Resist Composition]

Components shown in Tables 6, 7, and 8 were dissolved in the solvents shown in Tables 6, 7, and 8, and filtered through a polyethylene filter having a pore size of 0.03 μm to prepare resist compositions (Res-01 to Res-52). The contents (parts by mass) of each component and solvent in the resist compositions are shown in Tables 6, 7, and 8.

[Table 6]

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-01 | Pol-01 | 85.4 | - | | PAG-1 | 12.5 | - | | Q-03 | 2.1 | - | | F-1/F-4 | 2940/1960 |
| Res-02 | Pol-01 | 86.1 | D-3 | 2.0 | PAG-2 | 8.3 | - | | Q-04 | 3.6 | - | | F-1/F-2 | 4410/490 |
| Res-03 | Pol-01 | 789 | - | | PAG-3 | 19.6 | - | | Q-01 | 1.5 | - | | F-1/F-2/F-8 | 3920/735/245 |
| Res-04 | Pol-01 | 61.0 | - | | PAG-4 | 28.7 | - | | PQ-01 | 10.3 | - | | F-1/F-2 | 3430/1470 |
| Res-05 | Pol-01 | 67.8 | - | | PAG-5 | 19.9 | - | | PQ-02 | 12.3 | - | | F-1/F-6 | 4410/490 |
| Res-06 | Pol-01 | 55.8 | - | | PAG-6 | 37.7 | - | | PQ-03 | 6.5 | - | | F-1/F-2 | 3920/980 |
| Res-07 | Pol-01 | 67.6 | - | | PAG-7 | 17.4 | - | | PQ-04 | 15.0 | - | | F-1/F-5 | 3920/980 |
| Res-08 | Pol-01 | 22.9 | Pol-09 | 31.4 | PAG-8 | 44.2 | - | | Q-01 | 1.5 | - | | F-1/F-2 | 2940/1960 |
| Res-09 | Pol-01 | 89.5 | - | | PAG-9 | 9.6 | - | | Q-02 | 0.9 | - | | F-1/F-2/F-8 | 3920/735/245 |
| Res-10 | Pol-01 | 63.3 | - | | PAG-10 | 34.5 | - | | Q-03 | 2.2 | - | | F-1/F-2/F-4 | 980/980/2940 |
| Res-11 | Pol-01 | 72.7 | - | | PAG-11 | 19.9 | PAG-9 | 3.8 | Q-04 | 3.6 | - | | F-1/F-2 | 2940/1960 |

(continued)

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-12 | Pol-01 | 72.5 | - | | PAG-12 | 27.5 | - | | - | | - | | F-1/F-2/F-8 | 3920/735/245 |
| Res-13 | Pol-01 | 43.7 | Pol-06 | 13.3 | PAG-13 | 43.0 | - | | - | | - | | F-1/F-2/F-8 | 4165/490/245 |
| Res-14 | Pol-01 | 61.3 | - | | PAG-14 | 38.7 | - | | - | | - | | F-1/F-2 | 3920/980 |
| Res-15 | Pol-01 | 58.6 | - | | PAG-15 | 41.3 | - | | - | | E-3 | 0.1 | F-1/F-2/F-9 | 4165/490/245 |
| Res-16 | Pol-01 | 63.8 | - | | PAG-16 | 36.2 | - | | - | | - | | F-1/F-2/F-4 | 980/980/2940 |
| Res-17 | Pol-01 | 54.0 | - | | PAG-17 | 31.0 | - | | PQ-01 | 15.0 | - | | F-1/F-2 | 3430/1470 |
| Res-18 | Pol-01 | 61.7 | - | | PAG-18 | 25.0 | - | | PQ-02 | 13.3 | - | | F-1/F-8 | 4753/147 |
| Res-19 | Pol-01 | 59.4 | D-1 | 0.9 | PAG-19 | 39.7 | - | | - | | - | | F-1/F-2 | 4410/490 |
| Res-20 | Pol-01 | 41.4 | - | | PAG-20 | 53.5 | PAG-10 | 5.1 | - | | - | | F-1/F-2 | 4410/490 |
| Res-21 | Pol-01 | 51.7 | - | | PAG-21 | 44.1 | - | | Q-03 | 4.2 | - | | F-1/F-8 | 4753/147 |
| Res-22 | Pol-02 | 43.7 | - | | PAG-9 | 41.8 | - | | PQ-01 | 14.5 | - | | F-1/F-4 | 2940/1960 |

(continued)

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-23 | Pol-03 | 51.5 | - | | PAG-10 | 38.3 | - | | PQ-02 | 10.2 | - | | F-1/F-2/F-8 | 3920/490/490 |

[Table 7]

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-24 | Pol-04 | 81.1 | - | | PAG-14 | 18.9 | - | | - | | - | | F-1/F-5 | 2940/1960 |
| Res-25 | Pol-05 | 72.9 | - | | PAG-21 | 27.1 | - | | - | | - | | F-1/F-2/F-8 | 4165/490/245 |
| Res-26 | Pol-06 | 69.1 | - | | PAG-9 | 21.0 | - | | PQ-03 | 9.9 | - | | F-1/F-2 | 3920/980 |
| Res-27 | Pol-07 | 84.7 | - | | PAG-10 | 11.8 | - | | PQ-04 | 3.5 | - | | F-1/F-2 | 2940/1960 |
| Res-28 | Pol-08 | 38.8 | - | | PAG-14 | 61.2 | - | | - | | - | | F-1/F-2 | 4410/490 |
| Res-29 | Pol-09 | 51.5 | D-2 | 1.1 | PAG-21 | 38.3 | PAG-6 | 5.6 | PQ-04 | 3.5 | - | | F-1/F-2/F-8 | 3920/490/490 |
| Res-30 | Pol-10 | 71.2 | - | | PAG-9 | 14.4 | - | | PQ-01 | 14.4 | - | | F-1/F-2/F-8 | 3920/490/490 |
| Res-31 | Pol-11 | 54.8 | - | | PAG-10 | 31.7 | - | | PQ-02 | 13.5 | - | | F-1/F-2/F-8 | 4165/490/245 |
| Res-32 | Pol-12 | 73.1 | - | | PAG-14 | 26.9 | - | | - | | - | | F-1/F-4 | 3920/980 |
| Res-33 | Pol-13 | 84.3 | - | | PAG-21 | 15.7 | - | | - | | - | | F-1/F-2 | 3920/980 |
| Res-34 | Pol-14 | 48.2 | - | | PAG-9 | 36.9 | - | | PQ-03 | 14.9 | - | | F-1/F-9 | 4753/147 |

(continued)

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-35 | Pol-15 | 43.0 | - | | PAG-10 | 43.1 | - | | PQ-04 | 13.9 | - | | F-1/F-5 | 3920/980 |
| Res-36 | Pol-16 | 74.5 | - | | PAG-14 | 25.5 | - | | - | | - | | F-1/F-4 | 3920/980 |
| Res-37 | Pol-17 | 75.3 | - | | PAG-21 | 24.7 | - | | - | | - | | F-1/F-2 | 4410/490 |
| Res-38 | Pol-18 | 58.0 | - | | PAG-14 | 42.0 | - | | - | | - | | F-1/F-2/F-8 | 3920/490/490 |
| Res-39 | Pol-19 | 72.5 | - | | PAG-21 | 27.5 | - | | - | | - | | F-1/F-6 | 3430/1470 |
| Res-40 | Pol-20 | 79.3 | - | | PAG-9 | 10.5 | - | | PQ-01 | 10.2 | - | | F-1/F-8 | 4753/147 |
| Res-41 | Pol-21 | 44.1 | - | | PAG-10 | 43.6 | - | | PQ-02 | 12.3 | - | | F-1/F-9 | 4753/147 |
| Res-42 | Pol-22 | 75.2 | - | | PAG-14 | 24.8 | - | | - | | - | | F-1/F-2/F-8 | 4165/490/245 |
| Res-43 | Pol-23 | 66.3 | - | | PAG-20 | 33.7 | - | | - | | - | | F-1/F-2 | 4410/490 |
| Res-44 | Pol-24 | 80.1 | - | | PAG-21 | 19.9 | - | | - | | - | | F-1/F-2 | 3920/980 |
| Res-45 | Pol-25 | 82.4 | - | | PAG-9 | 17.1 | - | | Q-01 | 0.5 | - | | F-1/F-2/F-8 | 4165/490/245 |
| Res-46 | Pol-26 | 81.7 | - | | PAG-9 | 17.1 | - | | Q-03 | 1.0 | CL-1 | 0.2 | F-1/F-5 | 3920/980 |

[Table 8]

| Resist composition | Resin 1 | | Resin 2 | | Photoacid generator 1 | | Photoacid generator 2 | | Acid diffusion control agent | | Other additives | | Solvent | |
|---|---|---|---|---|---|---|---|---|---|---|---|---|---|---|
| | Type | Content (part by mass) | Type | Content (part by mass) | Type | Content (part by mass) | Type | Content (part by mass) | Type | Content (part by mass) | Type | Content (part by mass) | Type | Content (part by mass) |
| Res-47 | Pol-27 | 73.0 | - | | PAG-22 | 200 | - | | PQ-05 | 7.0 | - | | F-1/F-2 | 3430/1470 |
| Res-48 | Pol-28 | 68.0 | - | | PAG-23 | 25.0 | - | | PQ-06 | 7.0 | - | | F-1/F-2 | 3430/1470 |
| Res-49 | Pol-29 | 78.0 | - | | PAG-25 | 15.0 | - | | PQ-07 | 7.0 | - | | F-1/F-3 | 3430/1470 |
| Res-50 | Pol-30 | 63.0 | - | | PAG-27 | 30.0 | - | | PQ-08 | 7.0 | - | | F-1/F-7 | 3430/1470 |
| Res-51 | Pol-31 | 69.0 | - | | PAG-26 | 25.0 | - | | PQ-05 | 6.0 | - | | F-1/F-2 | 3430/1470 |
| Res-52 | Pol-32 | 68.0 | - | | PAG-24 | 24.0 | - | | PQ-05 | 8.0 | - | | F-1/F-2 | 3430/1470 |

[Preparation of Organic Treatment Liquid]

Organic solvents listed in Table 9 were mixed so as to have the content shown in Table 9 to prepare organic treatment liquids (R-01 to R-19). The obtained organic treatment liquid was used as a developer or a rinsing liquid described later.

[Table 9]

| Organic treatment liquid | First solvent | | Second solvent | |
|---|---|---|---|---|
| | Type | Content (% by mass) | Type | Content (% by mass) |
| R-01 | Butyl acetate | 95 | Undecane | 5 |
| R-02 | Butyl acetate | 90 | Undecane | 10 |
| R-03 | Butyl acetate | 85 | Undecane | 15 |
| R-04 | Butyl acetate | 80 | Undecane | 20 |
| R-05 | Butyl acetate | 75 | Undecane | 25 |
| R-06 | Butyl acetate | 70 | Undecane | 30 |
| R-07 | Butyl acetate | 65 | Undecane | 35 |
| R-08 | Butyl acetate | 85 | Dodecane | 15 |
| R-09 | Butyl acetate | 60 | Undecane | 40 |
| R-10 | Butyl acetate | 90 | Decane | 10 |
| R-11 | Isoamyl acetate | 90 | Undecane | 10 |
| R-12 | Butyl acetate | 100 | - | - |
| R-13 | Isoamyl acetate | 100 | - | - |
| R-14 | Methyl amyl ketone | 100 | - | - |
| R-15 | Isobutyl propionate | 100 | - | - |
| R-16 | Butyl acetate | 20 | Isoamyl acetate | 80 |
| R-17 | Undecane | 100 | - | - |
| R-18 | Diisoamyl ether | 100 | - | - |
| R-19 | Butyl acetate | 80 | Diisoamyl ether | 20 |

[Formation of Resist Film, Pattern Formation, and Development]

An organic film AL412 (manufactured by Brewer Science, Inc.) was applied to a silicon wafer and baked at 205°C for 60 seconds to form a film having a film thickness of 5 nm. Each resist composition prepared as shown in Tables 10 and 11 was applied thereto and baked (PB) at a temperature shown in Tables 10 and 11 for 60 seconds to form a resist film having a film thickness of 40 nm.

Using an EUV exposure device (manufactured by Exitech Ltd., Micro Exposure Tool, NA 0.3, Quadrupol, outer sigma 0.68, inner sigma 0.36), the entire surface of the silicon wafer having the obtained resist film was subjected to a pattern irradiation with the same exposure amount. As a reticle, a mask having a line size = 20 nm and a line:space = 1:1 was used. After the irradiation, baking (PEB) was performed on a hot plate at a temperature shown in Tables 10 and 11 for 60 seconds. Thereafter, development was performed by paddling a developer shown in Tables 10 and 11 for 30 seconds, a rinsing liquid shown in Tables 10 and 11 was poured over the wafer, and then the wafer was rotated and baked at 100°C for 60 seconds, thereby obtaining a 1:1 line-and-space pattern having a line width of 20 nm.

[Evaluation of In-plane Uniformity of Line Width]

Using a length-measuring scanning electron microscope (SEM (S-9380II of Hitachi, Ltd.)), a line width of the obtained line-and-space pattern was measured. $3\sigma$ which was a triple value of a standard deviation ($\sigma$) of the measured line width was calculated and used as an indicator of in-plane uniformity of the line width. Specifically, 3.5 mm in a vertical

direction (y-axis direction) and 6.5 mm in a horizontal direction (x-axis direction) were regarded as one shot, a total of 232 shots of exposure were performed on the wafer with 8 columns in the x direction and 29 rows in the y direction, and for each shot, 10 length-measurement images (5 lines per sheet) were measured, and an average of the 10 length-measurement values was regarded as a length-measurement value of the shot. The standard deviation of the length-measurement values for 232 shots was tripled to obtain 3σ.

The results are shown in Tables 10 and 11.

The unit of the in-plane uniformity of the line width in Tables 10 and 11 is "nm".

[Table 10]

| | Resist composition | PB | PEB | Developer | Rinsing liquid | In-plane uniformity of line width |
|---|---|---|---|---|---|---|
| Example 1 | Res-01 | 90°C | 80°C | R-12 | R-01 | 0.36 |
| Example 2 | Res-02 | 110°C | 120°C | R-02 | - | 0.36 |
| Example 3 | Res-03 | 120°C | 80°C | R-13 | R-03 | 0.34 |
| Example 4 | Res-04 | 130°C | 130°C | R-14 | R-04 | 0.24 |
| Example 5 | Res-05 | 80°C | 100°C | R-05 | - | 0.24 |
| Example 6 | Res-06 | 110°C | 130°C | R-12 | R-06 | 0.24 |
| Example 7 | Res-07 | 100°C | 80°C | R-19 | R-07 | 0.24 |
| Example 8 | Res-08 | 120°C | 130°C | R-01 | R-17 | 0.32 |
| Example 9 | Res-09 | 130°C | 100°C | R-12 | R-02 | 0.35 |
| Example 10 | Res-10 | 130°C | 120°C | R-12 | R-03 | 0.30 |
| Example 11 | Res-11 | 120°C | 80°C | R-01 | R-05 | 0.30 |
| Example 12 | Res-12 | 120°C | 100°C | R-13 | R-06 | 0.24 |
| Example 13 | Res-13 | 130°C | 110°C | R-12 | R-01 | 0.24 |
| Example 14 | Res-14 | 120°C | 90°C | R-13 | R-02 | 0.22 |
| Example 15 | Res-15 | 130°C | 100°C | R-03 | R-18 | 0.22 |
| Example 16 | Res-16 | 110°C | 110°C | R-12 | R-04 | 0.22 |
| Example 17 | Res-17 | 120°C | 110°C | R-13 | R-02 | 0.20 |
| Example 18 | Res-18 | 90°C | 110°C | R-06 | - | 0.20 |
| Example 19 | Res-19 | 80°C | 80°C | R-13 | R-03 | 0.20 |
| Example 20 | Res-20 | 130°C | 110°C | R-12 | R-02 | 0.20 |
| Example 21 | Res-21 | 120°C | 100°C | R-15 | R-03 | 0.20 |
| Example 22 | Res-22 | 90°C | 130°C | R-02 | - | 0.24 |
| Example 23 | Res-23 | 110°C | 110°C | R-15 | R-04 | 0.22 |
| Example 24 | Res-24 | 90°C | 80°C | R-12 | R-05 | 0.22 |
| Example 25 | Res-25 | 80°C | 110°C | R-16 | R-06 | 0.20 |
| Example 26 | Res-26 | 80°C | 100°C | R-01 | - | 0.24 |
| Example 27 | Res-27 | 90°C | 100°C | R-12 | R-02 | 0.22 |
| Example 28 | Res-28 | 130°C | 100°C | R-01 | R-07 | 0.22 |
| Example 29 | Res-29 | 80°C | 130°C | R-02 | - | 0.20 |
| Example 30 | Res-30 | 130°C | 80°C | R-14 | R-02 | 0.24 |
| Example 31 | Res-31 | 110°C | 120°C | R-12 | R-07 | 0.22 |
| Example 32 | Res-32 | 90°C | 120°C | R-12 | R-02 | 0.22 |

(continued)

| | Resist composition | PB | PEB | Developer | Rinsing liquid | In-plane uniformity of line width |
|---|---|---|---|---|---|---|
| Example 33 | Res-33 | 130°C | 130°C | R-12 | R-02 | 0.20 |
| Example 34 | Res-34 | 110°C | 120°C | R-16 | R-03 | 0.24 |
| Example 35 | Res-35 | 90°C | 90°C | R-12 | R-04 | 0.22 |
| Example 36 | Res-36 | 130°C | 100°C | R-01 | - | 0.22 |
| Example 37 | Res-37 | 80°C | 120°C | R-12 | R-07 | 0.20 |
| Example 38 | Res-38 | 100°C | 90°C | R-02 | - | 0.22 |
| Example 39 | Res-39 | 80°C | 100°C | R-01 | - | 0.20 |
| Example 40 | Res-40 | 80°C | 90°C | R-12 | R-02 | 0.28 |
| Example 41 | Res-41 | 100°C | 90°C | R-12 | R-01 | 0.26 |
| Example 42 | Res-42 | 120°C | 130°C | R-05 | - | 0.26 |
| Example 43 | Res-43 | 130°C | 110°C | R-12 | R-05 | 0.24 |
| Example 44 | Res-44 | 90°C | 80°C | R-02 | - | 0.24 |
| Example 45 | Res-45 | 120°C | 130°C | R-12 | R-02 | 0.37 |
| Comparative Example 1 | Res-46 | 100°C | 80°C | R-05 | - | 0.50 |
| Example 46 | Res-27 | 90°C | 100°C | R-12 | R-08 | 0.31 |
| Comparative Example 2 | Res-27 | 90°C | 100°C | R-12 | R-09 | 0.50 |
| Comparative Example 3 | Res-27 | 90°C | 100°C | R-12 | R-10 | 0.50 |
| Comparative Example 4 | Res-27 | 90°C | 100°C | R-12 | R-11 | 0.50 |
| Comparative Example 5 | Res-27 | 90°C | 100°C | R-12 | R-12 | 0.50 |

[Table 11]

| | Resist composition | PB | PEB | Developer | Rinsing liquid | In-plane uniformity of line width |
|---|---|---|---|---|---|---|
| Example 47 | Res-47 | 120°C | 100°C | R-01 | - | 0.24 |
| Example 48 | Res-48 | 120°C | 100°C | R-02 | - | 0.24 |
| Example 49 | Res-49 | 120°C | 100°C | R-03 | - | 0.24 |
| Example 50 | Res-50 | 120°C | 100°C | R-04 | - | 0.27 |
| Example 51 | Res-51 | 120°C | 100°C | R-02 | - | 0.24 |
| Example 52 | Res-52 | 120°C | 100°C | R-02 | - | 0.24 |

From the evaluation results of Tables 10 and 11, it was found that the pattern forming method of Examples was excellent in the in-plane uniformity of the line width of the obtained pattern.

Both Example 5 and Comparative Example 1 were examples of development using the organic treatment liquid R-05, but Example 5 was superior to Comparative Example 1 in the in-plane uniformity of the line width. It is considered that this is because the negative tone chemically amplified resist composition (Res-46) which undergoes negative conversion by a crosslinking reaction was used in Comparative Example 1, so that the organic treatment liquid R-05 did not

uniformly wet and spread on the resist film.

Example 27 and Comparative Examples 2 to 5 were examples of development using the organic treatment liquid R-12, but Example 27 was superior to Comparative Examples 2 to 5 in the in-plane uniformity of the line width. It is considered that this is because the rinsing liquid used in Comparative Examples 2 to 5 was not the specific organic treatment liquid according to the present invention, so that the organic treatment liquid did not uniformly wet and spread on the resist film.

According to the present invention, it is possible to provide a pattern forming method capable of obtaining a pattern having excellent in-plane uniformity of a line width, and a method for manufacturing an electronic device, including the pattern forming method.

The present invention has been described in detail with reference to specific embodiments. To those skilled in the art, it is obvious that various changes or modifications can be added without departing from the gist and scope of the present invention.

The present application is based on Japanese Patent Application (JP2021-9169) filed on January 22, 2021 and Japanese Patent Application (JP2021-120391) filed on July 21, 2021, and the contents of which are incorporated herein by reference.

## Claims

1. A pattern forming method comprising:

    (1) a step of forming a film using an actinic ray-sensitive or radiation-sensitive resin composition that contains a resin (A) which is decomposed by action of acid to increase polarity and a compound (B) which generates an acid by irradiation with an actinic ray or a radiation;
    (2) a step of exposing the film; and
    (3) a step of subjecting the exposed film to at least one of development or rinsing with an organic treatment liquid containing butyl acetate and a hydrocarbon having 11 or more carbon atoms,

    wherein a content of the hydrocarbon having 11 or more carbon atoms in the organic treatment liquid is 1% by mass or more and 35% by mass or less.

2. The pattern forming method according to claim 1,
    wherein the hydrocarbon having 11 or more carbon atoms is undecane.

3. The pattern forming method according to claim 1 or 2,
    wherein the resin (A) which is decomposed by action of acid to increase polarity includes at least one selected from the group consisting of a group in which a hydrogen atom of a carboxy group is substituted with a leaving group which is eliminated by action of acid, a group in which a hydrogen atom of an alcoholic hydroxyl group is substituted with a leaving group which is eliminated by action of acid, and a group in which a hydrogen atom of a phenolic hydroxyl group is substituted with a leaving group which is eliminated by action of acid.

4. The pattern forming method according to any one of claims 1 to 3,
    wherein the resin (A) which is decomposed by action of acid to increase polarity has a repeating unit represented by General Formula (AX),

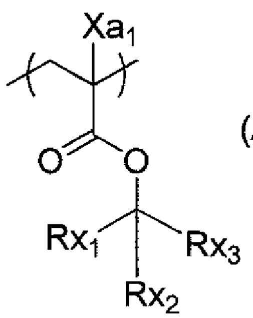

(AX)

in General Formula (AX),

$Xa_1$ represents a hydrogen atom or an alkyl group,
$Rx_1$ to $Rx_3$ each independently represent an alkyl group, a cycloalkyl group, an alkenyl group, or an aryl group, and two of $Rx_1$ to $Rx_3$ may be bonded to each other to form a ring.

**5.** The pattern forming method according to any one of claims 1 to 4,
wherein the resin (A) which is decomposed by action of acid to increase polarity has at least one selected from the group consisting of a lactone group, a carbonate group, a sultone group, and a cyclic group having a hydroxyl group.

**6.** The pattern forming method according to any one of claims 1 to 5,
wherein the resin (A) which is decomposed by action of acid to increase polarity has a repeating unit represented by General Formula (Y),

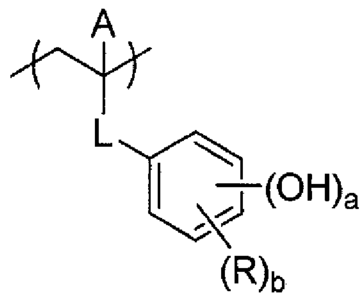

(Y)

in General Formula (Y),

A represents a hydrogen atom, an alkyl group, a cycloalkyl group, a halogen atom, or a cyano group,
L represents a single bond or a divalent linking group having an oxygen atom,
R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, where in a case of a plurality of R's, the plurality of R's may be the same or different from each other, in a case where a plurality of R's are present, the plurality of R's may be bonded to each other to form a ring,
a represents an integer of 1 to 3, and
b represents an integer of 0 to (5 - a).

**7.** The pattern forming method according to any one of claims 1 to 6,
wherein the compound (B) which generates an acid by irradiation with an actinic ray or a radiation has a cation represented by General Formula (ZaI) or a cation represented by General Formula (ZaII),

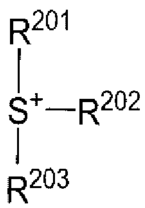

(ZaI)

$R^{204}$-I+-$R^{205}$ (ZaII)

in General Formula (ZaI), $R^{201}$, $R^{202}$, and $R^{203}$ each independently represent an organic group,
in General Formula (ZaII), $R^{204}$ and $R^{205}$ each independently represent an organic group.

**8.** The pattern forming method according to claim 7,

wherein at least one of $R^{201}$, $R^{202}$, or $R^{203}$ in General Formula (ZaI) is an aryl group, or
at least one of $R^{204}$ or $R^{205}$ in General Formula (ZaII) is an aryl group.

**9.** The pattern forming method according to claim 7 or 8,

wherein at least one of $R^{201}$, $R^{202}$, or $R^{203}$ in General Formula (ZaI) has an acid-decomposable group, or at least one of $R^{204}$ or $R^{205}$ in General Formula (ZaII) has an acid-decomposable group.

**10.** The pattern forming method according to any one of claims 1 to 9, wherein a molecular weight of the acid generated from the compound (B) which generates an acid by irradiation with an actinic ray or a radiation is 250 or more.

**11.** The pattern forming method according to any one of claims 1 to 10, wherein a content of the compound (B) which generates an acid by irradiation with an actinic ray or a radiation is 10% by mass or more with respect to a total solid content of the actinic ray-sensitive or radiation-sensitive resin composition.

**12.** The pattern forming method according to any one of claims 1 to 11,

wherein the actinic ray-sensitive or radiation-sensitive resin composition contains two or more types of the compound (B) which generates an acid by irradiation with an actinic ray or a radiation, or
the compound (B) which generates an acid by irradiation with an actinic ray or a radiation is at least one selected from the group consisting of the following compound (I) and the following compound (II),

Compound (I):

a compound having one or more of the following structural moieties X and one or more of the following structural moieties Y, in which the compound generates an acid including the following first acidic moiety derived from the following structural moiety X and the following second acidic moiety derived from the following structural moiety Y by irradiation with an actinic ray or a radiation,
Structural moiety X: a structural moiety which consists of an anionic moiety $A_1^-$ and a cationic moiety $M_1^+$, and forms a first acidic moiety represented by $HA_1$ by irradiation with an actinic ray or a radiation,
Structural moiety Y: a structural moiety which consists of an anionic moiety $A_2^-$ and a cationic moiety $M_2^+$, and forms a second acidic moiety represented by $HA_2$ by irradiation with an actinic ray or a radiation,
where, the compound (I) satisfies the following condition I,
Condition I: a compound PI, which is formed by, in the compound (I), replacing the cationic moiety $M_1^+$ in the structural moiety X and the cationic moiety $M_2^+$ in the structural moiety Y with $H^+$, has an acid dissociation constant a1 derived from the acidic moiety represented by $HA_1$, formed by replacing the cationic moiety $M_1^+$ in the structural moiety X with $H^+$, and has an acid dissociation constant a2 derived from the acidic moiety represented by $HA_2$, formed by replacing the cationic moiety $M_2^+$ in the structural moiety Y with $H^+$, in which the acid dissociation constant a2 is larger than the acid dissociation constant a1,

Compound (II):

a compound having two or more of the structural moieties X and one or more of the following structural moieties Z, in which the compound generates an acid including two or more of the first acidic moieties derived from the structural moiety X and the structural moiety Z by irradiation with an actinic ray or a radiation,
Structural moiety Z: a non-ionic moiety capable of neutralizing an acid.

**13.** A method for manufacturing an electronic device, comprising: the pattern forming method according to any one of claims 1 to 12.

## INTERNATIONAL SEARCH REPORT

International application No.
**PCT/JP2022/000432**

**A. CLASSIFICATION OF SUBJECT MATTER**

***C08F 20/20***(2006.01)i; ***G03F 7/004***(2006.01)i; ***G03F 7/038***(2006.01)i; ***G03F 7/039***(2006.01)i; ***G03F 7/20***(2006.01)i; ***G03F 7/32***(2006.01)i
FI: G03F7/32; G03F7/038 601; G03F7/004 503A; G03F7/039 601; C08F20/20; G03F7/20 521; G03F7/20 501; G03F7/32 501

According to International Patent Classification (IPC) or to both national classification and IPC

**B. FIELDS SEARCHED**

Minimum documentation searched (classification system followed by classification symbols)

C08F20/20; G03F7/004; G03F7/038; G03F7/039; G03F7/20; G03F7/32

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | JP 2012-203238 A (FUJIFILM CORP) 22 October 2012 (2012-10-22) claims | 1-13 |
| A | WO 2016/017232 A1 (FUJIFILM CORP) 04 February 2016 (2016-02-04) claims | 1-13 |
| A | WO 2017/057225 A1 (FUJIFILM CORP) 06 April 2017 (2017-04-06) claims | 1-13 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **22 March 2022** | **29 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/000432**

| Patent document cited in search report | Publication date (day/month/year) | Patent family member(s) | Publication date (day/month/year) |
|---|---|---|---|
| JP 2012-203238 A | 22 October 2012 | US 8889339 B2 claims<br>TW 201239535 A<br>CN 103460133 A<br>KR 10-2014-0018268 A | |
| WO 2016/017232 A1 | 04 February 2016 | US 2017/0075222 A1 claims<br>KR 10-2016-0145787 A<br>TW 201604647 A | |
| WO 2017/057225 A1 | 06 April 2017 | US 2018/0217499 A1 claims<br>KR 10-2018-0048873 A<br>CN 108139691 A<br>TW 201730327 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016104565 A
- JP 2011065105 A
- WO 2016158711 A
- JP 2014059543 A
- JP 2013061648 A
- WO 2020004306 A
- US 20160070167 A
- JP 2014098921 A
- JP 2014041327 A
- WO 2018193954 A
- WO 2020066824 A
- WO 2017154345 A
- US 20160070167 A1
- US 20150004544 A1
- US 20160237190 A1
- US 20160274458 A1
- WO 2020158337 A
- WO 2020158467 A
- WO 2020158366 A
- WO 2020158417 A
- WO 201819395 A
- JP 2021009169 A
- JP 2021120391 A


### Non-patent literature cited in the description


- *Materials Letters,* 2008, vol. 62, 3152
- Prediction of polymer properties. Marcel Dekker Inc, 1993